(19) **Europäisches Patentamt / European Patent Office / Office européen des brevets**

(11) **EP 4 770 272 A1**

(12) **EUROPEAN PATENT APPLICATION**
published in accordance with Art. 153(4) EPC

(43) Date of publication:
01.07.2026 Bulletin 2026/27

(21) Application number: 24868654.5

(22) Date of filing: 13.09.2024

(51) International Patent Classification (IPC):
*H05B 6/12* (2006.01)    *F24C 7/08* (2006.01)
*F24C 15/10* (2006.01)    *F24C 15/34* (2006.01)
*H05B 6/06* (2006.01)    *F24C 3/12* (2006.01)

(52) Cooperative Patent Classification (CPC):
**F24C 3/12; F24C 7/08; F24C 15/10; F24C 15/34;
H05B 6/06; H05B 6/12**

(86) International application number:
**PCT/KR2024/014078**

(87) International publication number:
**WO 2025/063677 (27.03.2025 Gazette 2025/13)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH MA MD TN**

(30) Priority: 21.09.2023  KR 20230126657
21.09.2023  KR 20230126658
26.09.2023  KR 20230129155
22.02.2024  KR 20240026117
06.08.2024  KR 20240104961

(71) Applicant: **LG Electronics Inc.**
**Yeongdeungpo-gu**
**Seoul 07336 (KR)**

(72) Inventors:
• **OH, Dooyong**
  **Seoul 08592 (KR)**
• **LEE, Jae-Woo**
  **Seoul 08592 (KR)**
• **KANG, Kyelyong**
  **Seoul 08592 (KR)**
• **HONG, Jaepyo**
  **Seoul 08592 (KR)**
• **CHA, Kwanghyung**
  **Seoul 08592 (KR)**
• **LEE, Yongsoo**
  **Seoul 08592 (KR)**

(74) Representative: **Vossius & Partner**
**Patentanwälte Rechtsanwälte mbB**
**Siebertstraße 3**
**81675 München (DE)**

(54) **HOME APPLIANCE**

(57)    Disclosed is an invention related to a home appliance. The invention disclosed herein includes a heating coil formed by a plurality of layers of conductors stacked in the up-down direction, wherein the horizontal outline of the heating coil has a polygonal shape. Accordingly, the cross-sectional area of patterns per turn of the heating coil increases while an increase in the size of the heating coil in the horizontal direction is suppressed, and thus a rise in the temperature of the heating coil can be effectively suppressed.

**FIG. 6**

**Description**

**TECHNICAL FIELD**

The present disclosure relates to a home appliance, and more particularly, to a home appliance including a heating coil assembly.

**BACKGROUND**

A cooking appliance is one of home appliances for cooking food, and is a device installed in a kitchen space and used to cook food according to an intention of a user. Such a cooking appliance may be variously classified according to a heat source, a shape, or a type of fuel used.

When the cooking appliance is classified according to a type of cooking food, the cooking appliance may be classified into an open-type cooking appliance and a closed-type cooking appliance depending on a shape of a space on which food is placed. The closed-type cooking appliance includes an oven, a microwave oven, and the like, and the open-type cooking appliance includes a cooktop, a hob, and the like.

The cooktop among open-type cooking appliances is provided to be capable of heating food contained in a cooking vessel through at least one cooking zone. Such a cooktop may be provided in a form including a cooking zone using electricity, or may be provided in a form including a cooking zone using gas. In addition, the cooktop may be implemented independently, and may also be implemented in a form of an oven range including an oven below the cooktop.

As an example of a cooktop including a cooking zone using electricity, there is an induction heating cooking appliance. The induction heating cooking appliance is a cooking appliance that performs a cooking function by an induction heating method. In the induction heating cooking appliance, when a current is applied to a heating coil, an eddy current is generated in a cooking vessel, which is a magnetic material, and cooking of food may be performed by the cooking vessel heated by acting as resistance to the eddy current.

Such an induction heating cooking appliance does not require combustion of gas and thus does not generate combustion exhaust gas. In addition, the induction heating cooking appliance allows heat to be generated immediately in the cooking vessel itself, thereby minimizing a transfer process through radiation or conduction of heat, and thus may heat food at a high speed.

In general, in the induction heating cooking appliance, a position at which a cooking vessel is to be placed is indicated on a top plate above a heating coil, and heating of the cooking vessel by the heating coil is performed in a state in which the cooking vessel is placed on the indicated position.

In the induction heating cooking appliance, one or more working coils and a circuit board may be provided. The working coil performs a role of transmitting electromagnetic force to a cooking vessel. In general, the working coil may be formed in a shape in which a wire is wound in a spiral manner. In addition, a circuit board may perform a role of electrically controlling that an induced current is supplied to the working coil.

Recently, instead of a working coil formed in a shape in which a wire is wound in a spiral manner, a working coil in a form in which a coil-shaped pattern is formed on a circuit board has also been used.

Among costs and time required for manufacturing an induction heating cooking appliance, costs and time input to fabrication of the working coil occupy a large proportion. Among these, costs of a wire, and considerable costs and time required for winding the wire are consumed.

When the working coil is formed in a form in which a coil-shaped pattern is formed on a circuit board instead of forming the working coil by winding a wire, costs and time input to fabrication of the working coil may be reduced.

High-frequency power is applied to the working coil, and accordingly, a considerable amount of heat is generated in the working coil. In particular, in an induction heating cooking appliance requiring high power, as high power is applied accordingly, a large amount of heat is generated in the working coil.

When the working coil is formed in a form in which a coil-shaped pattern is formed on a circuit board, due to a limited area of the circuit board, the working coil is inevitably formed in a form in which the coil pattern is concentrated in a narrow area of the circuit board. Accordingly, a large amount of heat is inevitably applied to the circuit board on which the working coil is formed relative to an area thereof, and as a result, a temperature of the circuit board may excessively increase.

Meanwhile, in recent years, an induction heating cooking appliance has been developed that automatically recognizes a size and a position of a cooking vessel and performs heating in a form suitable thereto even when the cooking vessel is not placed at a specific position. In order for heating in such a type of induction heating cooking appliance to be performed more effectively, the number of working coils provided in the induction heating cooking appliance needs to be increased.

Therefore, in the induction heating cooking appliance of the type described above, there is difficulty in applying a working coil having a coil pattern form due to a temperature increase problem caused by concentration of the coil pattern.

**SUMMARY**

Technical Problems

An object of the present disclosure is to provide a home appliance having an improved structure so that a temperature increase of a heating coil having a coil pattern form may be suppressed.

Another object of the present disclosure is to provide a home appliance having an improved structure so that density of an area occupied by a heating coil in an appliance may be improved.

Another object of the present disclosure is to provide a home appliance having an improved structure so that a temperature increase of a heating coil may be suppressed while allowing the heating coil to be disposed more densely.

Another object of the present disclosure is to provide a home appliance having an improved structure so that loss of a raw plate used for manufacturing a coil board part may be reduced while density of an area occupied by a heating coil in an appliance is improved.

Another object of the present disclosure is to provide a home appliance having an improved structure so that a connection structure between a heating coil and an electrical component may be simplified.

Another object of the present disclosure is to provide a home appliance having an improved structure so that a decrease in a pattern cross-sectional area per turn of a heating coil due to foil loss occurring during a process of forming a coil pattern may be suppressed.

Another object of the present disclosure is to provide a home appliance having an improved structure so that an appearance of the home appliance is not degraded due to a heating coil-related structure.

Technical Solutions

A home appliance according to one embodiment of the present disclosure for achieving the above objects includes a heating coil formed by conductors stacked in a plurality of layers, wherein an outer shape of the heating coil is polygonal.

Another embodiment of the present disclosure includes a heating coil formed by a plurality of pattern coils stacked in a vertical direction, wherein a horizontal outer shape of the heating coil is polygonal.

Another embodiment of the present disclosure includes a heating coil formed by stacking pattern coils patterned on a board in a vertical direction, wherein a horizontal outer shape of the heating coil is polygonal.

Another embodiment of the present disclosure includes a heating coil formed by conductors stacked in a plurality of layers, and a plurality of coil modules including at least one heating coil.

Another embodiment of the present disclosure includes a coil module having at least one heating coil formed by a plurality of pattern coils stacked in a vertical direction, wherein a plurality of coil modules are arranged along a horizontal direction.

Another embodiment of the present disclosure includes a rectangular coil module having a heating coil whose horizontal outer shape is rectangular, wherein a plurality of coil modules are arranged in a line along a horizontal direction.

Another embodiment of the present disclosure includes a coil module having at least one heating coil formed by a plurality of pattern coils stacked in a vertical direction, wherein a plurality of heating coils are arranged along a horizontal direction.

Another embodiment of the present disclosure includes a coil module having at least one heating coil, wherein a plurality of coil portions stacked in a vertical direction are connected in the vertical direction to respectively form one heating coil.

Another embodiment of the present disclosure includes a heating coil formed by stacking a plurality of first coil board parts, wherein an outer shape of the heating coil is polygonal.

Another embodiment of the present disclosure includes a coil board part having a pair of coil portions respectively patterned on both sides of a core in a vertical direction, and an adhesive material stacked together with a plurality of coil board parts in the vertical direction to bond the coil board parts, wherein the adhesive material is disposed between a pair of coil portions facing each other in the vertical direction to form an insulating layer therebetween.

Another embodiment of the present disclosure includes a coil module having at least one heating coil, wherein the coil module includes a mask covering uppermost and lowermost outer surfaces of a coil board stack in a vertical direction, and the mask is formed in a low-brightness color.

Another embodiment of the present disclosure includes a coil board stack formed by stacking coil patterns in a vertical direction, and a vertical connection part connecting a plurality of coil patterns stacked in the vertical direction in the vertical direction, wherein the vertical connection part includes vias connecting the plurality of coil patterns in the vertical direction, and a plurality of vias arranged in a horizontal direction in each vertical connection part are connected to each other.

Another embodiment of the present disclosure includes a coil module having at least one heating coil, wherein the heating coil is formed by coil patterns respectively patterned on a plurality of coil board parts stacked in a vertical direction, and an up-down cross-sectional shape of the coil pattern is formed in a polygonal shape in which a length of an upper side is less than a length of a lower side.

According to one aspect of the present disclosure, a home appliance may comprise: at least one coil module including a heating coil configured to inductively heat a heating target, wherein the heating coil may be formed by a plurality of coil patterns stacked in a vertical direction.

In addition, a vertical cross-section of each of the coil patterns may be formed in a polygonal shape including a lower side and an upper side spaced apart from each other by a thickness of the coil pattern.

Preferably, a length of the upper side may be less than a length of the lower side.

In addition, the vertical cross-section of the coil pattern is preferably formed in a polygonal shape in which the length of the upper side is 70% to 80% of the length of the lower side.

In addition, the vertical cross-section of the coil pattern is preferably formed in a trapezoidal shape in which the lower side and the upper side are parallel to each other.

In addition, the vertical cross-section of the coil pattern is preferably formed in a polygonal shape including a pair of side surfaces connecting the lower side and the upper side in the vertical direction.

In addition, each of the side surfaces respectively includes a first side surface connected to the upper side, and a second side surface connecting the first side surface and the lower side, and the second side surface preferably forms an inclined surface that becomes farther from a horizontal center of the lower side as the second side surface becomes closer to the lower side.

In addition, the first side surface is preferably formed in a linear shape in the vertical direction.

In addition, the second side surface is preferably formed as an inclined surface connecting a lower end of the first side surface and the lower side.

In addition, the coil pattern is preferably formed in the coil board part as a result in which a portion of a foil stacked on the core and not cured by exposure is etched and removed from the coil board part.

In addition, the vertical cross-section of the coil pattern may satisfy the following relationship.

$$0.47 \leq W1/t \leq 0.57$$

(where W1 denotes a length of the lower side of the coil pattern, and t denotes a thickness of the coil pattern).

In addition, an outer shape of the heating coil in a horizontal direction is preferably a rectangle in which a length in a first direction is 98 mm to 100 mm and a length in a second direction orthogonal to the first direction is 118 mm to 120 mm.

In addition, the coil board part preferably includes a plurality of the coil patterns disposed along a diametrical direction of a spiral formed by the heating coil.

In addition, a width of each of the coil patterns is preferably 0.3 mm to 0.6 mm.

In addition, the coil board part preferably includes a pair of the coil patterns disposed along the diametrical direction of the spiral formed by the heating coil.

In addition, a thickness of each of the coil patterns is 0.10 mm to 0.11 mm, and a width of each of the coil patterns is preferably 0.5 mm to 0.6 mm.

In addition, one of the lower side and the upper side preferably forms a flat surface, and the other of the lower side and the upper side preferably forms a rough surface.

In addition, the coil module may be formed by a plurality of coil board parts stacked in a vertical direction.

In addition, each of the coil board parts may respectively include at least one coil patterns patterned on a core.

In addition, the lower side is in contact with the core, and the upper side may be spaced apart from the core in the vertical direction by the thickness of the coil pattern.

In addition, the coil pattern is preferably deposited on an upper surface and a lower surface of the core, respectively.

In addition, the coil pattern is preferably deposited on the insulating layer such that the lower side is in contact with the insulating layer.

In addition, the lower side preferably forms a flat surface, and the upper side preferably forms a rough surface.

In addition, the coil pattern may include a first coil pattern in which the lower side is disposed at a lower portion and the upper side is disposed at an upper portion, and a second coil pattern in which the lower side is disposed at the upper portion and the upper side is disposed at the lower portion.

In addition, the first coil pattern and the second coil pattern are preferably disposed alternately in the vertical direction.

In addition, the coil pattern may include a first coil pattern disposed on the insulating layer and a second coil pattern disposed under the insulating layer.

In addition, the first coil pattern and the second coil pattern are preferably provided to be line-symmetric with respect to a horizontal straight line.

In addition, the coil module may include a via connected to the coil pattern or a dummy via not connected to the coil pattern.

In addition, a diameter of the via or the dummy via is preferably greater than a length of the lower side.

In addition, an inner diameter of the via is preferably less than the length of the lower side.

Advantageous Effects

The present disclosure forms a heating coil in a pattern coil form as a result of connecting a plurality of coil patterns stacked in a vertical direction in the vertical direction, and through this, by increasing a length of the heating coil in the vertical direction, allows a pattern cross-sectional area per turn of the heating coil to be effectively increased.

According to the present disclosure, by suppressing an increase in a horizontal size of the heating coil while increasing the pattern cross-sectional area per turn of the heating coil, a temperature increase of the heating coil may be effectively suppressed.

In addition, according to the present disclosure, as an outer shape of a heating coil disposed in a coil module formed in a polygonal shape similar to an outer shape of a cooktop is formed in a polygonal shape similar to an outer shape of the coil module, density of an area occupied by the heating coil in the cooktop may be effectively improved.

Accordingly, the present disclosure may improve heating efficiency of a home appliance by increasing a size of an area in which a heating target contacts the heating coil.

In addition, the present disclosure allows a heating coil to be formed as a result of connecting a plurality of coil lines stacked in a vertical direction in the vertical direction, and by forming a horizontal twisting structure and an up-down twisting structure in the heating coil, allows a pattern cross-sectional area per turn of the heating coil to be increased while minimizing an increase in a horizontal size of the heating coil.

According to the present disclosure, by reducing a size of the heating coil while lowering density of current flowing through the heating coil, the heating coils may be disposed more densely compared to a cooktop of the same specification, and maximum output may be maintained for a longer time compared to a cooktop of the same specification.

Accordingly, the present disclosure may provide improved heating efficiency by using small heating coils WC disposed densely, and may also provide higher output for a longer time.

In addition, the present disclosure allows a heating coil assembly to be formed as a combination of a plurality of coil modules, thereby allowing loss of a raw plate used for manufacturing the coil modules to be reduced, and allowing a space required for arranging a cooktop control panel on the cooktop to be effectively secured.

In addition, according to the present disclosure, wiring for connecting a heating coil and a sensing coil to a connection is formed in a pattern form on the coil module itself, and connection between the heating coil and the sensing coil and an electrical component may be achieved only by connection between the connection and the electrical component. Accordingly, a connection structure between the heating coil and the sensing coil and the electrical component may be formed very simply.

Accordingly, the present disclosure may provide an effect of not only allowing connection work between a heating coil assembly and an electrical component to be performed easily and quickly, but also preventing an accommodating space inside a cooktop in which the heating coil assembly and the electrical component are accommodated from becoming complicated due to a large number of wiring.

In addition, the present disclosure allows a first vertical connection part to include a plurality of vias, and through this, allows an amount of conductors provided in the vias to be increased, thereby effectively reducing resistance and heat generation occurring in the first vertical connection part.

In addition, the heating coil of the present disclosure may be formed to satisfy a condition in which a length of a lower side of a coil pattern is set to be in a range of 1.47 times to 1.57 times a thickness of the coil pattern.

The heating coil of the present disclosure may be formed to have a sufficient pattern cross-sectional area per turn required to effectively suppress a temperature increase of the heating coil even when a length of an upper side becomes shorter by 20% or more than the lower side during a coil pattern forming process.

In addition, the present disclosure allows a surface of a coil module formed by a mask to be formed in a color identical or similar to a color of a cover part, and through this, allows a heating coil assembly to be disposed inside a cooktop so as not to be easily visible from outside of the cooktop, thereby effectively suppressing degradation of appearance of a home appliance due to the heating coil assembly.

## BRIEF DESCRIPTION OF DRAWINGS

The accompanying drawings constitute a part of the specification, illustrate one or more embodiments in the disclosure, and together with the specification, explain the disclosure, wherein:

FIG. 1 is a perspective view illustrating a home appliance according to one embodiment of the present disclosure;
FIG. 2 is a plan view illustrating a cooktop shown in FIG. 1 in a separated state;
FIG. 3 is a view illustrating a lighting state of indicator lights of the cooktop shown in FIG. 2;
FIG. 4 is an exploded perspective view illustrating an exploded state of the cooktop shown in FIG. 2;
FIG. 5 is a view illustrating a state in which electrical components are installed on a lower surface of a supporter shown in FIG. 4;
FIG. 6 is a plan view schematically illustrating a configuration of a heating coil assembly shown in FIG. 4;
FIG. 7 is a cross-sectional view schematically illustrating a stacked structure of a coil module shown in FIG. 6;
FIG. 8 is a plan view illustrating a first example of an arrangement structure of a first coil module and a second coil module;
FIG. 9 is a view schematically illustrating an example of a raw plate cutting state for forming a first coil board part;
FIG. 10 is a plan view illustrating a second example of an arrangement structure of a first coil module and a second coil module;
FIG. 11 is a plan view illustrating another example of the arrangement structure of the first coil module and the second coil module shown in FIG. 8;
FIG. 12 is a plan view illustrating another example of the arrangement structure of the first coil module and the second coil module shown in FIG. 10;
FIG. 13 is a plan view illustrating a third example of an arrangement structure of a first coil module and a second coil module;

FIG. 14 is a plan view illustrating a fourth example of an arrangement structure of a first coil module and a second coil module;

FIG. 15 is a plan view illustrating a fifth example of an arrangement structure of a first coil module and a second coil module;

FIG. 16 is a plan view illustrating a sixth example of an arrangement structure of a first coil module and a second coil module;

FIG. 17 is a plan view illustrating an example of a first coil board part according to one embodiment of the present disclosure;

FIG. 18 is an enlarged view enlarging a portion of the first coil board part shown in FIG. 17;

FIG. 19 is a cross-sectional view schematically illustrating a stacked structure of a first coil portion shown in FIG. 18;

FIG. 20 is a plan view illustrating an example of an arrangement structure of a sensing coil;

FIG. 21 is an enlarged view enlarging a portion of FIG. 20, and illustrates an example of an arrangement structure of the sensing coil relative to a heating coil;

FIG. 22 is an enlarged view enlarging a first terminal shown in FIG. 18;

FIG. 23 is an enlarged view enlarging a second terminal shown in FIG. 18;

FIG. 24 is a plan view illustrating a seventh example of an arrangement structure of a first coil module and a second coil module;

FIG. 25 is a configuration diagram schematically illustrating a power supply-related configuration of a home appliance according to one embodiment of the present disclosure;

FIG. 26 is a view illustrating an example of a driving circuit and a load circuit shown in FIG. 25;

FIG. 27 is a plan view illustrating an example of a heating coil;

FIG. 28 is a plan view illustrating another example of a heating coil;

FIG. 29 is an enlarged view enlarging a first coil portion;

FIG. 30 is a view illustrating an example of a connection structure between a stack of coil patterns and a first vertical connection part;

FIG. 31 is a cross-sectional view illustrating a structure of the stack of coil patterns and the first vertical connection part shown in FIG. 30;

FIG. 32 is a view illustrating another example of a connection structure between a stack of coil patterns and a first vertical connection part;

FIG. 33 is a cross-sectional view illustrating a structure of the stack of coil patterns and the first vertical connection part shown in FIG. 32;

FIG. 34 is a view illustrating another example of a first vertical connection part;

FIG. 35 is a view illustrating an example of a connection structure between a stack of coil patterns and a first vertical connection part shown in FIG. 34;

FIG. 36 is a cross-sectional view illustrating a structure of the stack of coil patterns and the first vertical connection part shown in FIG. 35;

FIG. 37 is a view illustrating another example of a connection structure between a stack of coil patterns and a first vertical connection part shown in FIG. 34;

FIG. 38 is a cross-sectional view illustrating a structure of the stack of coil patterns and the first vertical connection part shown in FIG. 37;

FIG. 39 is a view illustrating still another example of a connection structure between a stack of coil patterns and a first vertical connection part;

FIG. 40 is a cross-sectional view illustrating a structure of the stack of coil patterns and the first vertical connection part shown in FIG. 39;

FIG. 41 is a view illustrating still another example of a connection structure between a stack of coil patterns and a first vertical connection part;

FIG. 42 is a cross-sectional view illustrating a structure of the stack of coil patterns and the first vertical connection part shown in FIG. 41;

FIG. 43 is a cross-sectional view illustrating an example of a stacked structure of a second outer layer part and a second coil board part;

FIG. 44 is an enlarged view enlarging a portion of the second outer layer part;

FIG. 45 is an enlarged view enlarging a portion of a second coil board part;

FIG. 46 is an enlarged view enlarging a portion of a first coil board part;

FIG. 47 is a view illustrating a second terminal and a second connection in a separated state;

FIG. 48 is a cross-sectional view schematically illustrating a stacked structure of the second terminal and the second connection shown in FIG. 47;

FIG. 49 is a view illustrating a state in which a heating coil assembly is covered with a mask;

FIG. 50 is a cross-sectional view schematically illustrating an example of a stacked structure of the heating coil assembly shown in FIG. 49;

FIG. 51 is a cross-sectional view schematically illustrating a state in which the heating coil assembly is covered with a top plate;

FIG. 52 is a cross-sectional view schematically illustrating another example of a stacked structure of the heating coil assembly shown in FIG. 49;

FIG. 53 is a flowchart schematically illustrating a manufacturing process of a coil board stack according to one embodiment of the present disclosure;

FIG. 54 is a flowchart schematically illustrating a progress of a connection step shown in FIG. 53;

FIG. 55 is a view illustrating an example of a heating coil assembly according to one embodiment of the present disclosure;

FIG. 56 is a view illustrating a first coil module shown in FIG. 55 in a separated state;

FIG. 57 is a view illustrating a second coil module shown in FIG. 55 in a separated state;

FIG. 58 is a view illustrating a heating coil shown in FIG. 55 in a separated state;

FIG. 59 is a cross-sectional view schematically illustrating an example of a per-turn arrangement structure of a first coil portion;

FIG. 60 is a cross-sectional view schematically illustrating another example of the per-turn arrangement structure of the first coil portion;

FIG. 61 is an enlarged cross-sectional view enlarging a stacked structure of the heating coil assembly;.

FIG. 62 is a cross-sectional view illustrating a vertical cross-sectional shape of a pattern coil.

FIG. 63 is an enlarged view enlarging the pattern coil shown in FIG. 62;

FIG. 64 is a table comparing a pattern coil according to one embodiment of the present disclosure with a comparative example;

FIG. 65 is an enlarged cross-sectional view enlarging a vertical cross-sectional shape of a pattern coil formed by etching; and

FIG. 66 is a cross-sectional view illustrating another example of a pattern coil formed by etching.

## DETAILED DESCRIPTION

The above-described aspects, features and advantages are specifically described hereafter with reference to accompanying drawings such that one having ordinary skill in the art to which the disclosure pertains can embody the technical spirit of the disclosure easily. In the *disclosure, detailed description* of known technologies in relation to the subject matter of the disclosure *is* omitted if it is deemed to *make* the *gist* of the *disclosure* unnecessarily *vague* Hereafter, preferred embodiments according to the disclosure are specifically described with reference to the accompanying drawings. In the drawings, identical reference numerals can denote identical or similar components.

The terms "first", "second" and the like are used herein only to distinguish one component from another component. Thus, the components are not to be limited by the terms. Certainly, a first component can be a second component, unless stated to the contrary.

Embodiments are not limited to the embodiments set forth herein, and can be modified and changed in various different forms. The embodiments in the disclosure are provided such that the disclosure can be through and complete and fully convey its scope to one having ordinary skill in the art. Accordingly, *all modifications, equivalents or replacements as well as a replacement of the configuration of any one embodiment with the configuration of another embodiment or an addition of the configuration of any one embodiment to the configuration of another embodiment, within* the technical spirit and scope of the disclosure, *are to be included in* the scope of the disclosure.

The accompanying drawings are provided for a better understanding of the embodiments set forth herein and are not intended to limit the technical spirit of the disclosure. It is to be understood that *all the modifications, equivalents or replacements within* the spirit and technical scope of the disclosure *are included in* the scope of the disclosure. The sizes or thicknesses of the components in the drawings are exaggerated or reduced to ensure ease of understanding and the like. However, the protection scope of the subject matter of the disclosure is not to be interpreted in a limited way.

The terms in the disclosure are used only to describe specific embodiments or examples and not intended to limit the subject matter of the disclosure. In the disclosure, singular forms include plural forms as well, unless explicitly indicated otherwise. In the disclosure, the terms "comprise", "comprised of" and the like specify the presence of stated features, integers, steps, operations, elements, components or combinations thereof but do not imply the exclusion of the presence or addition of one or more other features, integers, steps, operations, elements, components or combinations thereof.

The terms "first", "second" and the like are used herein only to distinguish one component from another component, and the components are not to be limited by the terms.

When any one component is described as "connected" or "coupled" to another component, any one component can be directly connected or coupled to another component, but an additional component can be "interposed" between the two components or the two components can be "connected" or "coupled" by an additional component. When any one component is described as "directly connected" or "directly coupled" to another component, an additional component cannot be "interposed" between the two components or the two components cannot be "connected" or "coupled" by an additional component.

When any one component is described as being "on (or under)" another component, any one component can be directly on (or under) another component, and an additional component can be interposed between the two components.

Unless otherwise defined, all the terms including technical or scientific terms used herein have the same meaning as commonly understood by one having ordinary skill in the art. Additionally, terms such as those defined in commonly used dictionaries are to be interpreted as having a meaning that is consistent with their meaning in the context of the relevant art, and unless explicitly defined herein, are not to be interpreted in an ideal way or an overly formal way.

In the state where a cooking appliance stands on the floor, a direction in which a door is installed with respect to the center of the cooking appliance is defined as a forward direction. Accordingly, a direction toward the inside of the cooking appliance with the door open is defined as a rearward direction. For convenience, the forward direction and the rearward direction can be referred to as a first direction.

Then the forward direction is referred to as one direction of the first direction, and the rearward direction is referred to as the other direction of the first direction.

Additionally, a gravitational direction can be defined as a downward direction, and a direction opposite to the gravitational direction can be defined as an upward direction.

Further, a horizontal direction across a front-rear direction of the cooking appliance, i.e., a widthwise direction of the cooking appliance that is seen in front of the door of the cooking appliance, can be referred to as a left-right direction. For convenience, the left-right direction can be referred to as a second direction. Then the right side can be referred to as one direction of the second direction, and the left side can be referred to as the other direction of the second direction.

Further, the widthwise direction of the cooking appliance can also be referred to as a lateral direction. Then the right side can also be referred to as one side of the lateral direction, and the left side can be referred to the other side of the lateral direction.

Additionally, an up-down direction can be referred to as a third direction. Then an upward direction can be referred to as one direction of the third direction, and a downward direction can be referred to as the other direction of the third direction.

Furthermore, the up-down direction can be referred to as a vertical direction. Then the front-rear direction and the left-right direction, i.e., the first direction and the second direction, can be referred to as the horizontal direction.

Throughout the disclosure, the terms "A and/or B" as used herein can denote A, B or A and B, and the terms "C to D" can denote C or greater and D or less, unless stated to the contrary.

[Entire structure of home appliance]

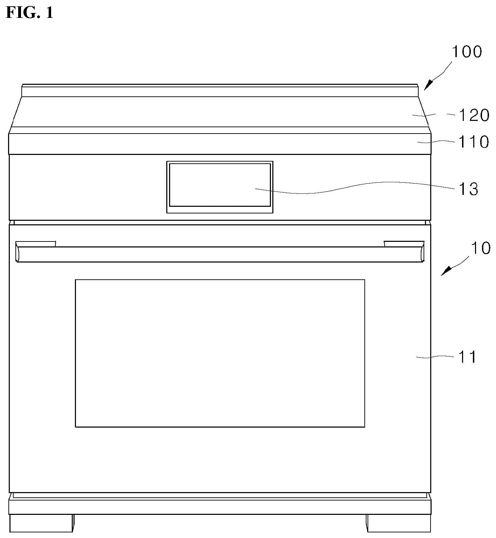

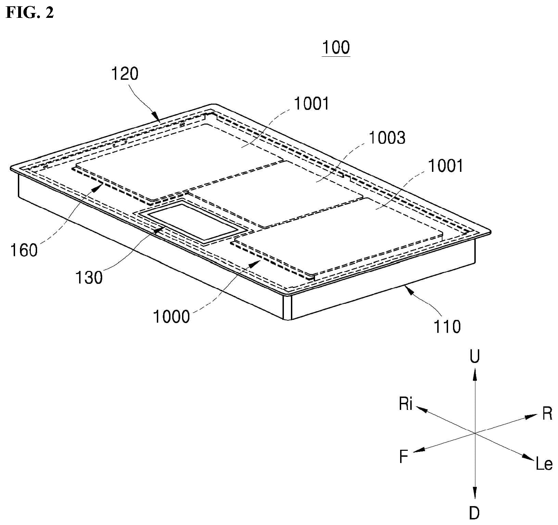

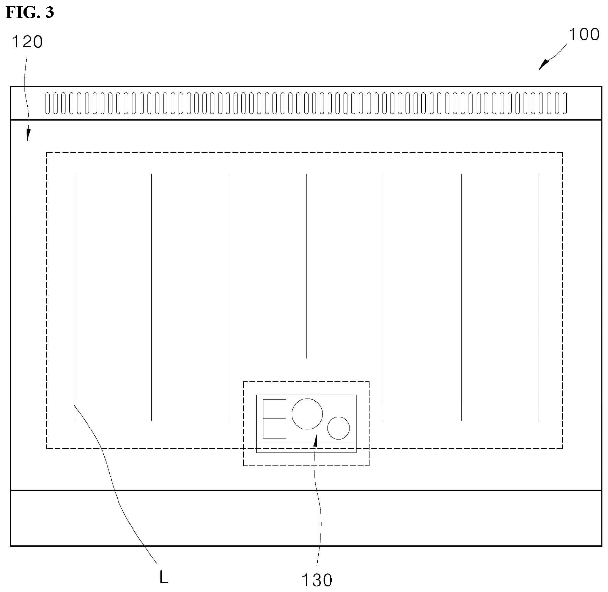

FIG. 1 is a perspective view illustrating a home appliance according to one embodiment of the present disclosure, FIG. 2 is a plan view illustrating a cooktop shown in FIG. 1 in a separated state, and FIG. 3 is a view illustrating a lighting state of indicator lights of the cooktop shown in FIG. 2.

As an example, the home appliance may be a cooking appliance including a cooktop. However, the home appliance of the present disclosure is not limited to a cooking appliance, and various types of appliances such as a washing machine, a water purifier, a clothes dryer, or a clothes care device may be applied as the home appliance of the present disclosure. Hereinafter, an embodiment of the home appliance of the present disclosure will be described by taking a cooking appliance as an example.

Referring to FIGS. 1 to 3, the cooking appliance according to the present embodiment may include a cooktop 100. In addition, the cooking appliance according to the present embodiment may further include an oven part 10. In the present embodiment, the cooking appliance is illustrated as being provided in an oven range form.

The cooking appliance according to the present embodiment provided in the oven range form may provide both a function of an oven, which is a closed-type cooking appliance, and a function of a cooktop, which is an open-type cooking appliance. Such a cooking appliance may include an oven part 10 and a cooktop 100.

A cooking chamber may be formed inside the oven part 10. In the oven part, cooking of food may be performed while an inside of the cooking chamber is heated.

The oven part 10 may be provided with a heating part for heating the cooking chamber. The heating part may be provided as a heating device using gas fuel, or may be provided as a heater using electricity.

The cooking appliance may be provided with a door 11 configured to selectively open and close the cooking chamber and disposed to be rotatable. As an example, the door may be provided in a form of opening and closing the cooking chamber by a pull-down method in which an upper portion thereof rotates upward and downward about a lower portion thereof.

A control panel 13 (hereinafter, referred to as a "main control panel") may be provided on an upper front portion of the cooking appliance. The main control panel 13 may form a part of a front exterior of the cooking appliance. The main control panel 13 may be provided with various switches for controlling an operation of the cooking appliance and a display for displaying an operating state of the cooking appliance, and the like.

A cooktop 100 may be disposed above the oven part 10. The cooktop is provided to be capable of heating food or a vessel containing food placed on an upper portion of the cooktop 100.

[Entire structure of cooktop]

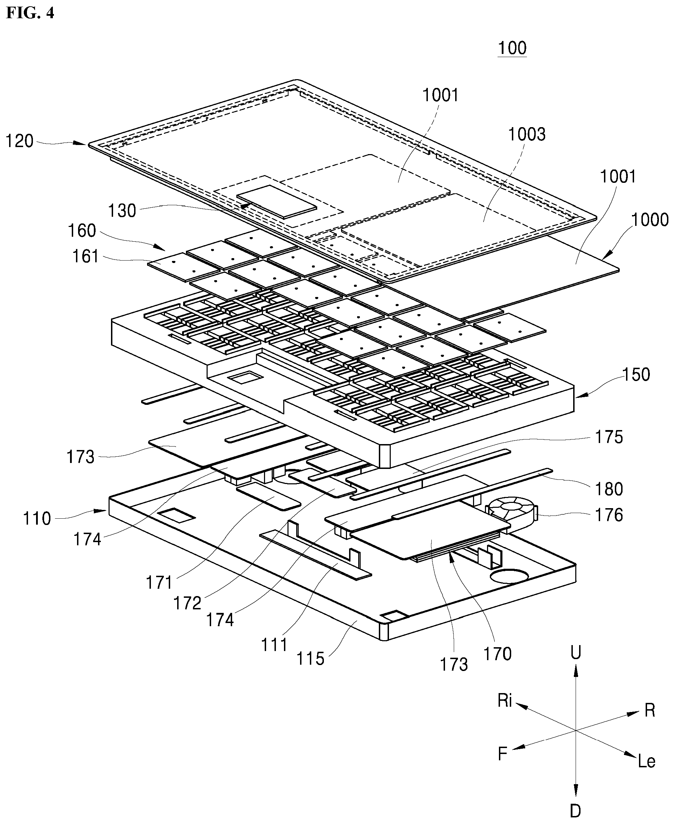

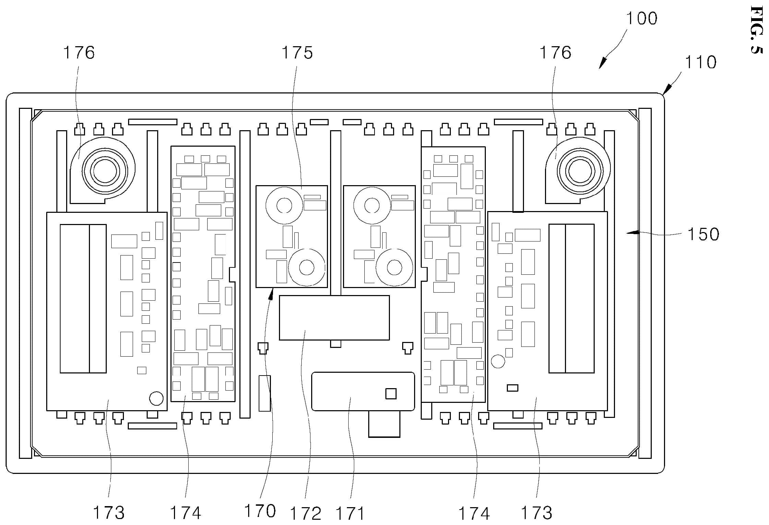

FIG. 4 is an exploded perspective view illustrating an exploded state of the cooktop shown in FIG. 2, and FIG. 5 is a view illustrating a state in which electrical components are installed on a lower surface of a supporter shown in FIG. 4.

Referring to FIGS. 1 to 5, the cooktop 100 may include a case 110 and a top plate 120. According to the present embodiment, an exterior of the cooktop 100 may be formed by the case 110 and the top plate 120. The case 110 is disposed below the top plate 120 and may form a front surface, a rear surface, side surfaces, and a bottom surface of the cooktop. The top plate 120 is disposed at an upper end of the cooktop 100 and may form an upper exterior surface of the cooktop 100.

An accommodating space may be formed inside the case 110. The accommodating space formed inside the case 110 may be open toward an upper side. As an example, the case 110 may be formed in a hexahedral shape having an upper side open. Various internal components constituting the cooktop 100 may be accommodated in an accommodating space surrounded by the top plate 120 and the case 110.

According to the present embodiment, the case 110 may include a bottom 111. The bottom 111 forms a bottom surface of the case 110 and may define a lower boundary surface of the accommodating space. The bottom 111 is disposed below the top plate 120 and may form a plane parallel to the top plate 120.

In addition, the case 110 may include a side wall 113. The side wall 113 may form a front surface, a rear surface, and both side surfaces of the case 110, and may be formed in a form of a vertical wall extending upward from an edge of the bottom 111. The side wall 113 may define a horizontal boundary surface of the accommodating space.

In addition, the cooktop 100 may be provided with a heating part for heating food to be cooked or a vessel containing food (hereinafter, referred to as a "heating target"). The heating part may include at least one cooking zone. For example, the cooking zone may be provided in a form including a heating coil or a heating wire coil using electricity.

In the present embodiment, the cooktop 100 is illustrated as being provided in a form of an induction heating cooking appliance. The cooking zone of the cooktop 100 may include a heating coil. As such, the cooking zone including the heating coil may be operated by a high-frequency current applied by an inverter to generate strong magnetic flux lines.

The magnetic flux lines generated in the cooking zone including the heating coil may generate an eddy current in a vessel, heat may be generated as the eddy current flows in the vessel to heat the vessel, and food accommodated in the vessel may be heated as the vessel is heated.

In addition, the cooktop 100 according to the present embodiment may include a control panel 130 (hereinafter, referred to as a "cooktop control panel"). The cooktop control panel 130 may be disposed on the top plate 120. The cooktop control panel 130 may be provided with an operation part including various switches for controlling an operation of the cooktop 100, and a display for displaying an operating state of the cooktop 100, and the like.

The cooktop 100 may be provided with a plurality of indicator lights L. The indicator lights L may be displayed on the top plate 120 of the cooktop. The indicator lights L may display information related to a position of food to be heated or a cooking vessel containing the food (hereinafter, referred to as a "heating target"), a heating state of the heating target, a temperature, and the like.

The cooktop 100 according to the present embodiment may include a heating coil assembly 140. The heating coil assembly 140 is provided to constitute a heating part of the cooktop 100 and may be disposed in an accommodating space inside the cooktop 100.

In addition, the cooktop 100 may include a supporter 150. The supporter 150 may be disposed below the top plate 120. The supporter 150 may be disposed in a space surrounded by the top plate 120 and the case 110, that is, the accommodating space.

The supporter 150 may form a framework inside the cooktop 100 for supporting various internal components constituting the cooktop. As an example, the supporter 150 may be formed in a hexahedral shape having a lower side open. For example, the supporter 150 may be formed in a shape substantially obtained by vertically inverting the case 110, and may be formed to have a size slightly smaller than that of the case 110.

According to the present embodiment, the accommodating space may be formed inside the supporter 150 and may be formed as a space surrounded by the bottom 111 of the case 110 and the supporter 150. That is, various internal components constituting the cooktop 100 may be accommodated inside the supporter 150.

According to the present embodiment, the supporter 150 may also provide a coil base function. That is, a ferrite core 160 may be installed on the supporter 150, and a heating coil assembly 1000 may be installed above the supporter 150 on which the ferrite core 160 is installed.

As an example, the ferrite core 160 may be formed by a combination of a plurality of ferrite modules 161 provided as separate bodies. That is, the ferrite core 160 may be provided in a structure separable into a plurality of ferrite modules 161.

In the present embodiment, each ferrite module 161 is illustrated as being provided to be respectively coupled to the supporter 150. For this purpose, the supporter 150 may be formed with a structure for fitting engagement with the ferrite modules 161. Each ferrite module 161 may be coupled to the supporter 150 by being fitted into the structure.

Each ferrite module 161 includes ferrite capable of forming a magnetic field around the ferrite module 161. As an example, each ferrite module 161 may be provided in a form in which ferrite is insert-molded.

According to the ferrite core 160 formed by a combination of the plurality of ferrite modules 161 provided as described above, labor required for installing the ferrite core 160 in the cooktop 100 may be reduced. In addition, the ferrite core 160 has an advantage in that, when a portion of the ferrite core 160 is damaged, repair may be performed by replacing the ferrite module 161 corresponding to the damaged portion.

Each indicator light L may be implemented by a lighting module 180. The lighting module 180 is provided to emit light toward a light display area of the top plate 120. As an example, the indicator light L may be implemented by light emitted from the lighting module 180 that irradiates the light display area of the top plate 120.

In the present embodiment, the light display area is defined as an area in which light emitted from the lighting module 180 can be recognized from outside through the top plate 120, that is, an area on the top plate 120 onto which light emitted from the lighting module 180 is irradiated, and is a predetermined partial portion of an entire area of the top plate 120.

As an example, the light display area may be a virtual area designated as a portion on the top plate 120 onto which light emitted from the lighting module 180 is irradiated. In this case, the light display area is not a portion that is visibly marked on the top plate 120 by a separate surface treatment on a surface of the top plate 120, but merely corresponds to a virtual area.

As another example, the light display area may be an area that is visibly marked on the top plate 120 by a separate surface treatment on the surface of the top plate 120.

The lighting module 180 may include a light source. As an example, an LED may be applied as the light source, but a type of the light source applicable as the light source is not limited to an LED.

The lighting module 180 may include a plurality of light sources, and in each lighting module 180, the plurality of light sources may be disposed to be spaced apart from each other by a predetermined interval in a front-rear direction. As an example, the lighting module 180 may be provided in a form in which a plurality of light sources are mounted on a PCB in a PCB form. The number of the light sources for each lighting module 180 and a length of the PCB in the front-rear direction may be appropriately set according to a size and intensity of lighting to be implemented through the lighting module 180.

In addition, a plurality of lighting modules 180 may be disposed in the cooktop, and the plurality of lighting modules 180 may be disposed to be spaced apart from each other by a predetermined interval in a lateral direction. The number of the lighting modules 180 and an interval between the lighting modules 180 may be appropriately set in consideration of a size of the heating coils, the number of the heating coils, intervals between the heating coils, and the like.

At least a portion of the lighting module 180 may be disposed between the supporter 150 and the bottom 111. As an example, the lighting module 180 may be disposed in the accommodating space. More specifically, the lighting module 180 may be disposed in a space surrounded by the bottom 111 of the case 110 and the supporter 150.

Inside the cooktop 100, that is, in the accommodating space, various electrical components may be installed. For example, a main PCB 171, a switching mode power supply (SMPS) 162, an inverter PCB 163, a resonant PCB 164, a noise filter (EMI filter) 165, a fan 176, and the like may be disposed in an internal space of the cooktop 100.

Hereinafter, the electrical components described above will be collectively referred to as an electrical part 170. The electrical part 170 may include at least one of a power processing part and a coil controller. The power processing part is provided to supply power to the heating coil assembly 1000, and the power processing part may include a switching mode power supply (SMPS) 162, a noise filter (EMI filter) 165, and the like. The coil controller is provided to control an operation of the heating coil assembly 1000, and the coil controller may include an inverter PCB 174, and the like.

[Entire structure of heating coil assembly]

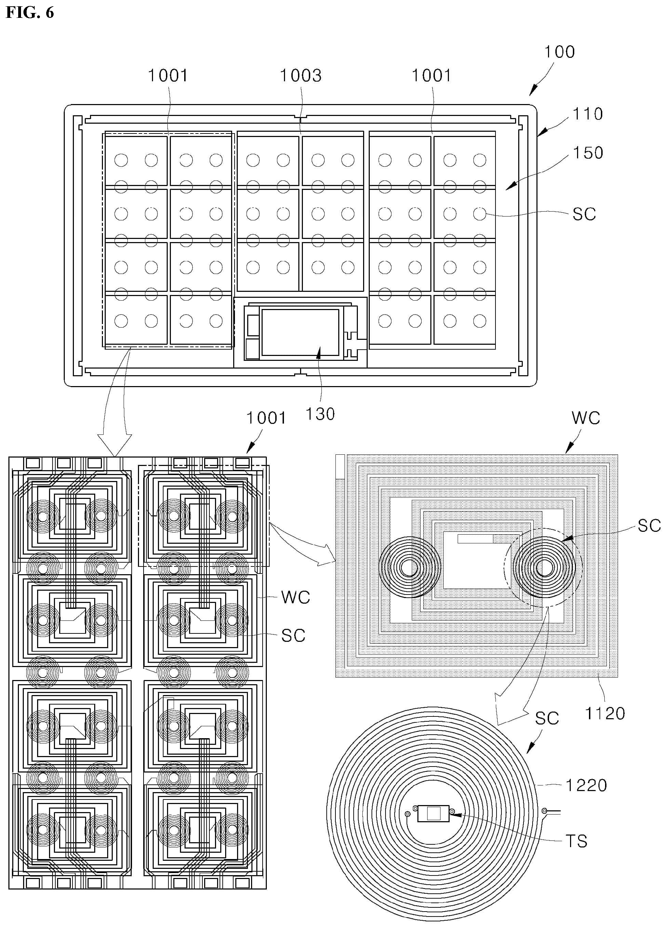

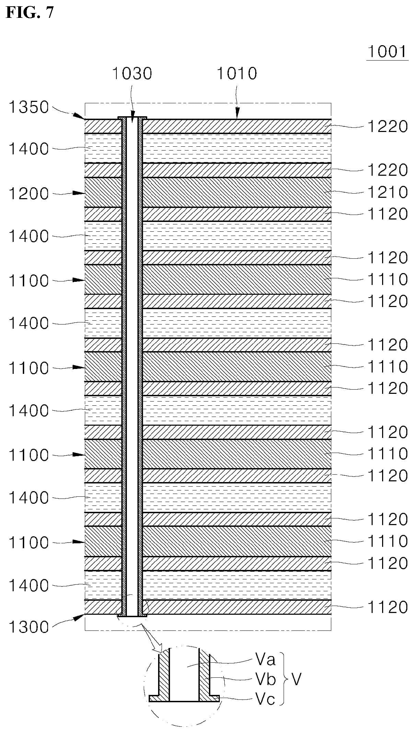

FIG. 6 is a view schematically illustrating a configuration of the heating coil assembly shown in FIG. 4, and FIG. 7 is a cross-sectional view schematically illustrating a stacked structure of a coil module shown in FIG. 6.

Referring to FIGS. 4 and 6, the heating coil assembly 1000 may include a plurality of heating coils WC arranged in a horizontal direction. As an example, in the heating coil assembly 1000, the plurality of heating coils WC may be arranged along a first direction, that is, a lateral direction, and a plurality of heating coils WC may also be arranged with respect to a second direction, that is, a front-rear direction.

The heating coil assembly 140 may include at least one coil module 1001, 1003. In the present embodiment, the heating coil assembly 140 is illustrated as including a plurality of coil modules 1001, 1003.

As an example, the heating coil assembly 140 may include a plurality of coil modules 1001, 1003 arranged in a horizontal direction. For example, the heating coil assembly 140 may include a plurality of coil modules 1001, 1003 arranged along a first direction.

In each of the coil modules 1001, 1003, as shown in FIGS. 6 and 7, a plurality of heating coils WC may be disposed in a horizontal direction. Each heating coil WC may be provided in a form in which a spiral coil is patterned on a printed circuit board. That is, the heating coil 142 may be provided in a patterned form formed on the coil modules 1001, 1003.

Each coil module 1001, 1003 may include a coil board stack 1010. The coil board stack 1010 may include a plurality of first coil board parts 1100 stacked in a vertical direction.

Each first coil board part 1100 may include a first coil portion 1120. As an example, the first coil portion 1120 may be formed as a result of patterning a metal foil stacked on a surface of the first coil board part 1100 into a spiral coil shape.

According to the present embodiment, a plurality of first coil board parts 1100 may be stacked in a vertical direction to form one coil module 1001, 1003, and accordingly, a plurality of first coil portions 1120 may be stacked in the vertical direction. The plurality of first coil portions 1120 stacked in the vertical direction may be connected to each other in the vertical direction to each form one heating coil WC.

In addition, in each first coil board part 1100, a plurality of first coil portions 1120 may be arranged in a horizontal direction, and accordingly, each coil module 1001, 1003 may include a plurality of heating coils WC arranged in the horizontal direction.

In addition, the heating coil assembly 1000 according to the present embodiment may include sensing coils SC for sensing presence of a heating target, as shown in FIGS. 6 and 7. Each coil module 1001, 1003 may include a plurality of sensing coils SC arranged in the horizontal direction. As an example, in the heating coil assembly 1000, the plurality of sensing coils SC may be arranged along a first direction, that is, a lateral direction, and a plurality of sensing coils SC may also be arranged with respect to a second direction, that is, a front-rear direction.

Each sensing coil SC may be provided in a form in which a spiral coil is patterned on a printed circuit board. That is, the sensing coil SC may be provided in a patterned form formed on the coil modules 1001, 1003.

According to the present embodiment, the coil board stack 1010 may include at least one second coil board part 1200. The second coil board part 1200 may be stacked in the vertical direction together with the first coil board parts 1100. That is, at least one second coil board part 1200 and a plurality of first coil board parts 1100 may be stacked in a vertical direction to form one coil module 1001, 1003. Accordingly, in each coil module 1001, 1003, at least a portion of the heating coil WC and the sensing coil SC may be arranged in the vertical direction.

Each second coil board part 1200 may include a second coil portion 1220. As an example, the second coil portion 1220 may be formed as a result of patterning a metal foil stacked on a surface of the second coil board part 1200 into a spiral coil shape.

Each sensing coil SC may be formed by one second coil portion 1220, or may be formed as a result of connecting a plurality of second coil portions 1220 stacked in the vertical direction in the vertical direction.

In addition, in each second coil board part 1200, a plurality of second coil portions 1220 may be arranged in a horizontal direction, and accordingly, each coil module 1001, 1003 may include a plurality of sensing coils SC arranged in the horizontal direction.

In addition, the heating coil assembly 1000 according to the present embodiment may further include a temperature sensor TS. The temperature sensor TS is provided to measure a temperature of the heating target and may be disposed on the second coil board part 1200.

The temperature sensor TS may be disposed on an inner side in a horizontal direction of the sensing coil SC. For example, the temperature sensor TS may be installed on the second coil board part 1200 and may be disposed within an area surrounded by the sensing coil SC.

[Arrangement structure of coil modules]

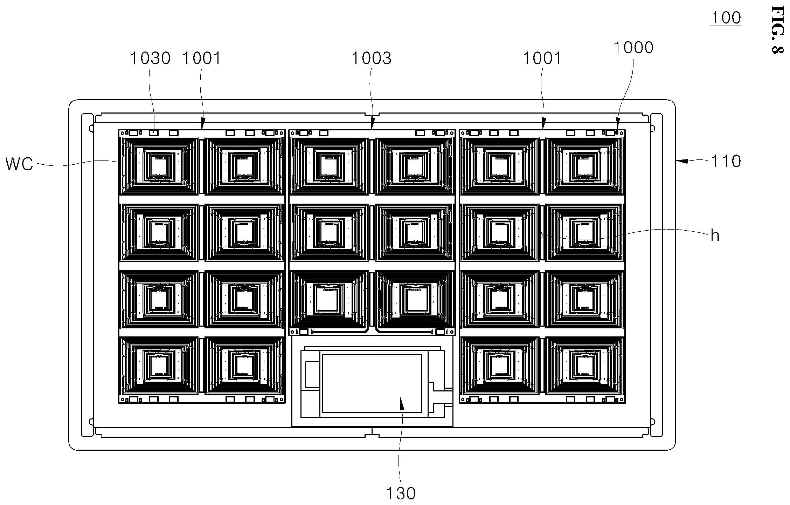

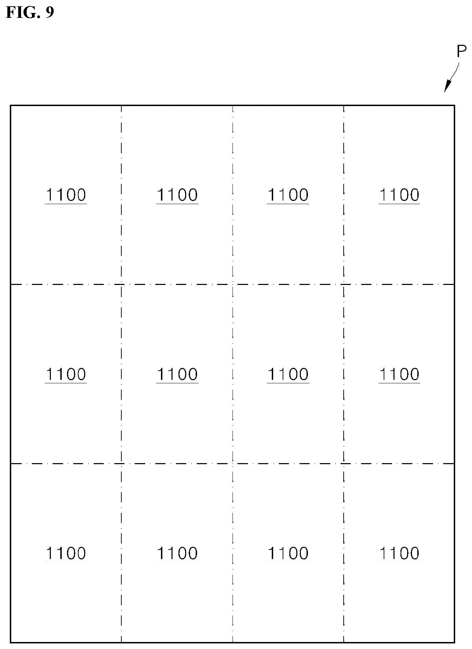

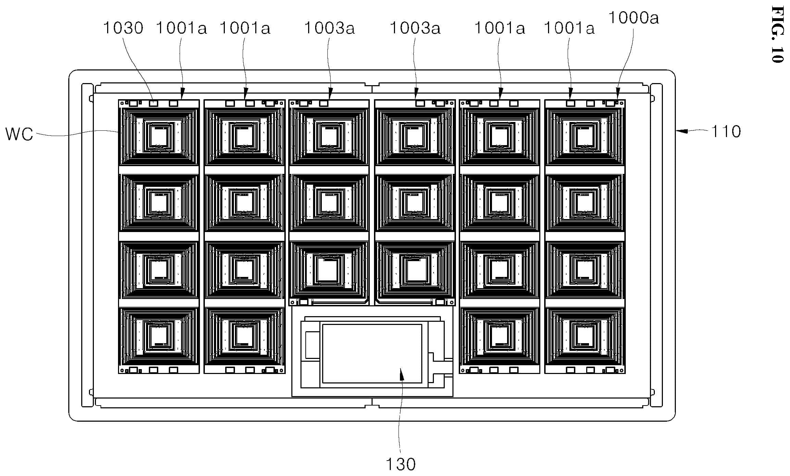

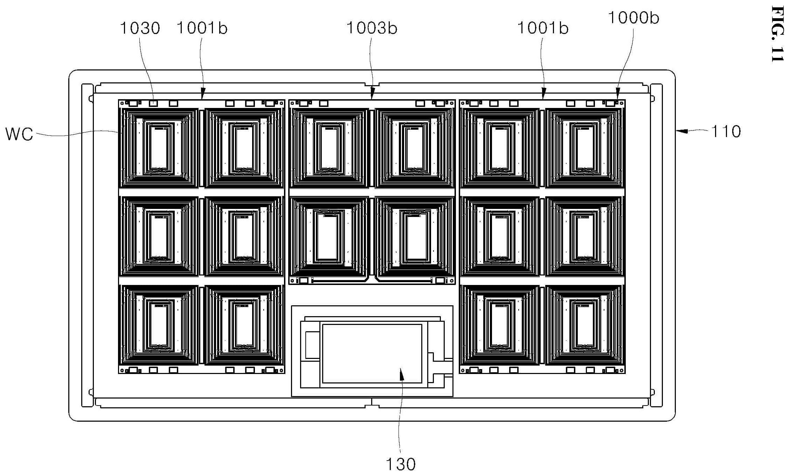

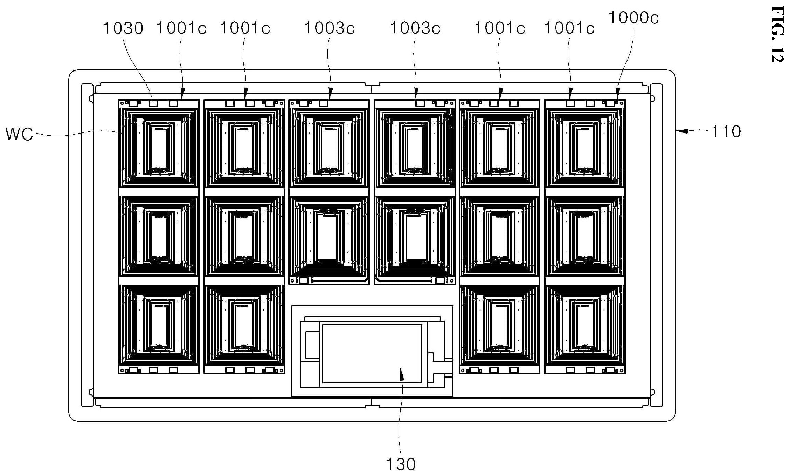

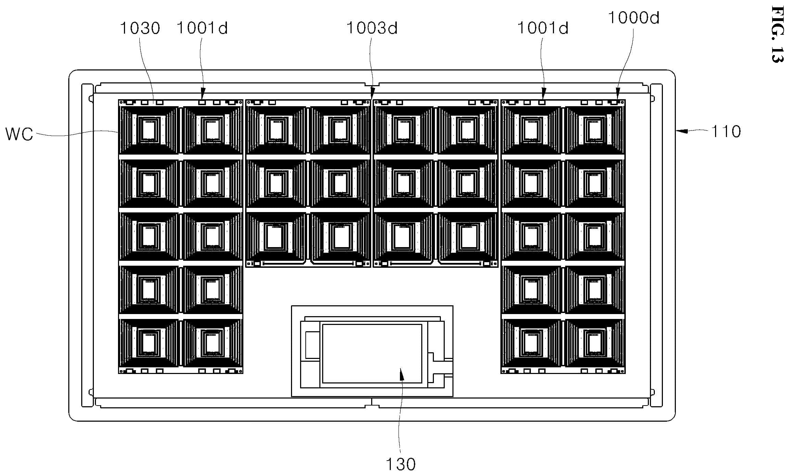

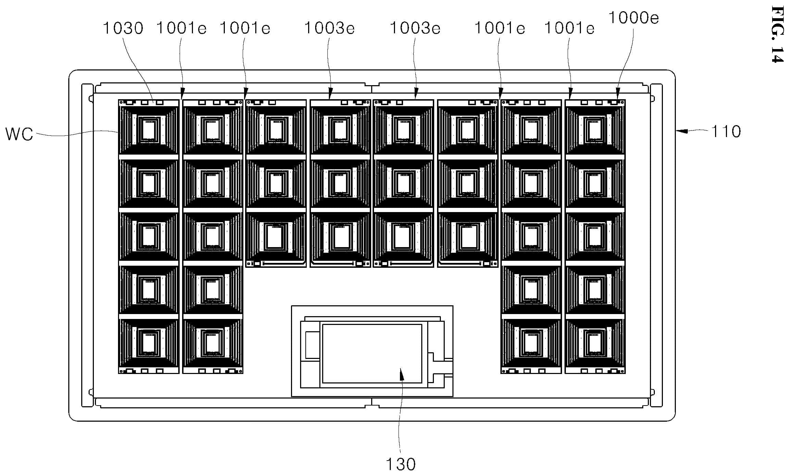

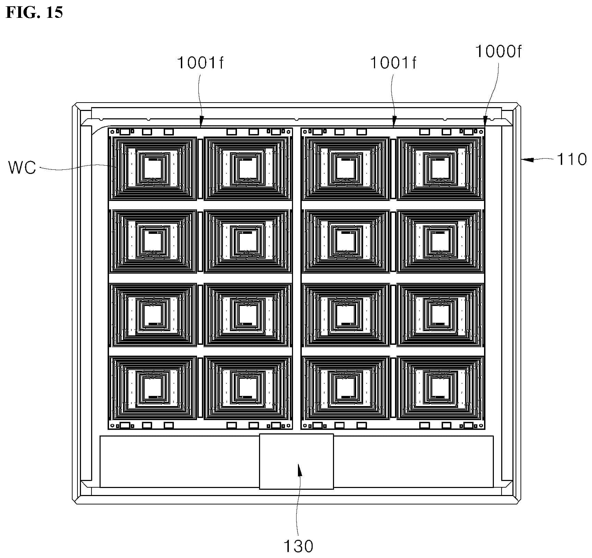

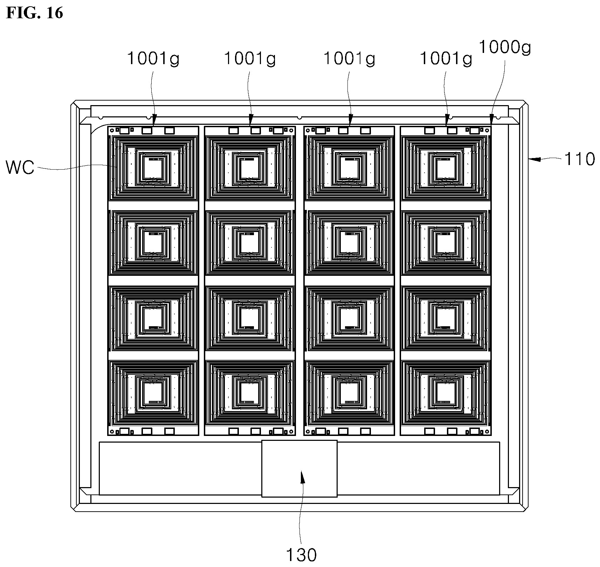

FIG. 8 is a plan view illustrating a first example of an arrangement structure of a first coil module and a second coil module, and FIG. 9 is a view schematically illustrating an example of a raw plate cutting state for forming a first coil board part. In addition, FIG. 10 is a plan view illustrating a second example of the arrangement structure of the first coil module and the second coil module, FIG. 11 is a plan view illustrating another example of the arrangement structure of the first coil module and the second coil module shown in FIG. 8, and FIG. 12 is a plan view illustrating another example of the arrangement structure of the first coil module and the second coil module shown in FIG. 10. In addition, FIG. 13 is a plan view illustrating a third example of the arrangement structure of the first coil module and the second coil module, and FIG. 14 is a plan view illustrating a fourth example of the arrangement structure of the first coil module and the second coil module. In addition, FIG. 15 is a plan view illustrating a fifth example of the arrangement structure of the first coil module and the second coil module, and FIG. 16 is a plan view illustrating a sixth example of the arrangement structure of the first coil module and the second coil module.

Referring to FIGS. 4 and 8, the heating coil assembly 1000 according to the present embodiment includes a plurality of coil modules 1001, 1003, and a plurality of coil modules 1001, 1003 may be arranged along a horizontal direction in the heating coil assembly 1000. As an example, in the heating coil assembly 1000, a plurality of coil modules 1001, 1003 may be arranged along a first direction.

As described above, the cooktop 100 according to the present embodiment may include a cooktop control panel 130. The cooktop control panel 130 may be disposed on the top plate 120 and may be disposed at a position biased toward a front side.

With respect to the first direction, the cooktop control panel 130 may be disposed at approximately a center of the heating coil assembly 1000. With respect to the second direction, the cooktop control panel 130 may be disposed at a position biased toward a front side of the heating coil assembly 1000.

The heating coil assembly 1000 is disposed below the top plate 120, but is not disposed below an area of the top plate 120 occupied by the cooktop control panel 130. That is, the heating coils WC are disposed only below an area of the top plate 120 not occupied by the cooktop control panel 130, and are not disposed below the area of the top plate 120 occupied by the cooktop control panel 130.

The heating coil assembly 1000 may include various types of coil modules 1001, 1003 having different sizes. In the present embodiment, the coil modules 1001, 1003 are illustrated as including a first coil module 1001 and a second coil module 1003. In this case, the first coil module 1001 includes a plurality of heating coils WC, and the second coil module 1003 includes a smaller number of heating coils WC than the first coil module 1001.

According to the present embodiment, in the heating coil assembly 1000, the first coil module 1001 and the second coil module 1003 may be arranged along a horizontal direction. In addition, with respect to the second direction, a length of the second coil module 1003 may be set to be shorter than a length of the first coil module 1001. That is, the second coil module 1003 may be provided in a form having a shorter length in the second direction than the first coil module 1001 and including a smaller number of heating coils WC.

In the heating coil assembly 1000, a pair of the first coil modules 1001 and at least one of the second coil modules 1003 may be arranged along the first direction. In this case, the pair of first coil modules 1001 may be disposed to be spaced apart along the first direction. At least one second coil module 1003 may be disposed between the pair of first coil modules 1001.

For example, at least one second coil module 1003 may be disposed at a center of the heating coil assembly 1000 in the first direction, similarly to the cooktop control panel 130. The at least one second coil module 1003 and the cooktop control panel 130 may be disposed on the same straight line in the second direction.

With respect to the first direction, the cooktop control panel 130 may be disposed between the pair of first coil modules 1001. In addition, with respect to the second direction, the cooktop control panel 130 may be disposed at a position biased to one side relative to the second coil module 1003, for example, disposed on a front side of the second coil module 1003. Accordingly, at least a portion of the cooktop control panel 130 may be disposed within an area surrounded by the pair of first coil modules 1001 and the second coil module 1003.

That is, the cooktop control panel 130 is disposed at a position where visual information provided through the cooktop control panel 130 can be clearly seen by a user and where the user can easily operate the cooktop control panel 130. The cooktop control panel 130 occupies a predetermined area on an upper surface of the cooktop 100.

In addition, since the heating coils WC cannot be disposed in an area occupied by the cooktop control panel 130 on the upper surface of the cooktop 100, the heating coils WC should be disposed in remaining areas excluding the area occupied by the cooktop control panel 130. Accordingly, the heating coil assembly 1000 including the heating coils WC is disposed in an area on the upper surface of the cooktop 100 that is not occupied by the cooktop control panel 130. For example, a horizontal outer shape of the heating coil assembly 1000 may be formed in a shape obtained by vertically inverting a "凵" shape.

The heating coil assembly 1000 may include coil modules 1001 and 1003 including the heating coils WC, and may include various types of coil modules 1001 and 1003 having different lengths in the second direction. In the present embodiment, the heating coil assembly 1000 is illustrated as including two types of coil modules 1001 and 1003, that is, a first coil module 1001 and a second coil module 1003.

For example, a horizontal outer shape of each of the coil modules 1001 and 1003 (hereinafter, referred to as an "outer shape of a coil module") may be formed as a rectangle. That is, the outer shapes of the first coil module 1001 and the second coil module 1003 may each be formed as rectangles.

For example, the second coil module 1003 may be formed as a rectangular shape having a different length in the second direction from the first coil module 1001. In addition, the second coil module 1003 and the cooktop control panel 130 are disposed on the same straight line in the second direction, and the second coil module 1003 may be disposed on a rear side of the cooktop control panel 130.

In consideration of the fact that the second coil module 1003 is disposed on the same straight line as the cooktop control panel 130 in the second direction, the length of the second coil module 1003 in the second direction is set to be shorter than the length of the first coil module 1001 in the second direction.

As described above, the heating coil assembly 1000 is formed by a combination of a plurality of coil modules 1001 and 1003 arranged in the horizontal direction, and each of the coil modules 1001 and 1003 may be formed as a rectangle. That is, the heating coil assembly 1000 is not formed by a single coil module having a shape obtained by vertically inverting a "凵" shape, but may be formed by a combination of a plurality of coil modules 1001 and 1003 each formed as a rectangle.

According to the present embodiment, as shown in FIGS. 8 and 9, the first coil board parts 1100 forming the respective coil modules 1001 and 1003 may be formed of copper clad laminates (CCLs), and each copper clad laminate forming each first coil board part 1100 may be provided as a result obtained by cutting an original plate B of a copper clad laminate (hereinafter, referred to as an "original plate").

When the first coil board part 1100 is formed in a "凵" shape or a shape obtained by inverting the "凵" shape, during fabrication of the first coil board part 1100 by cutting the original plate P, a loss of the original plate P corresponding to a portion cut out to secure an arrangement space for the cooktop control panel 130 inevitably occurs. That is, when the heating coil assembly 1000 is formed by a single coil module 1001 or 1003, a problem arises in that loss of the original plate P used for manufacturing the first coil board part 1100 increases.

In contrast, when the heating coil assembly 1000 is formed by a combination of a plurality of coil modules 1001 and 1003, each of the coil modules 1001 and 1003 can be formed as a rectangle. That is, the heating coil assembly 1000 may be formed in a "凵"

shape or a shape obtained by vertically inverting the "凵" shape by combining various types of coil modules 1001 and 1003 having different sizes, for example, the first coil module 1001 and the second coil module 1003.

Accordingly, when the original plate P is cut to manufacture the first coil board part 1100, the original plate P can be cut into a rectangular shape, so that loss of the original plate P used for manufacturing the first coil board part 1100 can be effectively reduced.

According to the present embodiment, the heating coil WC may be formed in a shape including a polygonal shape. For example, a horizontal outer shape of the heating coil WC (hereinafter, referred to as an "outer shape of a heating coil") may be a polygonal shape.

As an example, the outer shape of the heating coil WC may be substantially rectangular, and a horizontal outer shape of the cooktop 100 (hereinafter, referred to as an "outer shape of the cooktop") may also be substantially close to a rectangular shape. Considering the above, a horizontal outer shape of the coil modules 1001 and 1003 (hereinafter, referred to as an "outer shape of a coil module") is preferably rectangular.

Since the outer shape of the coil modules 1001 and 1003 is formed as a rectangle similar to the outer shape of the heating coil WC, density of an area occupied by the heating coil WC within the coil modules 1001 and 1003 may be effectively increased. In addition, since the outer shape of the coil modules 1001 and 1003 is formed as a rectangle similar to the outer shape of the cooktop 100, density of an area occupied by the coil modules 1001 and 1003 within the cooktop 100 may be effectively increased.

That is, as the outer shape of the coil modules 1001 and 1003 is formed as a polygonal shape similar to the outer shape of the heating coil WC and the outer shape of the cooktop 100, density of an area occupied by the heating coil WC within the cooktop 100 may be effectively increased, and accordingly, a size of an area in which heating of a cooking target is possible within the cooktop 100 may be effectively increased.

Accordingly, as a size of an area in which a heating target contacts the heating coil WC within the cooktop 100 is increased, heating efficiency of the cooktop 100 may be effectively improved.

Meanwhile, a length difference between the first coil module 1001 and the second coil module 1003 in the second direction may be adjusted by a difference in the number of heating coils WC in the second direction. For example, heating coils WC having the same size and shape may be provided in both the first coil module 1001 and the second coil module 1003, and the number of heating coils WC in the second direction in the second coil module 1003 may be set to be at least one less than the number of heating coils WC in the second direction in the first coil module 1001.

As described above, by setting the lengths of the first coil module 1001 and the second coil module 1003 to be different by adjusting the number of heating coils WC, even when sizes of the coil modules 1001 and 1003 are different, there is no need to design sizes and shapes of the heating coils WC differently according to the sizes of the coil modules. That is, various types of coil modules 1001 and 1003 having different lengths in the second direction may all be provided in a form including one type of heating coil WC.

Accordingly, not only costs and time required for designing the heating coil WC may be reduced, but also various types of coil modules 1001 and 1003 having different lengths in the second direction may be manufactured more easily and quickly at lower cost.

According to the present embodiment, the cooktop control panel 130 and the second coil module 1003 may be disposed at a center of an upper surface of the cooktop 100 in the first direction, and the first coil modules 1001 may be disposed at both sides of the upper surface of the cooktop 100 in the first direction.

For example, a length of the first coil module 1001 in the second direction may be set to be substantially similar to a length of the upper surface of the cooktop 100 in the second direction. Further, a difference in the length in the second direction between the first coil module 1001 and the second coil module 1003 may be set to be greater than or equal to a length of the heating coil WC in the second direction.

Accordingly, while heating coils WC can fill most of the area of the upper surface of the cooktop 100, an area required for arranging the cooktop control panel 130 can be secured on the upper surface of the cooktop 100.

For example, in the heating coil assembly 1000, a pair of first coil modules 1001 and one second coil module 1003 may be disposed along the first direction. In this case, the pair of first coil modules 1001 may be arranged to be spaced apart along the first direction. Further, the one second coil module 1003 may be disposed between the pair of first coil modules 1001.

For example, the one second coil module 1003 may be disposed at a center of the heating coil assembly 1000 in the first direction, similarly to the cooktop control panel 130. The one second coil module 1003 and the cooktop control panel 130 may be disposed on the same straight line in the second direction.

In this case, the number of heating coils WC included in each first coil module 1001 and the number of heating coils WC included in the second coil module 1003 may be, for example, eight and six, respectively (see FIG. 8), or six and four, respectively (see FIG. 11).

As another example, in a heating coil assembly 1000a as shown in FIG. 10, two pairs of first coil modules 1001a and one pair of second coil modules 1003a may be arranged along the first direction. In this case, one pair of the first coil modules 1001a may be disposed at one side in the first direction of one pair of the second coil modules 1003a, and the other pair of first coil modules 1001a may be disposed at the other side in the first direction of the pair of second coil modules 1003a.

In this case, the number of heating coils WC included in each first coil module 1001a and the number of heating coils WC included in each second coil module 1003a may be, for example, four and three, respectively (see FIG. 10), or three and two, respectively (see FIG. 12).

As still another example, in a heating coil assembly 1000d as shown in FIG. 13, a pair of first coil modules 1001d and a pair of second coil modules 1003d may be disposed to be spaced apart along the first direction. Further, the pair of second coil modules 1003d may be disposed between the pair of first coil modules 1001d.

As yet another example, in a heating coil assembly 1000e as shown in FIG. 14, two pairs of first coil modules 1001e and two pairs of second coil modules 1003e may be arranged along the first direction. In this case, one pair of first coil modules 1001e may be disposed at one side in the first direction of the two pairs of second coil modules 1003e, and the other pair of first coil modules 1001e may be disposed at the other side in the first direction of the two pairs of second coil modules 1003e.

Further, as shown in FIG. 15, only a pair of first coil modules 1001f may be arranged along the first direction, or as shown in FIG. 16, only two pairs of first coil modules 1001g may be arranged along the first direction.

[Structure of heating coil]

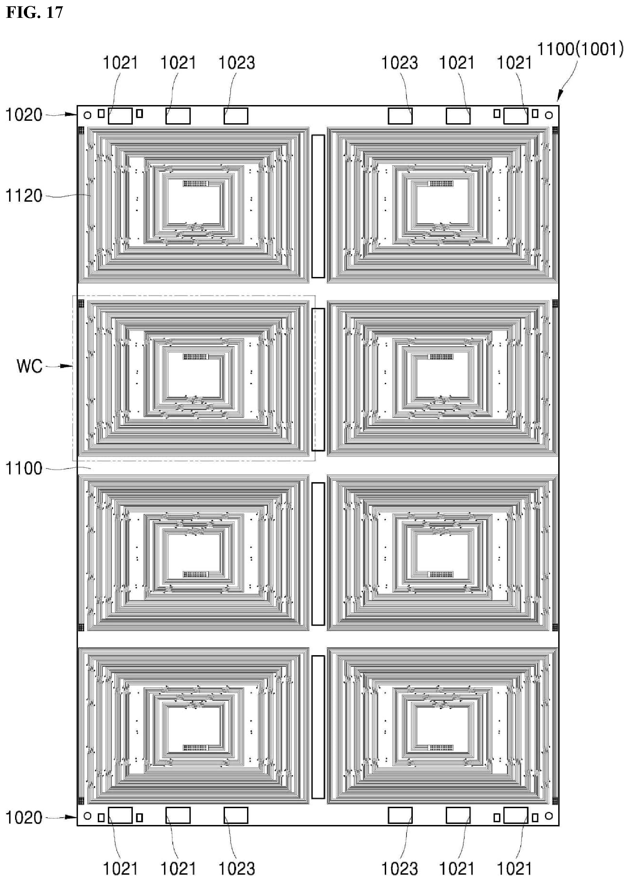

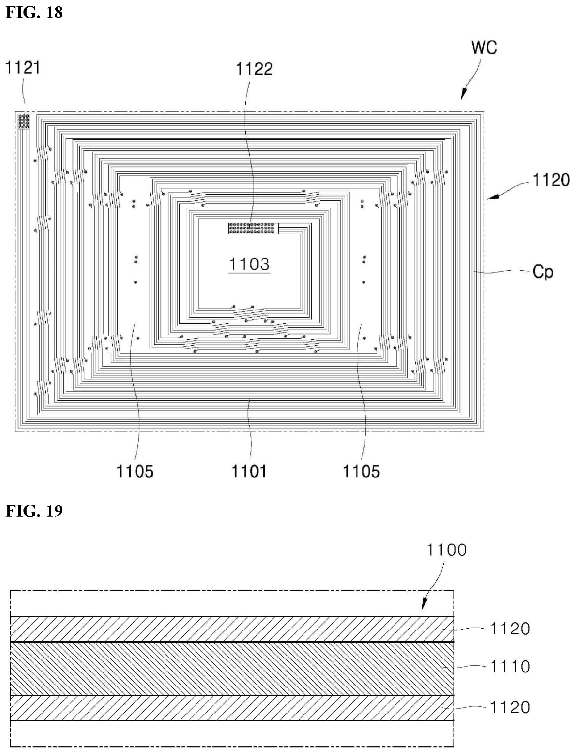

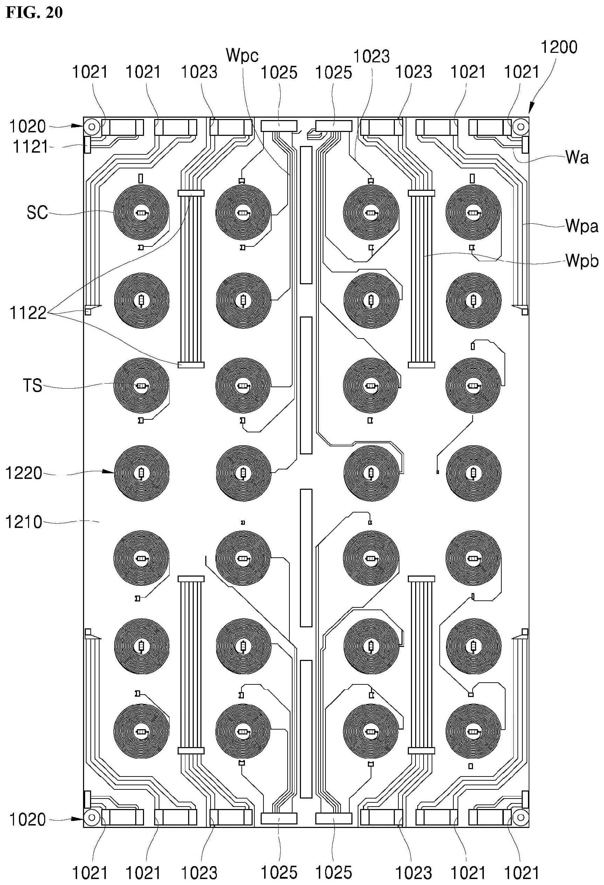

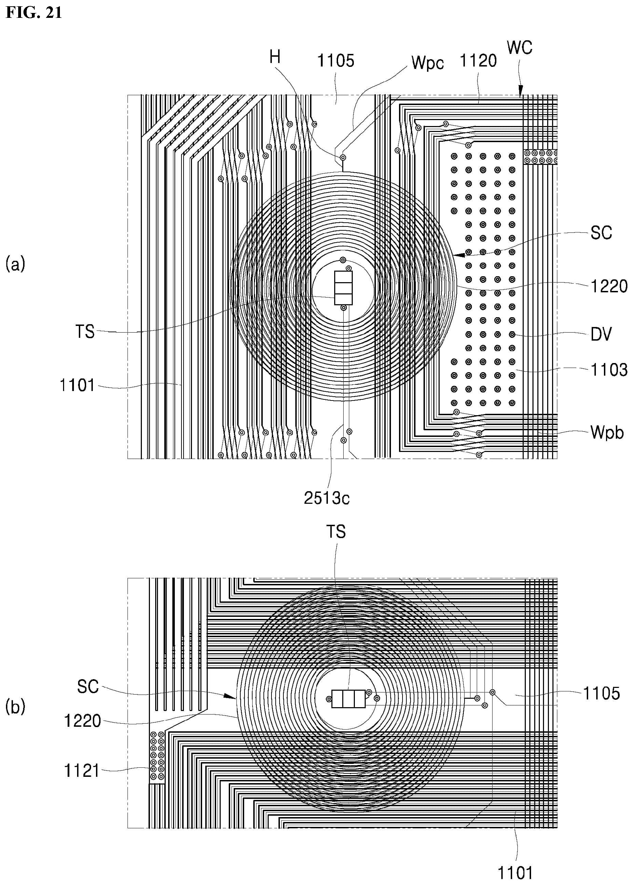

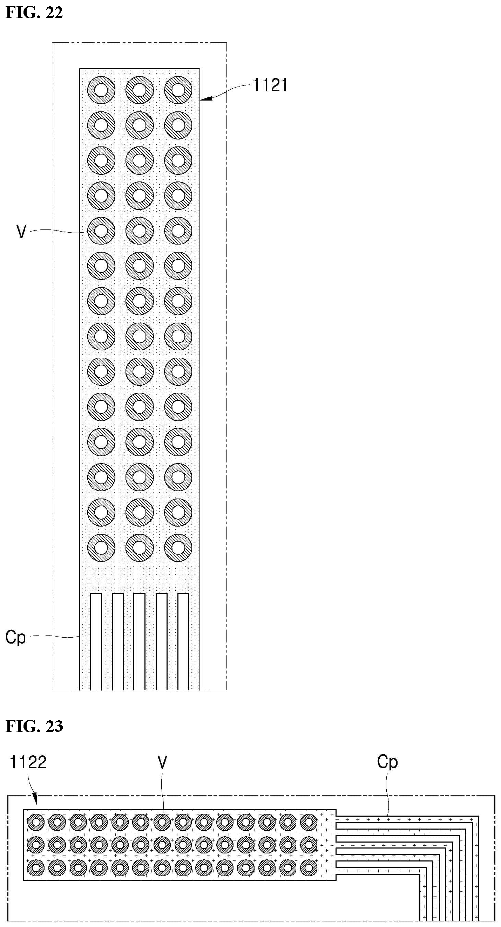

FIG. 17 is a plan view illustrating an example of a first coil board part according to an embodiment of the present disclosure, FIG. 18 is an enlarged view illustrating a portion of the first coil board part shown in FIG. 17, and FIG. 19 is a cross-sectional view schematically illustrating a stacked structure of the first coil portion shown in FIG. 18. FIG. 20 is a plan view illustrating an example of an arrangement structure of sensing coils, and FIG. 21 is an enlarged view enlarging a portion of FIG. 20 and illustrating an example of an arrangement structure of the sensing coils with respect to heating coils. FIG. 22 is an enlarged view enlarging the first terminal shown in FIG. 18, and FIG. 23 is an enlarged view enlarging the second terminal shown in FIG. 18.

According to the present embodiment, as shown in FIGS. 8 and 17 to 19, the heating coil WC may be formed by conductors stacked in a plurality of layers, more specifically, by electrical conductors. In the present embodiment, the conductors are exemplified as being formed by first coil portions 1120, more specifically, by coil patterns Cp to be described later.

The heating coil WC may be formed as a result of first coil portions 1120 respectively provided in a plurality of first coil board parts 1100 stacked in a vertical direction being connected to each other in the vertical direction. Each first coil board part 1100 may include a core 1110 and a first coil portion 1120.

The core 1110 forms a framework of the first coil board part 1100 and may be formed of an insulating material. For example, the core 1110 may be formed of a prepreg material. In the present embodiment, the core 1110 is exemplified as being formed of a thermoset prepreg, more specifically, an FR4 prepreg.

The first coil portion 1120 may be disposed on both sides of the core 1110 in the vertical direction. For example, each first coil board part 1100 may be provided in a form in which one layer of a first coil portion 1120 is formed on each of both sides of the core 1110 in a vertical direction.

As an example, the first coil portion 1120 may be provided in a patterned form on each of both sides of the core 1110 in the vertical direction. For example, the first coil board part 1100 may be formed by a copper clad laminate including the core 1110 and copper foils stacked on each of both sides of the core 1110 in the vertical direction. In this case, the first coil portion 1120 may be formed as a result of the foil stacked on the core 1110 being patterned in a coil shape.

According to the present embodiment, the heating coil WC may be formed in a shape including a polygonal shape. For example, a horizontal outer shape of the heating coil WC (hereinafter, referred to as an "outer shape of a heating coil") may be a polygonal shape.

In addition, as described above, the heating coil WC may be formed by a plurality of first coil board parts 1100 stacked in the vertical direction. The first coil board part 1100 may include a patterned region 1101 and non-patterned regions 1103 and 1105.

The patterned region 1101 corresponds to a region of the first coil board part 1100 in which the first coil portion 1120 is disposed. The non-patterned regions 1103 and 1105 correspond to regions of the first coil board part 1100 in which the first coil portion 1120 is not disposed. The patterned region 1101 and the non-patterned regions 1103 and 1105 may be disposed on the same plane and may be arranged in a horizontal direction.

The non-patterned regions 1103 and 1105 may include a first non-patterned region 1103. In each heating coil WC, the first non-patterned region 1103 may be disposed at a horizontal-direction center. In addition, the first non-patterned region 1103 may be disposed at a horizontal-direction center of the first coil board part 1100.

For example, the first non-patterned region 1103 may be disposed at a horizontal-direction center of each heating coil WC and the first coil board part 1100. The patterned region 1101 may be disposed to surround the first non-patterned region 1103 from a horizontal-direction outer side.

In the present embodiment, the term "center" does not mean an exact center, but refers to a region surrounded by the spirally wound heating coil WC and includes a diameter-direction center of the heating coil WC and a surrounding region thereof.

At least a portion of the first coil portion 1120 may surround the non-patterned regions 1103 and 1105 from a horizontal-direction outer side. For example, at least a portion of the first coil portion 1120 may surround the first non-patterned region 1103 from a horizontal-direction outer side.

The first coil portion 1120 may include at least one coil pattern Cp disposed on a horizontal-direction outer side of the first non-patterned region 1103. In each first coil portion 1120, each coil pattern Cp may be wound a plurality of turns around the first non-patterned region 1103. The first coil portion 1120 may be formed by at least one coil pattern Cp provided in such a manner.

Each first coil portion 1120 may include a plurality of coil patterns Cp. In this case, in each first coil portion 1120, the plurality of coil patterns Cp may be disposed to be spaced apart from each other by a predetermined interval along a diametrical direction of the heating coil WC.

For example, each first coil portion 1120 may include three to six coil patterns Cp. However, the present disclosure is not limited thereto, and each coil portion 112 may include more than six coil patterns Cp.

In the present embodiment, each first coil portion 1120 is exemplified as including three to six coil patterns Cp. Accordingly, in each first coil portion 1120, three to six coil patterns Cp may be arranged along the diametrical direction of the heating coil WC. Each coil pattern Cp disposed in each first coil portion 1120 may be connected in a vertical direction to one of coil patterns Cp disposed in another first coil portion 1120 adjacent in the vertical direction.

In addition, the first coil board part 1100 may further include a second non-patterned region 1105. The second non-patterned region 1105, like the first non-patterned region 1103, corresponds to a region in which the first coil portion 1120 is not formed.

With respect to a horizontal direction, the second non-patterned region 1105 may be disposed on an outer side of the first non-patterned region 1103. In the present embodiment, the second non-patterned region 1105 is exemplified as being disposed on a first-direction outer side of the first non-patterned region 1103.

In addition, in each first coil board part 1100, the first non-patterned region 1103 and the second non-patterned region 1105 are not connected in the horizontal direction. With respect to the horizontal direction, at least a portion of the sensing coil SC may be disposed between the first non-patterned region 1103 and the second non-patterned region 1105. That is, at least a portion of the first coil portion 1120 may be disposed between the first non-patterned region 1103 and the second non-patterned region 1105.

According to the present embodiment, for each heating coil WC, a plurality of second non-patterned regions 1105 may be arranged along the first direction. For example, for each heating coil WC, a pair of second non-patterned regions 1105 may be disposed. The pair of second non-patterned regions 1105 may be disposed on a first-direction outer side of the first non-patterned region 1103. That is, with respect to the first direction, the first non-patterned region 1103 may be disposed between the pair of second non-patterned regions 1105.

In addition, according to the present embodiment, a plurality of heating coils WC may be arranged along the first direction. The plurality of second non-patterned regions 1105 provided in the plurality of heating coils WC disposed in this manner may be disposed at equal intervals along the first direction.

Meanwhile, as shown in FIGS. 6 to 7, a second coil board part 1200 is disposed above or below the first coil board part 1100, and a sensing coil SC may be formed by the second coil board part 1200. The sensing coil SC may be disposed above or below the first coil board part 1100 and may be disposed in a region overlapping the first coil board part 1100 in a vertical direction.

In each of the coil modules 1001 and 1003, as shown in FIGS. 6 to 7 and FIGS. 20 to 21, the sensing coil SC may be disposed on a vertical-direction outer side of the heating coil WC. For example, in each of the coil modules 1001 and 1003, the sensing coil SC and the heating coil WC may be arranged in a vertical direction.

With respect to a horizontal direction, at least a portion of the sensing coil SC may be disposed in the second non-patterned region 1105. Accordingly, as the plurality of second non-patterned regions 1105 are disposed at equal intervals along the first direction, a plurality of sensing coils SC may be disposed at equal intervals along the first direction.

As described above, as the plurality of second non-patterned regions 1105 are disposed at equal intervals along the first direction, the plurality of sensing coils SC may be disposed at equal intervals along the first direction. According to the present embodiment, at least a portion of each sensing coil SC may be disposed in the second non-patterned region 1105. Therefore, when several second non-patterned regions 1105 are disposed at equal intervals along the first direction, a plurality of sensing coils SC may be disposed at equal intervals along the first direction.

According to the present embodiment, the temperature sensor TS may be disposed on an inner side of the sensing coil SC in a horizontal direction. With respect to the horizontal direction, at least a portion of the temperature sensor TS may be disposed in the second non-patterned region 1105.

For example, the temperature sensor TS may be disposed in the second non-patterned region 1105. That is, the temperature sensor TS installed on the second coil board part 1200 and the second non-patterned region 1105 formed on the first coil board part 1100 may be disposed to overlap each other in a vertical direction.

For this purpose, each sensing coil SC may be disposed at a position at which the entire temperature sensor TS can be disposed in the second non-patterned region 1105, that is, at a position at which the entire temperature sensor TS can overlap the second non-patterned region 1105 in the vertical direction.

Meanwhile, as shown in FIGS. 17 to 18 and FIGS. 22 to 23, each first coil portion 1120 may include a first terminal 1121 and a second terminal 1122. The first terminal 1121 and the second terminal 1122 are provided to connect a plurality of coil patterns Cp arranged in the horizontal direction, that is, a plurality of coil patterns Cp forming one first coil portion 1120.

With respect to the horizontal direction, the first terminal 1121 may be disposed outside the first non-patterned region 1103 and the second terminal 1122, and at least a portion of the second terminal 1122 may be disposed to be in contact with the first non-patterned region 1103. Accordingly, with respect to the horizontal direction, the second non-patterned region 1105 may be disposed between the first terminal 1121 and the second terminal 1122.

In addition, with respect to the second non-patterned region 1105, the first terminal 1121 may be disposed in an outer region of the first coil portion 1120 in the horizontal direction, and the second terminal 1122 may be disposed in an inner region of the first coil portion 1120 in the horizontal direction.

For example, the first terminal 1121 may be disposed at a outermost side of the first coil portion 1120 in the horizontal direction, and the second terminal 1122 may be disposed at a innermost side of the first coil portion 1120 in the horizontal direction. For example, the first terminal 1121 may be connected to a outermost end of the coil pattern Cp in the horizontal direction. Further, the second terminal 1122 may be connected to a innermost end of the coil pattern Cp in the horizontal direction.

Referring to FIGS. 6 and 20, the heating coil assembly 1000 according to the present embodiment may further include a connection 1020. The connection 1020 is provided to be connectable to at least one of the first terminal 1121 and the second terminal 1122. A detailed description of the connection 1020 will be described later.

[Arrangement structure of heating coils for each coil module]

As shown in FIG. 8, each of the coil modules 1001 and 1003 may include a plurality of heating coils WC arranged in the horizontal direction. For example, each of the coil modules 1001 and 1003 may include a plurality of heating coils WC arranged along the first direction and also arranged along the second direction. That is, each of the coil modules 1001 and 1003 may include a plurality of heating coils WC disposed in a matrix form.

In this case, each heating coil WC may be disposed to be spaced apart from another adjacent heating coil WC in the first direction by a predetermined distance in the first direction, and to be spaced apart from another adjacent heating coil WC in the second direction by a predetermined distance in the second direction.

According to the present embodiment, a length of each of the coil modules 1001 and 1003 in the first direction may be set to be shorter than a length of the coil modules 1001 and 1003 in the second direction. That is, each of the coil modules 1001 and 1003 may be formed in a rectangular shape, wherein a length in the second direction is longer than a length in the first direction.

In contrast, a length of each heating coil WC in the second direction may be set to be shorter than a length of the heating coil WC in the first direction. That is, each heating coil WC may be formed in a rectangular shape, wherein a length in the first direction is longer than a length in the second direction.

In each of the coil modules 1001 and 1003 including such heating coils WC, the number of heating coils WC disposed along the same straight line in the second direction is greater than the number of heating coils WC disposed along the same straight line in the first direction.

According to the present embodiment, the first coil module 1001 may include a plurality of heating coils WC arranged in an A-column by B-row configuration, and the second coil module 1003 may include a plurality of heating coils WC arranged in an A-column by C-row configuration. In the present embodiment, a column is defined as a line in the first direction, and a row is defined as a line in the second direction.

For example, relationships among A, B, and C may be defined as follows.

$A \geq 1$, $C \geq 2$, and $B>C$.

For example, in the first coil module 1001 and the second coil module 1003, one or more heating coils WC may be arranged in the first direction, and two or more heating coils WC may be arranged in the second direction. In addition, in the first coil module 1001, one or more heating coils WC may be arranged in the first direction, and three or more heating coils WC may be arranged in the second direction.

Accordingly, the number of heating coils WC disposed on the same straight line in the first direction in the first coil module 1001 and the number of heating coils WC disposed on the same straight line in the first direction in the second coil module 1003 may be set to be identical to each other. In addition, the number of heating coils WC disposed on the same straight line in the second direction in the second coil module 1003 may be set to be smaller than the number of heating coils WC disposed on the same straight line in the second direction in the first coil module 1001.

For example, when n first coil modules 1001 are disposed to be spaced apart along the first direction, n/2 second coil modules 1003 may be disposed between a pair of first coil modules 1001 disposed at an innermost side in the first direction.

In this case, each of the first coil modules 1001 may include 16/n heating coils WC arranged in a 4/n-column by 4-row configuration. Further, each of the second coil modules 1003 may include 12/n heating coils WC arranged in a 4/n-column by 3-row configuration.

For example, when two first coil modules 1001 are disposed to be spaced apart along the first direction, one second coil module 1003 may be disposed between a pair of first coil modules 1001 disposed at an innermost side in the first direction. In this case, each of the first coil modules 1001 may include eight heating coils WC arranged in a 2-column by 4-row configuration.

Further, each of the second coil modules 1003 may include six heating coils WC arranged in a 2-column by 3-row configuration. In this case, the heating coil assembly 1000 may include a total of twenty-two heating coils WC.

As described above, the cooktop 100 (see FIG. 3) is provided with a plurality of indicator lights L (see FIG. 3), and the indicator lights L may be implemented by a lighting module 180 (see FIG. 4). The lighting module 180 is disposed below the heating coil assembly 1000, and light emitted from the lighting module 180 may pass through the heating coil assembly 1000 to illuminate a light display area of the top plate 120.

In order to allow the light emitted from the lighting module 180 to pass to the light display area of the top plate 120, each of the coil modules 1001 and 1003 may be provided with a through-hole h. In each of the coil modules 1001 and 1003, the through-hole h may penetrate the coil module 1001 or 1003 in a vertical direction, and each through-hole h may be disposed between one column of heating coils WC and an adjacent column of heating coils WC.

If, as shown in FIG. 10, four first coil modules 1001a are disposed to be spaced apart along the first direction, two second coil modules 1003a may be disposed between a pair of first coil modules 1001a disposed at an innermost side in the first direction. In this case, each of the first coil modules 1001a may include four heating coils WC arranged in a 1-column by 4-row configuration.

When the heating coil assembly 1000a is provided in the form described above, spaces may be formed between respective columns of the heating coil assembly 1000a. Such spaces may be used as passages for allowing light emitted from the lighting module 180 to pass to the light display area of the top plate 120.

Accordingly, since each of the coil modules 1001a and 1003a is provided in a form including only one column of heating coils WC, it is unnecessary to separately form through-holes in the heating coil assembly 1000a.

In addition, considering that sizes of products, and sizes of a display or a control panel, may vary depending on models, the heating coil assembly 1000a provided in the above-described form may be more advantageous for mass production than the heating coil assembly shown in FIG. 8.

For example, according to the heating coil assembly 1000a provided in the above-described form, when producing multiple products having different sizes of displays or control panels, only a size of the second coil module 1003a may be changed according to the size of the display or the control panel, while the first coil module 1001a may be commonly used.

Further, according to the heating coil assembly 1000a provided in the above-described form, since repair or replacement may be performed for each coil module 1001a or 1003a on a one-column basis when necessary, maintenance may be facilitated and maintenance costs may be reduced.

Further, when each of the coil modules 1001a and 1003a is provided in a form including only one column of heating coils WC as described above, a surface area of each coil module 1001a or 1003a may be relatively increased as compared with a case in which each coil module includes two columns of heating coils WC, and air may flow through spaces between the coil modules 1001a and 1003a, thereby improving heat dissipation performance of the heating coil assembly 1000a.

In comparison, when two or more columns of heating coils WC are disposed in each of the coil modules 1001 and 1003 as shown in FIG. 8, the number of coil modules 1001 and 1003 to be assembled is reduced as compared with a case in which only one column of heating coils WC is disposed in each coil module, thereby providing an advantage in that assembly labor is reduced.

Further, when two or more columns of heating coils WC are disposed in each of the coil modules 1001 and 1003, a space required for forming wiring between two adjacent columns of heating coils WC may be easily secured in the coil modules 1001 and 1003, thereby providing an advantage in that wiring design may be performed easily and efficiently.

Further, each of the second coil modules 1003a may include three heating coils WC arranged in a 1-column by 3-row configuration. In this case as well, the heating coil assembly 1000a may include a total of twenty-two heating coils WC.

As a second example, as shown in FIG. 11, each of the first coil modules 1001b may include 12/n heating coils WC arranged in a 4/n-column by 3-row configuration. Further, each of the second coil modules 1003b may include 8/n heating coils WC arranged in a 4/n-column by 2-row configuration.

For example, when two first coil modules 1001b are disposed to be spaced apart along the first direction, one second coil module 1003b may be disposed between a pair of the first coil modules 1001b disposed at an innermost position in the first direction. In this case, each of the first coil modules 1001b may include six heating coils WC arranged in a 2-column by 3-row configuration.

Further, each of the second coil modules 1003b may include four heating coils WC arranged in a 2-column by 2-row configuration. In this case, the heating coil assembly 1000b may include a total of sixteen heating coils WC.

If, as shown in FIG. 12, four first coil modules 1001c are disposed to be spaced apart along the first direction, two second coil modules 1003c may be disposed between a pair of the first coil modules 1001c disposed at an innermost side in the first direction.

In this case, each of the first coil modules 1001c may include three heating coils WC arranged in a 1-column by 3-row configuration. Further, each of the second coil modules 1003c may include two heating coils WC arranged in a 1-column by 2-row configuration. In this case as well, the heating coil assembly 1000c may include a total of sixteen heating coils WC.

As a third example, as shown in FIG. 13, when two first coil modules 1001d are disposed to be spaced apart along the first direction, two second coil modules 1003d may be disposed between a pair of the first coil modules 1001d disposed at an innermost side in the first direction. In this case, each of the first coil modules 1001d may include ten heating coils WC arranged in a 2-column by 5-row configuration.

Further, each of the second coil modules 1003d may include six heating coils WC arranged in a 2-column by 3-row configuration. In this case, the heating coil assembly 1000d may include a total of thirty-two heating coils WC.

As a fourth example, as shown in FIG. 14, when four first coil modules 1001e are disposed to be spaced apart along the first direction, four second coil modules 1003e may be disposed between a pair of the first coil modules 1001e disposed at an innermost side in the first direction. In this case, each of the first coil modules 1001e may include five heating coils WC arranged in a 1-column by 5-row configuration.

Further, each of the second coil modules 1003e may include three heating coils WC arranged in a 1-column by 3-row configuration. In this case as well, the heating coil assembly 1000e may include a total of thirty-two heating coils WC.

As a fifth example, as shown in FIG. 15, when n first coil modules 1001f are disposed to be spaced apart along the first direction, each of the first coil modules 1001f may include 16/n heating coils WC arranged in a 4/n-column by 4-row configuration.

For example, when two first coil modules 1001f are disposed to be spaced apart along the first direction, each of the first coil modules 1001f may include eight heating coils WC arranged in a 2-column by 4-row configuration. In this case, the heating coil assembly 1000f may include a total of sixteen heating coils WC.

If, as shown in FIG. 16, four first coil modules 1001g are disposed to be spaced apart along the first direction, each of the first coil modules 1001g may include four heating coils WC arranged in a 1-column by 4-row configuration. In this case as well, the heating coil assembly 1000g may include a total of sixteen heating coils WC.

In the above-described examples, the heating coil assembly may include heating coils WC all having the same size and shape. Alternatively, the heating coil assembly may include various types of heating coils WC having different sizes and shapes.

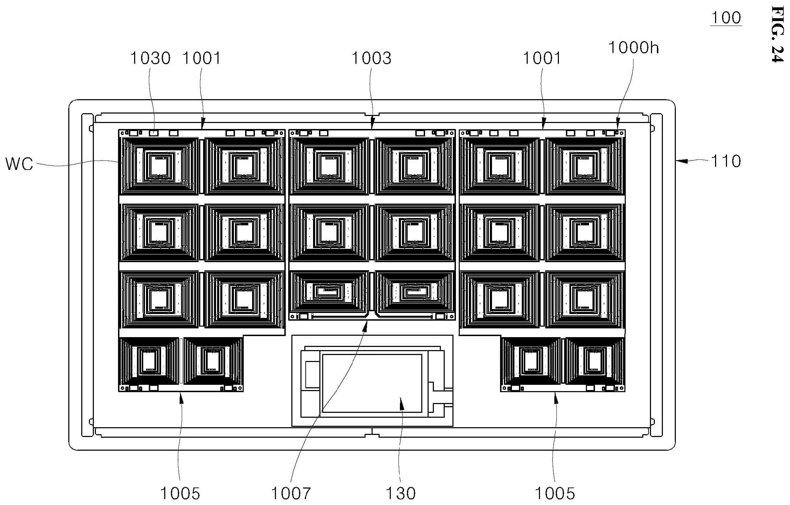

FIG. 24 is a plan view illustrating a seventh example of an arrangement structure of a first coil module and a second coil module.

As another example, a heating coil assembly 1000h as shown in FIG. 24 may further include at least one of a third coil module 1005 and a fourth coil module 1007. The first coil module 1001 and the third coil module 1005 are disposed on the same straight line in the second direction, and the second coil module 1003 and the fourth coil module 1007 may be disposed on the same straight line in the second direction.

Accordingly, with respect to the first direction, a pair of the first coil modules 1001 may be disposed to be spaced apart along the first direction with the second coil module 1003 and the fourth coil module 1007 interposed therebetween.

Further, with respect to the second direction, the first coil module 1001 may protrude further toward one side than the second coil module 1003, the third coil module 1005 may be disposed at a position further biased toward one side than the first coil module 1001, and the fourth coil module 1007 may be disposed at a position further biased toward one side than the second coil module 1003.

That is, the first coil module 1001 having a length in the second direction greater than that of the second coil module 1003 may protrude further forward than the second coil module 1003, the third coil module 1005 may be disposed at a position further biased forward than the first coil module 1001, and the fourth coil module 1007 may be disposed at a position biased forward relative to the second coil module 1003. It is of course that the third coil module 1005 is disposed at a position biased further forward than the fourth coil module 1007.

The third coil module 1005 and the fourth coil module 1007 may be formed to have a horizontal size smaller than that of the first coil module 1001 and the second coil module 1003. For this purpose, the third coil module 1005 may include heating coils having a horizontal size smaller than that of the heating coils provided in the first coil module 1001.

As described above, the cooktop control panel 130 may be disposed at a position biased further forward than the second coil module 1003, and a pair of the first coil modules 1001 may be disposed to be spaced apart along the first direction with the cooktop control panel 130 interposed therebetween. In addition, a pair of the third coil modules 1005 disposed on a forward side of the pair of first coil modules 1001 may also be disposed to be spaced apart along the first direction with the cooktop control panel 130 interposed therebetween.

With respect to the first direction, a length of the third coil module 1005 may be set to be shorter than a length of the first coil module 1001. Further, with respect to the second direction, the length of the third coil module 1005 may also be set to be shorter than the length of the first coil module 1001. That is, the third coil module 1005 may be formed such that both a length in the first direction and a length in the second direction are shorter than those of the first coil module 1001.

In addition, the fourth coil module 1007 may be disposed behind the cooktop control panel 130. With respect to the second direction, the fourth coil module 1007 may be disposed between the cooktop control panel 130 and the second coil module 1003, and a length of the fourth coil module 1007 may be formed to be shorter than a length of the second coil module 1003.

As the third coil module 1005 and the fourth coil module 1007 are disposed in the above-described manner, a size of an area in which the cooktop control panel 130 is to be disposed can be secured to be relatively wider. Accordingly, the cooktop control panel 130 can be spaced apart further from the coil modules 1001 and 1003 in the horizontal direction, so that the cooktop control panel 130 can be less affected by heat generated around the heating coils WC.

[Power supply-related configuration]

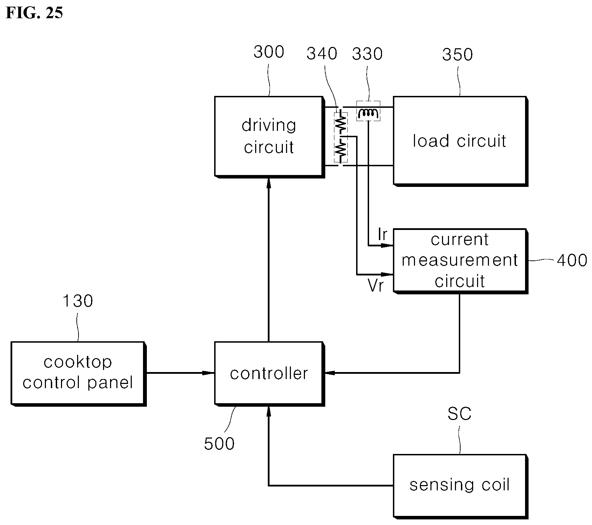

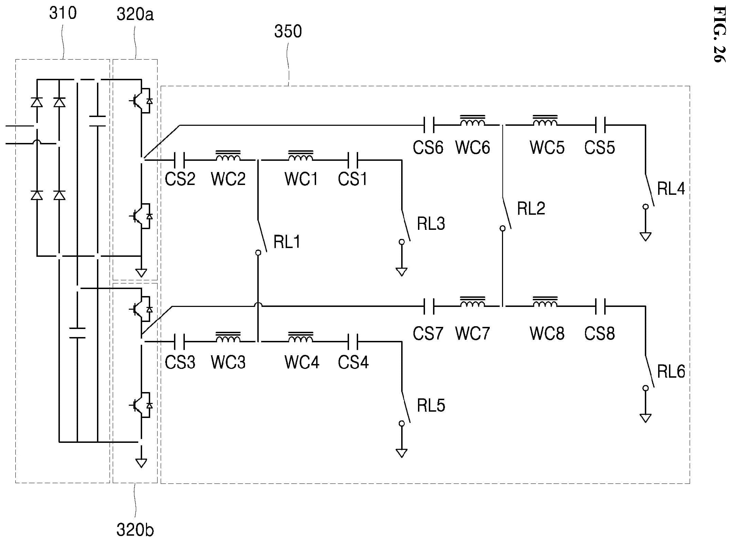

FIG. 25 is a configuration diagram schematically illustrating a power supply-related configuration of a cooking appliance according to an embodiment of the present disclosure, and FIG. 26 is a diagram illustrating an example of a driving circuit and a load circuit shown in FIG. 25.

Referring to FIGS. 2, 25 and 26, the cooking appliance according to the present embodiment may include a cooktop control panel 130, a load circuit 350, and a driving circuit 300.

According to the present embodiment, the cooktop control panel 130 may be provided with a user interface including various icons for adjusting operation of the cooktop 100 by touch and a display for indicating an operation state of the cooktop 100. A user may input a target heating intensity through the cooktop control panel 130.

The load circuit 350 may include at least one heating coil, at least one capacitor, and at least one relay. Here, the at least one heating coil, the at least one capacitor, and the at least one relay may be selectively connected in series or in parallel.

The driving circuit 300 may supply a driving current to the load circuit 350 through switching driving of an inverter circuit. The driving circuit 300 may include a current converter 330 and a resonant voltage generator 340.

The current converter 330 may generate a resonant current Ir obtained by converting current based on a driving current, and the resonant voltage generator 340 generate a resonant voltage Vr based on the current converter 330 and an alternating current voltage. The current converter 330 and the resonant voltage generator 340 may be provided inside the driving circuit 300 according to design.

In addition, the cooking appliance according to the present embodiment may further include a current measurement circuit 400. The current measurement circuit 400 may measure an input current applied to the load circuit 350 by using the resonant current Ir and the resonant voltage Vr, and measure an average input current by averaging the input current.

In addition, the cooking appliance according to the present embodiment may further include a sensing coil SC and a controller 500.

The sensing coil SC may detect presence of a heating target, and when the presence of the heating target is detected, provide a container detection signal to the controller 500. The sensing coil SC may store oscillation energy in the sensing coil SC or output a freely resonating oscillation signal under control of the controller 500. The sensing coil SC may filter a DC component from the oscillation signal, compare the filtered oscillation signal with a reference signal, and output a container detection signal to the controller 500 according to a result of the comparison.

The controller 500 may control the driving circuit 300 to drive the load circuit 350 at a target intensity received from the cooktop control panel 130. The controller 500 may control switching of switching elements of the driving circuit 300.

The controller 500 may measure power of the load circuit 350 based on an average input current received from the current measurement circuit 400, and determine a switching frequency such that a target heating intensity is maintained according to the power of the load circuit 350. The controller 500 may control switching driving of an inverter circuit of the driving circuit 300 based on the switching frequency.

The controller 500 may determine container information including at least one of a position, a material, a shape, and a size of a container based on a container detection signal received from the sensing coil SC. The controller 500 may control at least one relay in the load circuit 350 such that at least one heating coil corresponding to the position of the container is activated according to the position of the container.

In addition, the controller 500 may determine or vary a switching frequency for controlling switching driving of the inverter circuit of the driving circuit 300 according to at least one of the material, the shape, and the size of the container.

Referring to FIG. 25, a driving circuit according to an embodiment of the present disclosure may include a rectifier circuit 310 and inverter circuits 320a and 320b.

The inverter circuits 320a and 320b may include a first inverter circuit 320a and a second inverter circuit 320b. The first inverter circuit 320a may supply a first driving current to the load circuit 350 according to switching driving, and the second inverter circuit 320b may supply a second driving current to the load circuit 350 according to switching driving together with the first inverter circuit 320a.

The load circuit 350 may include at least one capacitor CS1, CS2, CS3, CS4, CS5, CS6, CS7, and CS8 connected in series or in parallel, at least one heating coil WC1, WC2, WC3, WC4, WC5, WC6, WC7, and WC8, and at least one relay RL1, RL2, RL3, RL4, RL5, and RL6.

In addition, the capacitors CS1, CS2, CS3, CS4, CS5, CS6, CS7, and CS8 may be used to filter a direct current component from a driving current. The heating coils WC1, WC2, WC3, WC4, WC5, WC6, WC7, and WC8 may be used to heat a cooking vessel by using electromagnetic induction.

The relays RL1, RL2, RL3, RL4, RL5, and RL6 may be used to selectively connect the heating coils WC1, WC2, WC3, WC4, WC5, WC6, WC7, and WC8 in series or in parallel. The heating coils WC1, WC2, WC3, WC4, WC5, WC6, WC7, and WC8 and the capacitors CS1, CS2, CS3, CS4, CS5, CS6, CS7, and CS8 may be used to determine a resonant frequency of the driving current.

The load circuit 350 may include a first capacitor CS1, a first heating coil WC1, a second heating coil WC2, a second capacitor CS2, and a first relay RL1. The first capacitor CS1 may transmit a first driving current supplied from the first inverter circuit 320a, the first heating coil WC1 may be connected in series with the first capacitor CS1, and the second heating coil WC2 may be connected in series with the first heating coil WC1. The second capacitor CS2 may be connected in series with the second heating coil WC2, and the first relay RL1 may switch between the second capacitor CS2 and a ground voltage terminal.

In addition, the load circuit 350 may further include a third capacitor CS3, a third heating coil WC3, a fourth heating coil WC4, a fourth capacitor CS4, and a second relay RL2.

The third capacitor CS3 may transmit a second driving current supplied from the second inverter circuit 320b, the third heating coil WC3 may be connected in series with the third capacitor CS3, and the fourth heating coil WC4 may be connected in series with the third heating coil WC3. The fourth capacitor CS4 may be connected in series with the fourth heating coil WC4, and the second relay RL2 may switch between the fourth capacitor CS4 and the ground voltage terminal.

In addition, the load circuit 350 may further include a third relay RL3. The third relay RL3 may switch between a node between the first heating coil WC1 and the second heating coil WC2 and a node between the third heating coil WC3 and the fourth heating coil WC4.

In addition, the load circuit 350 may further include a fifth capacitor CS5, a fifth heating coil WC5, a sixth heating coil WC6, a sixth capacitor CS6, and a fourth relay RL4.

The fifth capacitor CS5 may transmit the first driving current supplied from the first inverter circuit 320a, the fifth heating coil WC5 may be connected in series with the fifth capacitor CS5, and the sixth heating coil WC6 may be connected in series with the fifth heating coil WC5. The sixth capacitor CS6 may be connected in series with the sixth heating coil WC6, and the fourth relay RL4 may switch between the sixth capacitor CS6 and a ground voltage terminal.

In addition, the load circuit 350 may further include a seventh capacitor CS7, a seventh heating coil WC7, an eighth heating coil WC8, an eighth capacitor CS8, and a fifth relay RL5.

The seventh capacitor CS7 may transmit the second driving current supplied from the second inverter circuit 320b, the seventh heating coil WC7 may be connected in series with the seventh capacitor CS7, and the eighth heating coil WC8 may be connected in series with the seventh heating coil WC7. The eighth capacitor CS8 may be connected in series with the eighth heating coil WC8, and the fifth relay RL5 may switch between the eighth capacitor CS8 and a ground voltage terminal.

In addition, the load circuit 350 may further include a sixth relay RL6. The sixth relay RL6 may switch between a node between the fifth heating coil WC5 and the sixth heating coil WC6 and a node between the seventh heating coil WC7 and the eighth heating coil WC8.

[Stacking structure of coil board stack]

Referring to FIGS. 7 and 8, each of the coil modules 1001 and 1003 may be formed by a coil board stack 1010. The coil board stack 1010 may include a plurality of first coil board parts 1100 stacked in a vertical direction and at least one second coil board part 1200.

As shown in FIGS. 8 and 19, the first coil board part 1100 may be formed in a structure in which a core 1110 and first coil portions 1120 are stacked in the vertical direction. The second coil board part 1200 may be formed in a structure in which a core 1210 and second coil portions 1220 are stacked in the vertical direction. The core 1210 forms a framework of the second coil board part 1200 and may be formed of the same or similar material as the core 1110 of the first coil board part 1100.

For example, in the first coil board part 1100, the first coil portions 1120 may be disposed on both sides of the core 1110 in the vertical direction. For example, the first coil portions 1120 may be stacked on an upper surface and a lower surface of the core 1110, respectively.

In the second coil board part 1200, a first coil portion 1120 may be disposed on one side of the core 1210 in a vertical direction, that is, below the core 1210, and a second coil portion 1220 may be disposed on the other side of the core 1210 in the vertical direction, that is, above the core 1210. For example, the first coil portion 1120 may be stacked on a lower surface of the core 1210, and the second coil portion 1220 may be stacked on an upper surface of the core 1210.

As another example, in the second coil board part 1200, the second coil portions 1220 may be disposed on both sides of the core 1210 in the vertical direction.

In the present embodiment, the second coil board part 1200 is illustrated as including the first coil portion 1120 and the second coil portion 1220, wherein the first coil portion 1120 is disposed below the core 1210, and the second coil portion 1220 is disposed above the core 1210.

According to the present embodiment, the heating coil WC, more specifically, the coil board stack 1010, may include six or more layers of first coil portions 1120. That is, the coil board stack 1010 may include six or more first coil portions 1120 that are connected in the vertical direction and integrally coupled to each other.

In order for a sufficient amount of induction power for heating a heating target to be secured by the heating coil WC, an amount of conductors included in the heating coil WC needs to be sufficiently secured. There is a limitation in increasing a height of the coil pattern Cp in order to increase the amount of conductors included in the heating coil WC.

In consideration of this, increasing the number of coil patterns Cp for each layer forming the heating coil WC, and increasing the number of layers of the coil patterns Cp forming the heating coil WC, may be effective methods for increasing the amount of conductors included in the heating coil WC.

According to the present embodiment, three or more coil patterns Cp connected in parallel for each layer may be disposed along a diametric direction of the heating coil WC to form one coil line. Further, three or more coil lines formed in this manner may be stacked to overlap each other in the vertical direction to form the heating coil WC.

Considering a winding interval of the coil patterns Cp and other design conditions, there is a limitation in increasing the number of coil patterns Cp for each layer. For example, when the number of coil patterns Cp for each layer is increased, a size of each heating coil WC may increase, which may cause a problem in that the number of heating coils WC disposed in a cooking appliance needs to be reduced.

Further, when a width of the coil patterns Cp is reduced in order to increase the number of coil patterns Cp for each layer, a space required to secure intervals between the coil patterns Cp increases, and thus a problem may occur in that, despite the increase in the number of coil patterns Cp, an amount of conductors included in the heating coil WC is rather reduced.

In contrast, increasing the number of layers of the coil patterns Cp may be regarded as a method that causes relatively fewer problems. That is, as the number of layers of the coil patterns Cp increases, the amount of conductors included in the heating coil WC may also increase, and even when the number of layers of the coil patterns Cp increases, there is a low likelihood that the number of heating coils WC decreases or that the amount of conductors included in the heating coil WC decreases.

In consideration of this, in the present embodiment, since three or more coil patterns Cp are disposed for each layer, three layers of coil patterns Cp may also be disposed in the vertical direction to form three layers of coil lines. Further, considering that, as such three layers of coil lines (e.g., first coil lines) are disposed, three layers of coil lines having patterns different from those of the coil lines (e.g., second coil lines) need to be disposed, it is preferable that the coil board stack 1010 includes six or more layers of coil lines.

Further, according to design conditions, by stacking the coil lines in eight or more layers, the amount of conductors included in the heating coil WC may be more effectively increased. In the present embodiment, it is illustrated that eight to twelve layers of first coil portions 1120 are stacked in the vertical direction. However, the present disclosure is not limited thereto, and the first coil portions 1120 may also be stacked in the number of layers exceeding twelve.

For example, as the number of layers of the first coil portions 1120 increases, the coil modules 1001 and 1003 may be designed such that a thickness of each layer of the first coil portions 1120 decreases, and accordingly, despite the increase in the number of layers of the first coil portions 1120, an increase in an overall thickness of the coil modules 1001 and 1003 may be suppressed to an appropriate level.

Further, the coil board stack 1010 may include at least one layer of second coil portions 1220. For example, the coil board stack 1010 may include eight to twelve layers of first coil portions 1120 and one to two layers of second coil portions 1220, which are connected and integrally coupled in the vertical direction.

Further, the coil board stack 1010 may further include insulating layers stacked in the vertical direction together with the first coil portions 1120. In each coil board stack 1010, the coil portions 1120 and 1220 and the insulating layers may be alternately disposed in the vertical direction.

In the first coil board part 1100, the insulating layer may be formed by the core 1110. Also, in the second coil board part 1200, the insulating layer may be formed by the core 1210.

Further, the insulating layer may also be disposed between the coil board parts 1100 and 1200. For example, an insulating layer may be disposed between a pair of first coil board parts 1100 adjacent to each other in the vertical direction, and an insulating layer may also be disposed between the first coil board part 1100 and the second coil board part 1200. Further, an insulating layer may also be disposed between a pair of second coil board parts 1200 adjacent to each other in the vertical direction.

As an example, the insulating layer disposed between the coil board parts 1100 and 1200 as described above may be formed by an adhesive material 1400. According to the present embodiment, a plurality of first coil board parts 1100 stacked in the vertical direction may be coupled to each other by an adhesive material 1400, and the first coil board parts 1100 and the second coil board parts 1200 may also be coupled to each other by the adhesive material 1400. Further, a plurality of second coil board parts 1200 stacked in the vertical direction may also be coupled to each other by the adhesive material 1400.

Accordingly, insulating layers may be formed by cores 1110 and 1210 respectively provided in the first coil board parts and the second coil board parts 1100 and 1200 (hereinafter, referred to as "coil board parts"), and insulating layers may also be formed by the adhesive materials 1400 disposed between the coil board parts 1100 and 1200.

The cores 1110 and 1210 may be disposed between a pair of first coil portions 1120 facing each other in the vertical direction, between a pair of second coil portions 1220 facing each other in the vertical direction, or between a first coil portion 1120 and a second coil portion 1220, thereby forming insulating layers therebetween. That is, the cores 1110 and 1210 may form insulating layers inside the first coil board parts 1100 or inside the second coil board parts 1200.

Further, the adhesive material 1400 may be disposed between a pair of first coil portions 1120 facing each other in the vertical direction, between a pair of second coil portions 1220 facing each other in the vertical direction, or between a first coil portion 1120 and a second coil portion 1220 facing each other in the vertical direction, thereby forming insulating layers therebetween. That is, the adhesive material 1400 may form insulating layers outside the first coil board parts 1100 or the second coil board parts 1200.

Accordingly, either one of the first coil portion and the second coil portion 1120 and 1220 (hereinafter, referred to as a "coil portion") and insulating layers may be alternately disposed in the vertical direction. That is, the first coil portions 1120 and insulating layers may be alternately disposed in the vertical direction, and the second coil portions 1220 and insulating layers may also be alternately disposed.

Further, among a plurality of insulating layers arranged in the vertical direction, the cores 1110 and 1210 and the adhesive materials 1400 may be alternately disposed in the vertical direction. For example, the coil portions 1120 and 1220 and insulating layers may be stacked in the vertical direction in an order of "◎first coil portion 1120 - core 1110 - first coil portion 1120 - adhesive material 1400 - first coil portion 1120◎".

In the present embodiment, the coil board parts 1100 and 1200 are illustrated as being formed by copper clad laminates including the cores 1110 and 1210 and foils, respectively. Accordingly, the cores 1110 and 1210 may be formed of thermoset prepreg.

For example, the cores 1110 and 1210 may be formed of FR4 prepreg, and the coil portions 1120 and 1220 may be formed as results of foils provided on the cores 1110 and 1210 being patterned into coil shapes. Adjustment of a thickness of the first coil board part 1100 or the second coil board part 1200 may be achieved by changing a thickness of the core 1110 or by changing a thickness of the first coil portion 1120 or the second coil portion 1220.

Further, the adhesive material 1400 may be formed of a prepreg material. For example, each adhesive material 1400 may include a plurality of prepreg films stacked in the vertical direction. Adjustment of a thickness of the adhesive material 1400 may be achieved by changing the number of the prepreg films stacked in the vertical direction.

The thickness of the adhesive material 1400 may be set to be greater than a thickness of the cores 1110 and 1210. According to the present embodiment, both the cores 1110 and 1210 and the adhesive material 1400 are formed of prepreg, but the cores 1110 and 1210 are formed of thermoset prepreg, whereas the adhesive material 1400 is formed of non-thermoset prepreg. In consideration of the above, in the present embodiment, the adhesive material 1400 is formed to be thicker than the cores 1110 and 1210, so that strength of the adhesive material 1400 is maintained at a level similar to strength of the cores 1110 and 1210, and strength of the coil modules 1001 and 1003 can be enhanced.

Further, a thickness of the adhesive material 1400 may be set to be greater than a thickness of the coil portions 1120 and 1220. For example, the thickness of the adhesive material 1400 may be set to be at least twice the thickness of the coil portions 1120 and 1220. The adhesive material 1400 formed in this manner may contribute to enhancing strength of the coil portions 1120 and 1220 disposed on both upper and lower sides of the adhesive material 1400 in the vertical direction.

Meanwhile, the heating coil assembly 1000 of the present embodiment may further include outer layer parts 1300 and 1350. The outer layer parts 1300 and 1350 may be disposed on outer sides of the coil board stack 1010 in the vertical direction. For example, the outer layer parts 1300 and 1350 may be disposed on an upper side and a lower side of the coil board stack 1010, respectively, and a pair of the outer layer parts 1300 and 1350 disposed in this manner may be stacked together with the coil board stack 1010 in the vertical direction. The pair of the outer layer parts 1300 and 1350 stacked together with the coil board stack 1010 in the vertical direction may form an upper end and a lower end of the coil modules 1001 and 1003.

The outer layer parts 1300 and 1350 may be divided into a first outer layer part 1300 and a second outer layer part 1350. The first outer layer part 1300 may include, similarly to the first coil portions 1120, a plurality of first coil portions 1120 arranged in a horizontal direction. Further, the second outer layer part 1350 may include, similarly to the second coil portions 1220, a plurality of second coil portions 1220 arranged in a horizontal direction.

The first outer layer part 1300 may form a heating coil WC together with a plurality of first coil portions 1120 stacked in the vertical direction. Further, the second outer layer part 1350 may form a heating coil WC together with the second coil portions 1220. That is, the first outer layer part 1300 may be connected to the first coil portions 1120 in the vertical direction, and the second outer layer part 1350 may be connected to the second coil portions 1220 in the vertical direction.

The first outer layer part 1300 may be disposed at a position adjacent to the first coil board part 1100. For example, the first outer layer part 1300 may be disposed below the first coil board part 1100 and may be connected to the first coil portions 1120 in the vertical direction. The first outer layer part 1300 configured as described above may form a heating coil WC together with the first coil portions 1120.

The second outer layer part 1350 may be disposed at a position adjacent to the second coil board part 1200. For example, the second outer layer part 1350 may be disposed above the second coil board part 1200 and may be connected to the second coil portions 1220 in the vertical direction. The second outer layer part 1350 configured as described above may form a sensing coil SC together with the second coil portions 1220.

For example, the coil board stack 1010 may be formed in a structure in which a second coil portion 1220 is stacked above a plurality of first coil portions 1120. The coil board stack 1010 may be disposed between a first outer layer part 1300 and a second outer layer part 1350 that are spaced apart from each other in a vertical direction.

In this case, the first outer layer part 1300 disposed below the first coil board part 1100 may form a lower end of the coil modules 1001 and 1003 and may form a heating coil WC together with the first coil portions 1120. Further, the second outer layer part 1350 disposed above the second coil board part 1200 may form an upper end of the coil modules 1001 and 1003 and may form a sensing coil SC together with the second coil portions 1220.

According to the present embodiment, in each of the coil board parts 1100 and 1200, a pair of coil portions 1120 and 1220 may be disposed in a vertical direction. That is, two layers of coil portions 1120 and 1220 may be formed in each of the coil board parts 1100 and 1200. The coil board stack 1010 formed by stacking a plurality of coil board parts 1100 and 1200 may include a plurality of layers of coil portions 1120 and 1220, and may include an even number of layers of the coil portions 1120 and 1220.

Further, outer layer parts 1300 and 1350 may each be coupled to both sides of the coil board stack 1010 in a vertical direction as formed above, and accordingly, in each of the coil modules 1001 and 1003, a plurality of layers of coil portions 1120 and 1220 may be disposed, and an even number of layers of the coil portions 1120 and 1220 may be disposed.

The outer layer parts 1300 and 1350 may be coupled to the coil board stack 1010 by an adhesive material 1400 disposed between the coil portions 1120 and 1220 and the outer layer parts 1300 and 1350. The adhesive material 1400 may form an insulating layer between the coil portions 1120 and 1220 and the outer layer parts 1300 and 1350, and may couple the coil board stack 1010 and the outer layer parts 1300 and 1350.

For example, an adhesive material 1400 disposed between the first outer layer part 1300 disposed at a lower end of the coil modules 1001 and 1003 and the first coil board part 1100 may form an insulating layer between the first coil portion 1120 provided in the first coil board part 1100 and the first coil portion 1120 provided in the first outer layer part 1300, and may couple the first coil board part 1100 and the first outer layer part 1300.

Further, an adhesive material 1400 disposed between the second outer layer part 1350 disposed at an upper end of the coil modules 1001 and 1003 and the second coil board part 1200 may form an insulating layer between the second coil portion 1220 provided in the second coil board part 1200 and the second coil portion 1220 provided in the second outer layer part 1350, and may couple the first coil board part 1100 and the outer layer parts 1300 and 1350.

In the present embodiment, a structure in which the coil board stack 1010 and the heating coil WC and the sensing coil SC are formed by stacking units such as the coil board parts 1100 and 1200 and the coil portions 1120 and 1220 is exemplified; however, the present disclosure is not limited thereto.

As another example, without a separate board, the heating coil WC and the coil modules 1001 and 1003 may be formed in a structure in which conductors of respective layers are sequentially stacked from a lowermost layer. In this case, the coil modules 1001 and 1003 may be formed in a structure in which conductors for forming the heating coil WC and the adhesive material 1400 are alternately stacked in a vertical direction.

Further, although it has been described above that the coil modules 1001 and 1003 are formed in a stacked structure of respective components constituting the coil modules 1001 and 1003, such as the coil board parts 1100 and 1200, the coil portions 1120 and 1220, and conductors, the coil modules 1001 and 1003 are formed in an integrated structure in which the respective components constituting the coil modules 1001 and 1003 are integrated.

That is, the coil modules 1001 and 1003 according to the present embodiment are formed as an integral structure, and unless a separate process such as cutting or chemical treatment is performed, the respective components constituting the coil modules 1001 and 1003 are not separated from one another.

[Shape of heating coil]

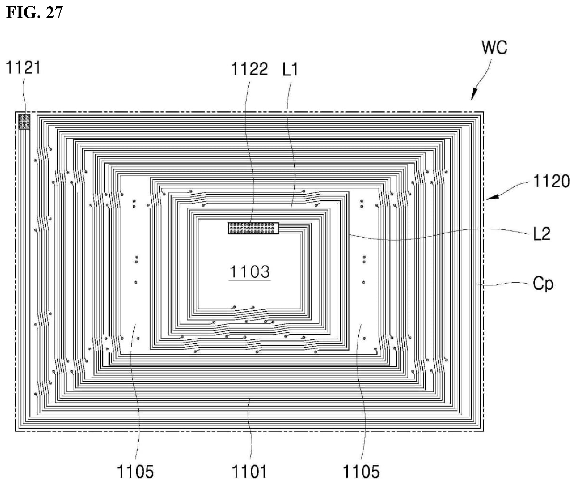

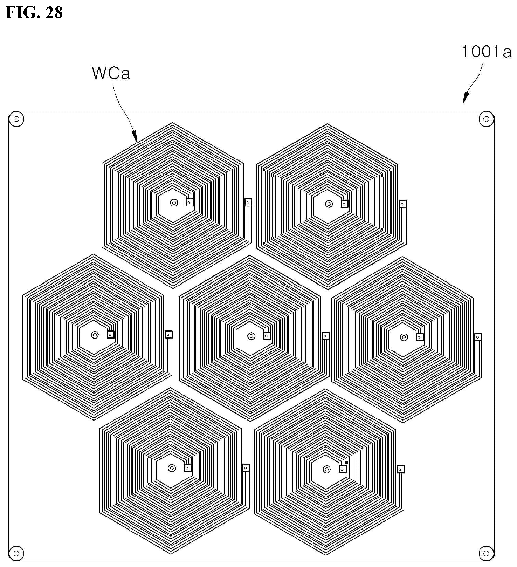

FIG. 27 is a plan view illustrating an example of a heating coil, and FIG. 28 is a plan view illustrating another example of a heating coil.

Referring to FIGS. 17 and 27, the heating coil WC may be formed to have a shape including a polygonal shape. For example, an outer shape of the heating coil WC in a horizontal direction may be a polygonal shape. In other words, when viewed from above, the heating coil WC may have a polygonal shape.

As an example, the outer shape of the heating coil WC may be substantially rectangular. Further, an outer shape of the coil modules 1001 and 1003 including the heating coil WC may also be a polygonal shape. Further, the heating coil WC may be formed by a pattern coil patterned on an insulating layer. For example, the heating coil WC may be formed not by a Litz coil wound in a substantially circular shape, but by a pattern coil patterned on an insulating layer.

As the heating coil WC is formed in such a pattern shape, the outer shape of the heating coil WC may be easily formed as a polygonal shape, more specifically, as a substantially rectangular shape.

Further, since the outer shape of the heating coil WC is formed in this manner, the heating coil WC may occupy an area up to a region very close to an edge of the coil modules 1001 and 1003, and thus a density of an area occupied by the heating coil WC within the coil modules 1001 and 1003 may be effectively increased.

Further, a horizontal outer shape of each first coil board part 1100 provided for each heating coil WC (hereinafter, referred to as an "outer shape of the first coil board part") may be a polygonal shape. For example, the outer shape of the first coil board part 1100 may be substantially rectangular.

In addition, a horizontal outer shape of a core 1110 forming a framework of each first coil board part 1100 (hereinafter, referred to as a "core outer shape") may be a polygonal shape, similarly to shapes of the coil modules 1001 and 1003 and the first coil board part 1100.

For example, the heating coil WC may be formed in a rectangular spiral shape. For example, the heating coil WC may be formed in a rectangular spiral shape in which a first straight line L1 extending in a first direction and a second straight line L2 extending in a second direction are alternately connected to each other. In addition, the outer shape of the core 1110 of the first coil board part 1100 forming the heating coil WC may be formed in a rectangular shape similar to an outer shape of the heating coil WC.

Accordingly, at least one of a plurality of outer sides of the heating coil WC may include a straight line parallel to one of a plurality of outer sides of the core 1110 that is closest thereto. For example, the first straight line L1 disposed at a foremost side of the heating coil WC may be formed as a straight line parallel to a front-side outer side of the core 1110, and the second straight line L2 disposed at a rightmost side of the heating coil WC may be formed as a straight line parallel to a right-side outer side of the core 1110.

As the outer shape of the core 1110 and the outer shape of the heating coil WC are formed in the above-described manner, the heating coil WC may occupy an area very close to an edge of the coil modules 1001 and 1003, and thus a density of an area occupied by the heating coil WC within the coil modules 1001 and 1003 may be effectively increased.

In addition, according to the present embodiment, each of the coil modules 1001 and 1003 may include a plurality of heating coils WC. That is, each of the coil modules 1001 and 1003 may include an assembly of a plurality of heating coils WC arranged in a horizontal direction. For example, each of the coil modules 1001 and 1003 may be provided with an assembly of heating coils WC including eight heating coils WC arranged in a 2-column by 4-row configuration along the horizontal direction.

According to the present embodiment, an outer shape of an assembly of the heating coils WC may be a polygonal shape. That is, both an outer shape of each of the coil modules 1001 and 1003 and an outer shape of an assembly of the heating coils WC provided in the coil modules 1001 and 1003 may be polygonal shapes.

For example, the outer shape of the assembly of the heating coils WC may be disposed in a rectangular shape. That is, a plurality of heating coils WC provided in each of the coil modules 1001 and 1003 may be disposed in a rectangular shape.

As another example, as illustrated in FIG. 28, an outer shape of a heating coil WCa may be a hexagonal shape. For example, the heating coil WCa may be formed in a hexagonal spiral shape. Accordingly, a plurality of heating coils WCa may be disposed in a honeycomb shape in the coil module 1001a.

As the plurality of heating coils WCa each formed in the hexagonal spiral shape are disposed in the honeycomb shape, centers of all the heating coils WCa provided in the coil module 1001a may maintain an identical interval. For example, all the heating coils WCa provided in the coil module 1001a may be disposed such that center-to-center distances from adjacent heating coils WCa are maintained at a designated value.

The heating coils WCa provided in the above-described manner may provide an advantage in that, by making all center-to-center distances between adjacent heating coils WCa identical, structural design of the heating coil assembly 1000 for allowing the heating coils WCa to perform both a function of detecting presence of a heating target and a function of heating the heating target may be facilitated.

As another example, an outer shape of the heating coil may be a circular shape or an elliptical shape. For example, the heating coil may be formed in a spiral shape similar to a circular shape or an elliptical shape. Even in this case, disposement of the coil modules may be performed such that centers of all the heating coils provided in the coil modules maintain an identical interval.

[Structure of first vertical connection part]

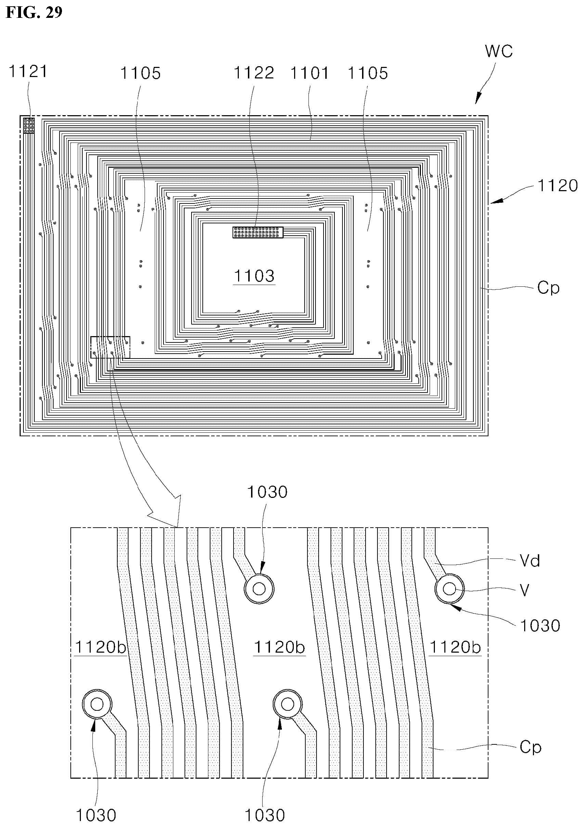

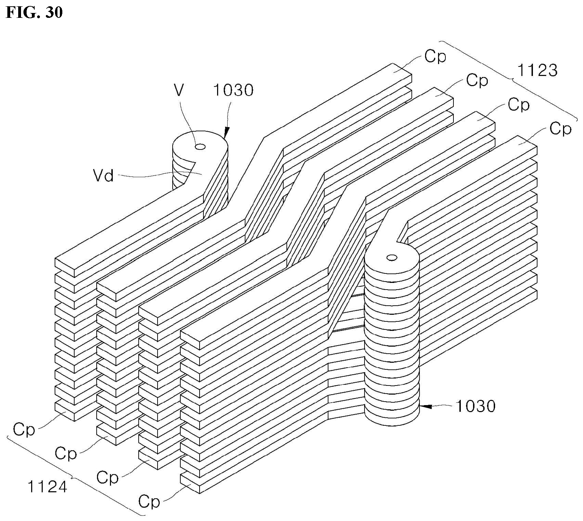

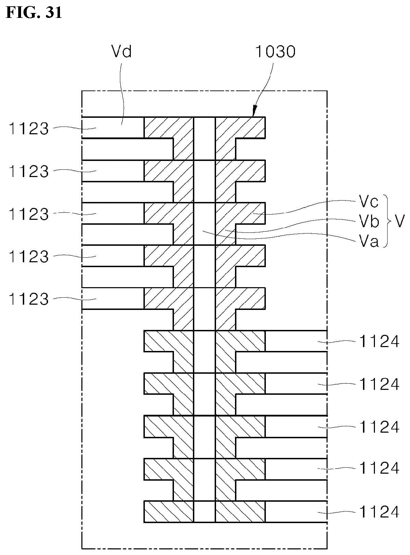

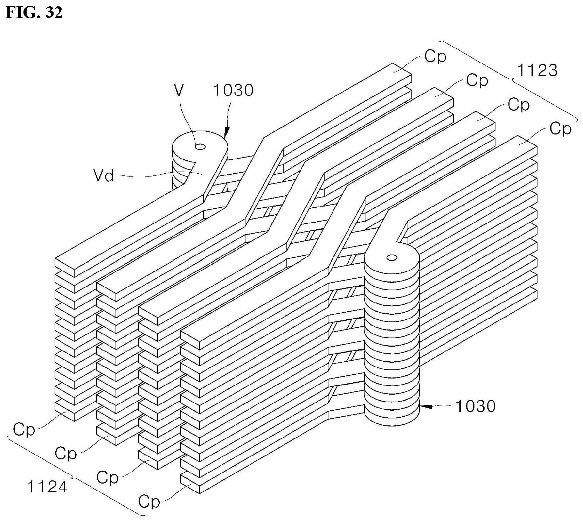

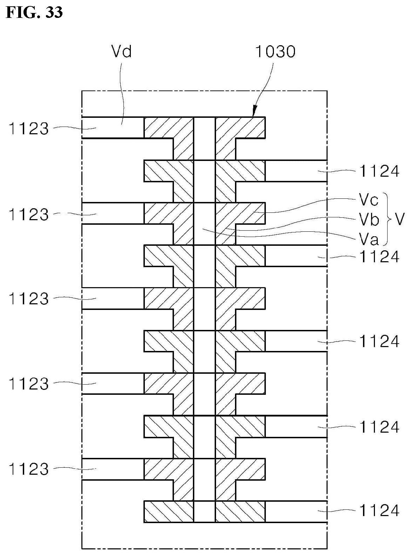

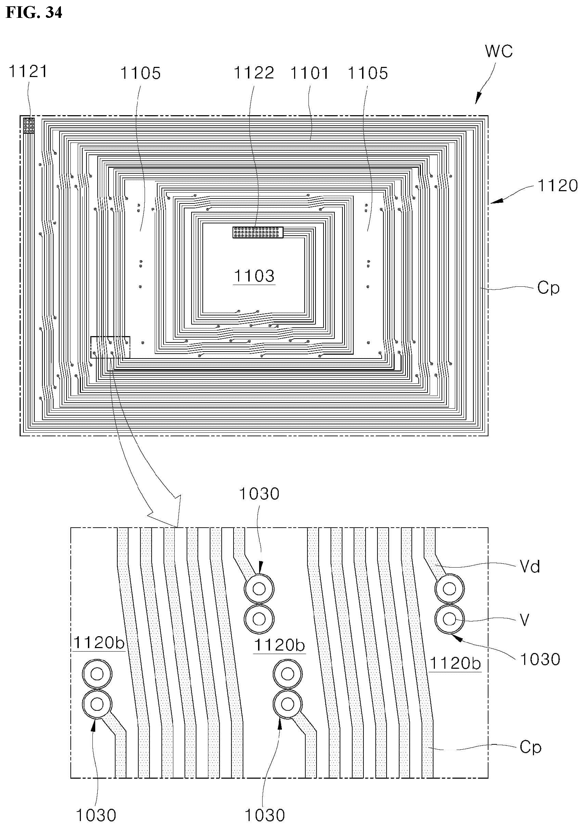

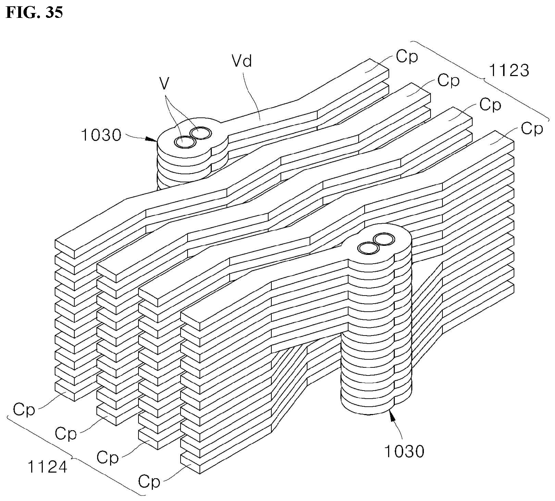

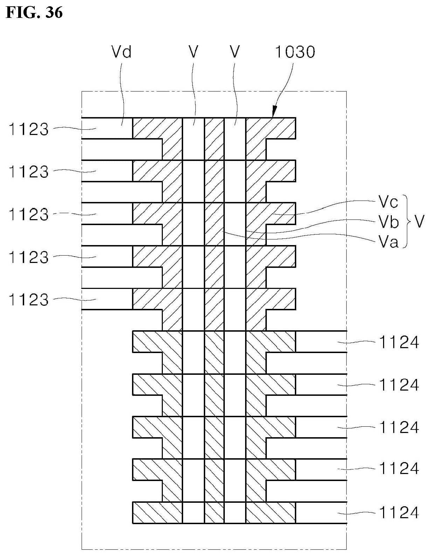

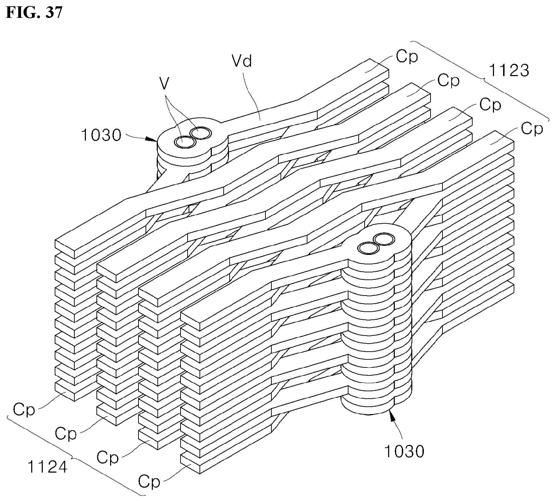

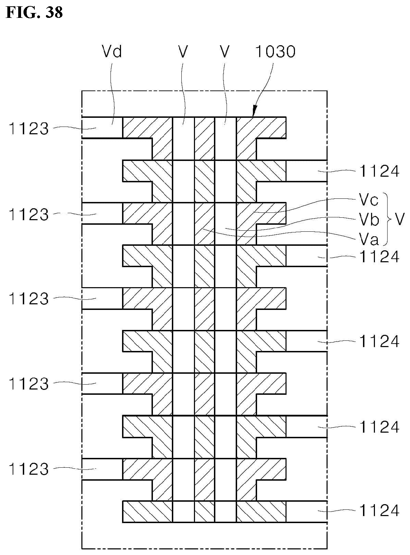

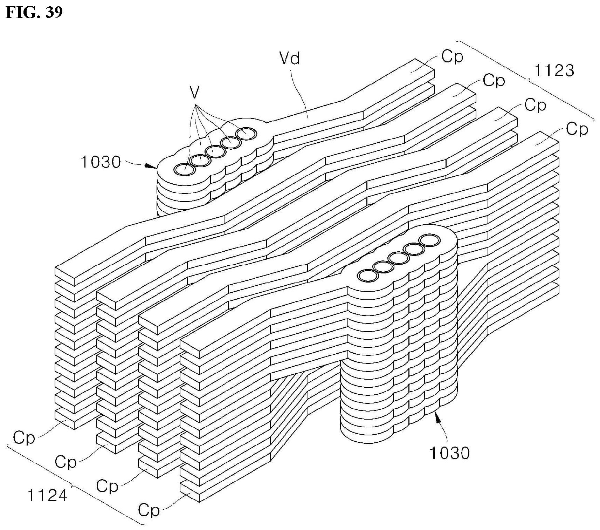

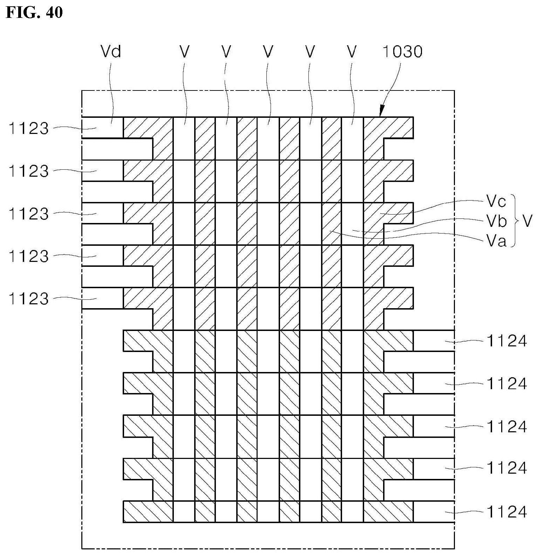

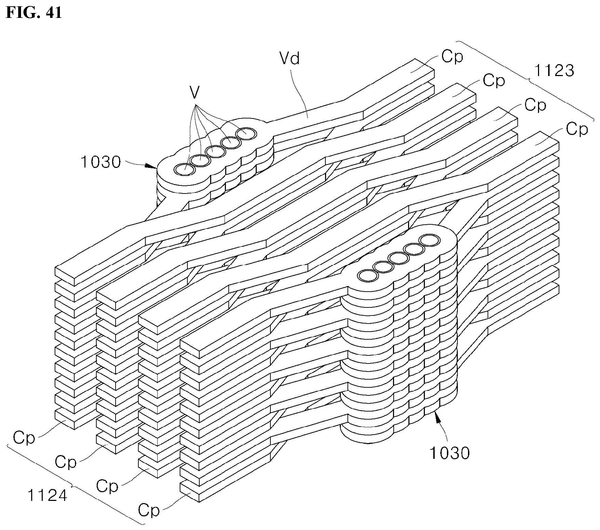

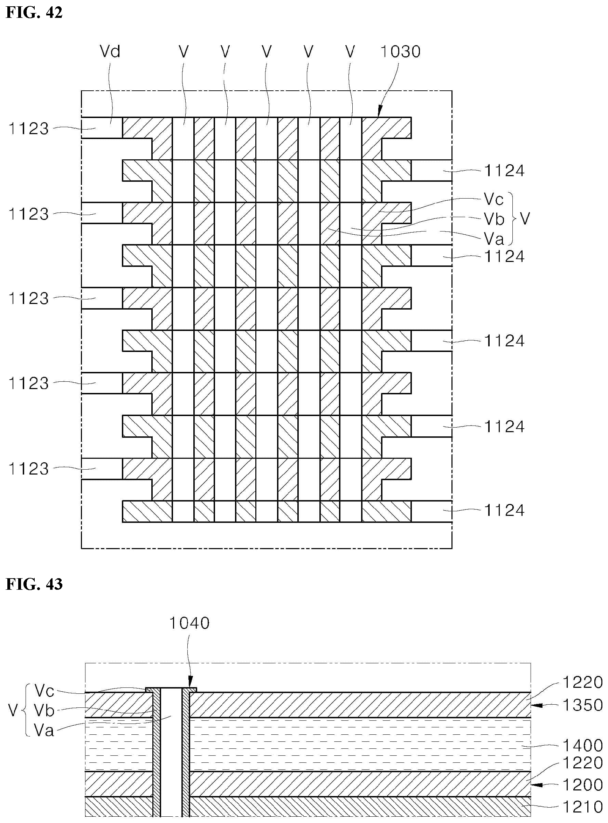

FIG. 29 is an enlarged view illustrating an enlarged first coil portion, FIG. 30 is a diagram illustrating an example of a coil pattern stack and a first vertical connection part, and FIG. 31 is a cross-sectional view illustrating a structure of the coil pattern stack and the first vertical connection part illustrated in FIG. 30. FIG. 32 is a diagram illustrating another example of a coil pattern stack and a first vertical connection part, FIG. 33 is a cross-sectional view illustrating a structure of the coil pattern stack and the first vertical connection part illustrated in FIG. 32, and FIG. 34 is a diagram illustrating another example of the first vertical connection part. FIG. 35 is a diagram illustrating an example of a connection structure between the coil pattern stack and the first vertical connection part illustrated in FIG. 34, and FIG. 36 is a cross-sectional view illustrating a structure of the coil pattern stack and the first vertical connection part illustrated in FIG. 35. FIG. 37 is a diagram illustrating another example of a connection structure between the coil pattern stack and the first vertical connection part illustrated in FIG. 34, and FIG. 38 is a cross-sectional view illustrating a structure of the coil pattern stack and the first vertical connection part illustrated in FIG. 37. FIG. 39 is a diagram illustrating still another example of a connection structure between the coil pattern stack and the first vertical connection part, and FIG. 40 is a cross-sectional view illustrating a structure of the coil pattern stack and the first vertical connection part illustrated in FIG. 39. FIG. 41 is a diagram illustrating still another example of a connection structure between the coil pattern stack and the first vertical connection part, and FIG. 42 is a cross-sectional view illustrating a structure of the coil pattern stack and the first vertical connection part illustrated in FIG. 41.

Referring to FIGS. 6, 17, and 29, the heating coil assembly 1000 according to the present embodiment may further include a first vertical connection part 1030. The first vertical connection part 1030 is provided to vertically connect a plurality of first coil portions 1120 stacked in a vertical direction in each coil board stack 1010.

Each first vertical connection part 1030 penetrates a plurality of first coil board parts 1100 in the vertical direction and is capable of vertically connecting a plurality of first coil portions 1120 arranged on the same straight line in the vertical direction. Each heating coil WC may be formed as a result of a plurality of first coil portions 1120 arranged on the same straight line in the vertical direction being vertically connected by the first vertical connection part 1030.

Each first vertical connection part 1030 may include vias V, respectively. Each via V may vertically connect, one by one for each first coil portion 1120, a plurality of coil patterns Cp stacked in the vertical direction.

For example, each via V may be connected to one coil pattern Cp in each first coil board part 1100 and may vertically connect the plurality of coil patterns Cp stacked in the vertical direction. In addition, in each first coil portion 1120, each via V may be connected to the coil pattern Cp in a horizontal direction.

As an example, the first coil portion 1120 may be formed in a rectangular spiral shape. For example, the first coil portion 1120 may be formed in a rectangular spiral shape in which a first straight line L1 extending in the first direction and a second straight line L2 extending in the second direction are alternately connected.

According to the present embodiment, in each first coil portion 1120, a region in which coil patterns Cp are disposed may be divided into a plurality of divided regions 1120a. The plurality of divided regions 1120a may be arranged along a diametrical direction of a spiral formed by the first coil portion 1120 (hereinafter, referred to as a "diametrical direction").

For example, when a cross section of each first coil portion 1120 in an vertical direction is viewed, the plurality of divided regions 1120a may be arranged along a horizontal direction. As an example, when the first coil portion 1120 includes six coil patterns Cp, each divided region 1120a may include six coil patterns Cp arranged along the diametrical direction.

In FIG. 29, a form in which the first coil portion 1120 includes six coil patterns Cp is exemplarily illustrated; however, the present disclosure is not limited thereto. As another example, the first coil portion 1120 may include four coil patterns Cp, and accordingly, each divided region 1120a may include four coil patterns Cp arranged along the diametrical direction (see FIG. 34). As still another example, the first coil portion 1120 may include three coil patterns Cp, and accordingly, each divided region 1120a may include three coil patterns Cp arranged along the diametrical direction.

As described above, the first coil portion 1120 including the plurality of divided regions 1120a may further include a separation region 1120b in which the coil patterns Cp are not disposed. According to the present embodiment, the plurality of divided regions 1120a provided in the first coil portion 1120 may be disposed to be spaced apart from each other by a predetermined interval along the diametrical direction. The separation region 1120b may be disposed in a gap between the plurality of divided regions 1120a. That is, in each first coil portion 1120, the divided regions 1120a and the separation regions 1120b may be alternately disposed in the diametrical direction.

For example, when a vertical cross-section of each first coil portion 1120 is viewed, a plurality of divided regions 1120a and separation regions 1120b may be arranged along a horizontal direction, and the divided regions 1120a and the separation regions 1120b may be alternately disposed in the horizontal direction.

The first vertical connection part 1030 may be disposed in the separation region 1120b. That is, the first vertical connection part 1030 may be disposed in gaps between the plurality of divided regions 1120a, and may include at least one via V disposed in the separation region 1120b.

According to the present embodiment, a set of a plurality of coil patterns Cp arranged in the diametrical direction forms one coil line 1123 or 1124, and the coil line 1123 or 1124 may be wound a plurality of times to form one first coil portion 1120. That is, in each coil line 1123 or 1124, a plurality of coil patterns Cp may be arranged in the diametrical direction, and each coil pattern Cp may extend along a circumferential direction of a spiral formed by the first coil portion 1120 (hereinafter, referred to as a "circumferential direction").

As described above, the plurality of coil patterns Cp forming the coil lines 1123 and 1124 may form a twisted structure within the heating coil WC. For example, as shown in FIG. 30, each coil pattern Cp may extend along the circumferential direction and may extend in a direction between the circumferential direction and the diametrical direction. That is, each coil pattern Cp forming the coil lines 1123 and 1124 may extend along the circumferential direction while forming an oblique line inclined in the diametrical direction.

For example, at one position of the coil line 1123 or 1124 in the circumferential direction, one coil pattern Cp disposed at an outermost position of the coil line 1123 or 1124 in the diametrical direction may be disposed at a central position of the coil line 1123 or 1124 in the diametrical direction at another position in the circumferential direction, and may be disposed at an innermost position of the coil line 1123 or 1124 in the diametrical direction at still another position in the circumferential direction.

That is, each of the coil lines 1123 and 1124 forming the first coil portion 1120 may form a horizontal twisting structure within the first coil portion 1120 by varying diameter-direction positions of the coil patterns Cp within the coil line 1123 or 1124.

In the present embodiment, the coil lines 1123 and 1124 are exemplarily divided into a first coil line 1123 and a second coil line 1124. In the first coil line 1123, each coil pattern Cp may extend along the circumferential direction while forming an oblique line inclined toward a centripetal direction. In the second coil line 1124, each coil pattern Cp may extend along the circumferential direction while forming an oblique line inclined toward a centrifugal direction.

According to the present embodiment, the first coil line 1123 and the second coil line 1124 stacked in an vertical direction may be connected in the vertical direction to form the heating coil WC, and the first vertical connection part 1030 may connect the first coil line 1123 and the second coil line 1124 stacked in the vertical direction in the vertical direction.

Each first vertical connection part 1030 may be connected to one coil pattern Cp per each coil line 1123 or 1124, and may connect a plurality of coil patterns Cp stacked in the vertical direction in the vertical direction. In addition, each coil pattern Cp may be connected to a plurality of first vertical connection parts 1030 arranged along the circumferential direction. That is, each coil pattern Cp may be vertically connected to another coil pattern Cp disposed above or below the coil pattern Cp at a plurality of positions in the circumferential direction.

Accordingly, connections between the first coil line 1123 and the second coil line 1124 are made in such a manner that coil patterns Cp of the first coil line 1123 and coil patterns Cp of the second coil line 1124 are alternately connected to each other. That is, the first coil line 1123 and the second coil line 1124 stacked in the vertical direction may form a vertical twisted structure within the heating coil WC in such a manner that the first coil line 1123 and the second coil line 1124 are alternately connected to each other.

Accordingly, each coil line 1123 or 1124 forming the first coil portion 1120 may form a horizontal twisted structure within the first coil portion 1120, and the first coil line 1123 and the second coil line 1124 stacked in an vertical direction may form a vertical twisted structure, such that a plurality of coil patterns Cp forming the heating coil WC may form a braided twisted structure.

The twisted structure of the heating coil WC formed in this manner not only allows a length of a connected body formed as a result of connecting a plurality of coil patterns Cp to form the heating coil WC to be increased, but also provides an advantage in that positions of the respective coil patterns Cp are prevented from being biased only toward an innermost side or an outermost side within each heating coil WC.

Meanwhile, referring to FIGS. 29 to 31, each via V may include a hole part Va, an inner wall part Vb, and a land part Vc. The hole part Va may be formed in a hole shape penetrating at least a portion of the coil board stack 1010 in an vertical direction. The hole part Va may penetrate, in the vertical direction, a region of the coil board stack 1010 in which the first coil board parts 1100 are stacked.

The inner wall part Vb may be disposed inside the hole part Va and may connect a plurality of coil patterns Cp stacked in the vertical direction in the vertical direction. The inner wall part Vb may include a conductor disposed in the hole part Va and may electrically connect the plurality of coil patterns Cp stacked in the vertical direction. For example, the inner wall part Vb may be formed as a copper plating layer plated on an inner wall of the first coil board part 1100 surrounding the hole part Va.

The land part Vc may electrically connect the inner wall part Vb and the coil pattern Cp. The land part Vc may be formed as a copper plating layer plated on an upper surface or a lower surface of the first coil board part 1100, and may be electrically connected to the inner wall part Vb and the coil pattern Cp, respectively.

Each first vertical connection part 1030 configured in the above-described manner may further include a via connection part Vd. The via connection part Vd is provided to electrically connect the coil pattern Cp and the via V, more specifically, to electrically connect the coil pattern Cp and the land part Vc. The via connection part Vd may be formed in a pattern shape protruding in a horizontal direction from the coil pattern Cp toward the separation region 1120b.

For example, the via connection part Vd may be formed to extend from the coil pattern Cp in a direction between a diametrical direction and a circumferential direction of a spiral formed by the first coil portion 1120. For example, the via connection part Vd may be formed in a straight-line shape connecting the coil pattern Cp and the via V in a direction between the diametrical direction and the circumferential direction.

Each via V provided in the above-described manner may be connected to one coil pattern Cp per one coil line 1123 or 1124, and may connect a plurality of coil patterns Cp in an vertical direction. The first vertical connection part 1030 including the via V may electrically connect a plurality of coil patterns Cp stacked in the vertical direction.

For example, the heating coil WC may be formed as a result of a plurality of coil lines 1123 and 1124 stacked in the vertical direction being connected in the vertical direction, and may be exemplarily formed by a connection between a group in which a plurality of first coil lines 1123 are continuously connected in the vertical direction and a group in which a plurality of second coil lines 1124 are continuously connected in the vertical direction.

For example, the heating coil WC may be formed as a result of four to five first coil lines 1123 being continuously connected in the vertical direction, and four to five second coil lines 1124 being continuously connected in the vertical direction below the group.

The heating coil WC having such a structure is advantageous in responding to cases in which interlayer coil lines 1123 and 1124 are unintentionally bonded due to various causes that cannot be identified because of fine process characteristics. The arrangement structure of the coil lines 1123 and 1124 having the above-described structure may be a structure capable of improving coil formation reliability, since the coil lines 1123 and 1124 having the same current direction are disposed adjacent to each other.

As another example, as shown in FIGS. 32 and 33, the first coil lines 1123 and the second coil lines 1124 may be alternately disposed along an vertical direction. That is, in a state in which the first coil lines 1123 and the second coil lines 1124 are alternately disposed along the vertical direction, vertical direction connections between the first coil lines 1123 and the second coil lines 1124 may be performed, and the heating coil WC may be formed as a result of a plurality of first coil lines 1123 and second coil lines 1124 being connected in the vertical direction in this manner.

In a case where the coil lines 1123 and 1124 are continuously connected, current may be concentrated at an intermediate point of the via V in the vertical direction, that is, at a point where the first coil line 1123 and the second coil line 1124 are in contact with each other, and accordingly, heat generation at the corresponding portion may increase, and it may become difficult for current to smoothly flow through the via V (see FIGS. 31 and 32).

In comparison, when the coil lines 1123 and 1124 are alternately disposed, each first coil line 1123 may be disposed adjacent to a corresponding second coil line 1124 in a paired manner. Accordingly, when the coil lines 1123 and 1124 are alternately disposed, current may be divided and flow, and an amount of heat generation may be relatively reduced. That is, not only may current flow smoothly through the via V, but also occurrence of a phenomenon in which heat generation is concentrated in a portion of the via V may be effectively suppressed.

Each first vertical connection part 1030 connecting the first coil lines 1123 and the second coil lines 1124 in the vertical direction as described above may include at least one via V. For example, each first vertical connection part 1030 may include one via V.

According to the present embodiment, the via V may be disposed in the separation region 1120b. For example, the via V may be disposed further inward than a coil pattern Cp disposed at an innermost side in the diametrical direction among the plurality of coil patterns Cp forming each of the coil lines 1123 and 1124, or the via V may be disposed further outward than a coil pattern Cp disposed at an outermost side among the coil patterns Cp.

For example, a distance between one of a plurality of coil patterns Cp disposed at an innermost side and a center of a via V, or a distance between one of the plurality of coil patterns Cp disposed at the outermost side and the center of the via V, may be set to be longer than a radius of the via V.

Accordingly, the via V disposed in the separation region 1120b may be disposed so as not to contact another coil pattern Cp that is adjacent in the diametrical direction, that is, a coil pattern Cp other than the coil pattern Cp directly connected to the via V.

In addition, a perpendicular distance between the center of the via V and the first straight line L1, or a perpendicular distance between the center of the via V and the second straight line L2, may be set to be longer than the radius of the via V. In addition, a length of the separation region 1120b in the horizontal direction may be formed to be longer than a diameter of the via V. In these cases as well, the via V may be disposed in the separation region 1120b so that contact between the via V and the coil patterns Cp does not occur.

As another example, each first vertical connection part 1030 may include a plurality of vias V, as illustrated in FIGS. 34 to 36. For example, each first vertical connection part 1030 may include a plurality of vias V arranged along a circumferential direction of a spiral formed by the first coil portion 1120, hereinafter referred to as a circumferential direction.

Each via V included in the first vertical connection part 1030 may form a passage that connects the plurality of coil patterns Cp stacked in the vertical direction. A width of each passage formed by the via V is mainly related to an area of the inner wall part Vb. That is, when an area of the inner wall part Vb increases, a width of a passage formed by the via V may increase.

The area of the inner wall part Vb is mainly related to a diameter of the hole part Va. That is, as the diameter of the hole part Va increases, the area of the inner wall part Vb may increase, and accordingly, the passage formed by the via V may be widened. When the first vertical connection part 1030 includes a single via V, the diameter of the hole part Va must be increased in order to increase the area of the inner wall part Vb.

However, since the via V must be disposed in the separation region 1120b, that is, a region in which no coil pattern Cp is disposed, an increase in the diameter of the hole part Va requires a corresponding increase in a size of the separation region 1120b. For this purpose, not only a length of the separation region 1120b in the circumferential direction but also a length of the separation region 1120b in the diametrical direction must be increased. However, when the length of the separation region 1120b in the diametrical direction is increased, a size of an available area for arranging the coil patterns Cp in the first coil portion 1120 inevitably decreases.

In consideration of the above, in the present embodiment, each first vertical connection part 1030 may be formed by a plurality of vias V arranged along the circumferential direction. Accordingly, each first vertical connection part 1030 may form a plurality of passages that connect a plurality of coil patterns Cp stacked in the vertical direction.

That is, the plurality of coil patterns Cp stacked in the vertical direction may be connected in the vertical direction by the plurality of passages formed by the plurality of vias V constituting one first vertical connection part 1030.

In each first vertical connection part 1030, a plurality of vias V arranged in the horizontal direction may be electrically connected to one another. That is, in each first vertical connection part 1030, an electrical connection among the plurality of vias V may be established by coil patterns Cp electrically connected to the plurality of vias V, or may be established by connecting land parts Vc provided in the respective vias V to one another.

As described above, as the first vertical connection part 1030 includes the plurality of vias V, an area of inner wall parts Vb of the first vertical connection part 1030 may be increased, whereby resistance in the first vertical connection part 1030 may be reduced and an amount of heat generation in the first vertical connection part 1030 may be decreased.

As described above, the plurality of vias V constituting the first vertical connection part 1030 are disposed in the separation region 1120b and may be connected to via connection parts Vd protruding from the coil patterns Cp toward the separation region 1120b. In this case, each via connection part Vd may form a straight line extending from the coil pattern Cp in a direction between the diametrical direction and the circumferential direction, and the plurality of vias V connected thereto may be disposed along the circumferential direction.

When the first coil portion 1120 is formed in a rectangular spiral shape, the first vertical connection part 1030 may be connected to the first straight line L1 or may be connected to the second straight line L2. When the first vertical connection part 1030 is connected to the first straight line L1, the first vertical connection part 1030 may include a plurality of vias V arranged along the first direction. When the first vertical connection part 1030 is connected to the second straight line L2, the first vertical connection part 1030 may include a plurality of vias V arranged along the second direction.

The first vertical connection part 1030 and the plurality of vias V included therein are disposed in the separation region 1120b. Accordingly, the first vertical connection part 1030 connected to the first straight line L1 and the first straight line L1 may be arranged along the second direction, and the first vertical connection part 1030 connected to the second straight line L2 and the second straight line L2 may be arranged along the first direction. That is, the first vertical connection part 1030 connected to the first straight line L1 and the first straight line L1 may be arranged along the diametrical direction, and the first vertical connection part 1030 connected to the second straight line L2 and the second straight line L2 may also be arranged along the diametrical direction.

As a plurality of vias V form a plurality of paths in each first vertical connection part 1030, an area of the paths formed by each first vertical connection part 1030 may be increased as compared to a case in which the vertical connection part includes only a single via V. For example, the area of the paths formed by the first vertical connection part 1030 may increase in proportion to the number of vias V.

According to the present embodiment, the plurality of vias V forming each first vertical connection part 1030 may be arranged along the circumferential direction. That is, in each first vertical connection part 1030, the plurality of vias V may not be arranged in a direction parallel to a straight line formed by the via connection part Vd, but may be arranged along the circumferential direction.

If, in the first vertical connection part 1030, the plurality of vias V are arranged in a direction parallel to a straight line formed by the via connection part Vd, for example, in a direction between a diametrical direction and a circumferential direction, an increase in a size of a separation region 1120b in which the first vertical connection part 1030 is disposed, a reduction in the number of vias V, or a reduction in a size of each via V may be required.

In contrast, in the present embodiment, the plurality of vias V in the first vertical connection part 1030 are arranged along the circumferential direction. Accordingly, even when each first vertical connection part 1030 includes the plurality of vias V, it is not necessary to increase a size of the separation region 1120b in which the first vertical connection part 1030 is disposed, and in particular, it is not necessary to increase a length of the separation region 1120b in the diametrical direction.

As a result, the first vertical connection part 1030 according to the present embodiment can effectively increase an area of the paths formed by the first vertical connection part 1030 for vertically connecting the plurality of coil patterns Cp, while suppressing a reduction in a size of an area available for arranging the coil patterns Cp in the first coil portion 1120.

In the present embodiment, the plurality of vias V constituting the first vertical connection part 1030 are exemplarily arranged in a direction parallel to the circumferential direction; however, the present disclosure is not limited thereto.

As another example, the vias V may be arranged along the diametrical direction or along a direction between the diametrical direction and the circumferential direction, as long as the vias V do not extend beyond the separation region 1120b, and the vias V may be arranged to form a bent line or a curved line rather than a straight line, or may be arranged in a polygonal, circular, or elliptical shape.

For example, a distance between one of a plurality of coil patterns Cp disposed at an innermost side and a center of a via V, or a distance between one of the plurality of coil patterns Cp disposed at the outermost side and the center of the via V, may be set to be longer than a radius of the via V.

Accordingly, the via V disposed in the separation region 1120b may be disposed so as not to contact another coil pattern Cp that is adjacent in the diametrical direction, that is, a coil pattern Cp other than the coil pattern Cp directly connected to the via V.

In addition, a perpendicular distance between the center of the via V and the first straight line L1, or a perpendicular distance between the center of the via V and the second straight line V, may be set to be longer than the radius of the via V. In addition, a length of the separation region 1120b in the horizontal direction may be formed to be longer than a diameter of the via V. In these cases as well, the via V may be disposed in the separation region 1120b so that contact between the via V and the coil patterns Cp does not occur.

As another example, as illustrated in FIGS. 37 and 38, a plurality of vias V may be provided in the first vertical connection part 1030, and the first coil line 1123 and the second coil line 1124 may be alternately disposed along the vertical direction.

As still another example, as illustrated in FIGS. 39 and 40, the first vertical connection part 1030 may include more than two vias V, for example, five vias V, and the plurality of vias V may be arranged along the circumferential direction.

As still another example, as illustrated in FIGS. 41 and 42, more than two vias V may be provided in the first vertical connection part 1030, and the first coil line 1123 and the second coil line 1124 may be alternately disposed along the vertical direction.

As yet another example, two or more coil patterns Cp may be arranged along the diametrical direction. Further, a horizontal length of the separation region 1120b may be formed to be longer than two times a diameter of the via V. For example, when two coil patterns Cp are arranged in a diametrical direction, the horizontal length of the separation region 1120b may be formed to be longer than two times the diameter of the via V, and when three or more coil patterns Cp are arranged in the diametrical direction, the horizontal length of the separation region 1120b may be formed to be longer than three times the diameter of the via V.

Accordingly, even when a plurality of vias V are disposed in the separation region 1120b in the diametrical direction, the vias V may be disposed in the separation region 1120b such that contact between the vias V and the coil patterns Cp does not occur.

[Structure of sensing coil]

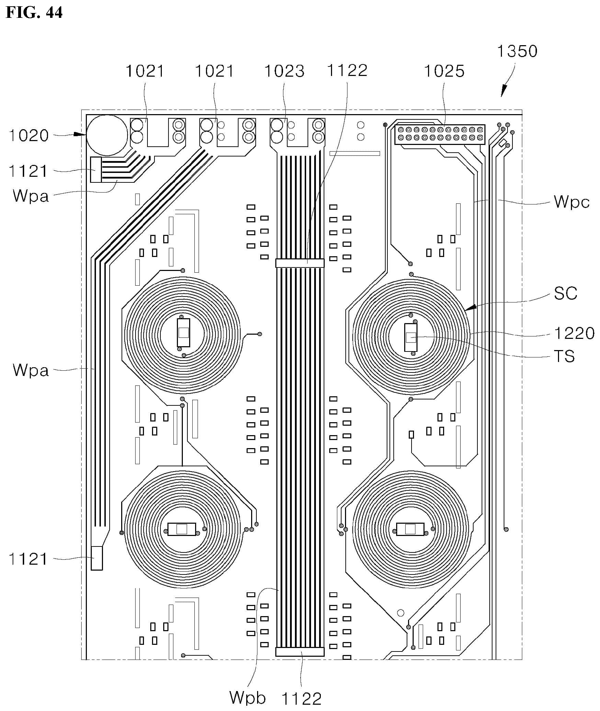

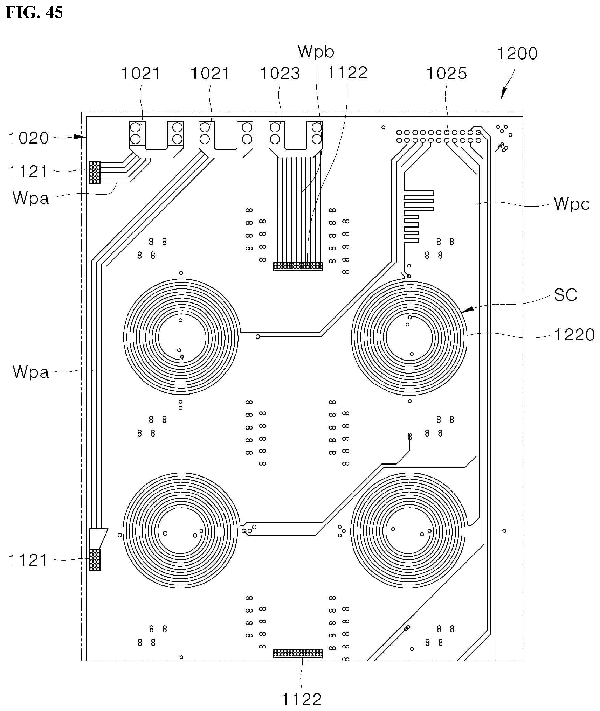

FIG. 43 is a cross-sectional view illustrating an example of a stacked structure of a second outer layer part and a second coil board part, FIG. 44 is an enlarged view illustrating an enlarged portion of the second outer layer part, and FIG. 45 is an enlarged view illustrating an enlarged portion of the second coil board part.

According to the present embodiment, as illustrated in FIGS. 7 and 43 to 37, a sensing coil SC may be formed by second coil portions 1220 respectively provided in the second coil board part 1200. Each sensing coil SC may be formed by one second coil portion 1220, or may be formed as a result of connecting a plurality of second coil portions 1220 stacked in the vertical direction in the vertical direction.

For example, the sensing coil SC may be disposed above the heating coil WC. Further, each second coil board part 1200 may include a core 1210 and the second coil portion 1220. In addition, each second coil board part 1200 may further include the first coil portion 1120.

The second coil portion 1220 may be disposed on at least one of one side and the other side of the core 1210 in an vertical direction. For example, when the second coil board part 1200 includes both the first coil portion 1120 and the second coil portion 1220, the first coil portion 1120 may be disposed on one side of the core 1210 in the vertical direction, and the second coil portion 1220 may be disposed on the other side of the core 1210 in the vertical direction. For example, the first coil portion 1120 may be provided in a form patterned below the core 1210, and the second coil portion 1220 may be provided in a form patterned above the core 1210.

When the second coil board part 1200 includes only the core 1210 and the second coil portion 1220, the second coil portion 1220 may be disposed on both sides of the core 1210 in the vertical direction. For example, each second coil board part 1200 may be provided in a structure in which one layer of the second coil portion 1220 is formed on each of both sides of the core 1210 in the vertical direction. Such second coil portions 1220 may be provided in a form patterned on both sides of the core 1210 in the vertical direction, similarly to the first coil portion 1120.

In the present embodiment, each second coil board part 1200 is exemplified as including the core 1210, the first coil portion 1120, and the second coil portion 1220, wherein the first coil portion 1120 is provided in a form patterned below the core 1210, and the second coil portion 1220 is provided in a form patterned above the core 1210.

Further, a second outer layer part 1350 may be disposed above the second coil board part 1200, and the second outer layer part 1350 may include the second coil portion 1220 similarly to the second coil board part 1200. One second coil portion 1220 provided in the second coil board part 1200 and one second coil portion 1220 provided in the second outer layer part 1350 may be connected in the vertical direction to form one sensing coil SC.

In addition, a plurality of second coil portions 1220 may be arranged in a horizontal direction in each of the second coil board part 1200 and the second outer layer part 1350, and accordingly, the coil modules 1001 and 1003 may include a plurality of sensing coils SC arranged in the horizontal direction.

In each of the coil modules 1001 and 1003, the sensing coil SC may be disposed outside the first coil board part 1100 in a vertical direction. For example, the sensing coil SC may be disposed above or below the first coil board part 1100.

As another example, the sensing coil SC may be disposed below the heating coil WC. In this case, the second coil board part 1200 may be disposed below the first coil board part 1100, and the second coil portion 1220 may be disposed below the core 1210. In addition, an outer layer part 1300 or 1350 formed in the same or similar form as the second coil portion 1220 may be disposed below the second coil portion 1220 and may be connected to the second coil portion 1220 in the vertical direction.

As still another example, the sensing coil SC may be disposed inside the heating coil WC. In this case, at least one first coil board part 1100 may be disposed below the second coil board part 1200, and at least one first coil board part 1100 may also be disposed above the second coil board part 1200. Accordingly, the sensing coil SC may be disposed between a stack of the first coil board parts 1100, thereby being disposed inside the heating coil WC formed by the stack of the first coil board parts 1100.

Meanwhile, the heating coil assembly 1000 according to the present embodiment may further include a second vertical connection part 1040. The second vertical connection part 1040 is provided to connect, in the vertical direction, a coil board stack 1010 having the second coil board part 1200 and the second outer layer part 1350 stacked in the vertical direction, or a coil board stack 1010 having a plurality of second coil board parts 1200 stacked in the vertical direction.

Each of the coil modules 1001 and 1003 may include a plurality of second vertical connection parts 1040. Each second vertical connection part 1040 may connect, in the vertical direction, a plurality of second coil portions 1220 arranged on the same straight line in the vertical direction.

For example, when the second outer layer part 1350 is stacked above the second coil board part 1200 in the coil board stack 1010, each second vertical connection part 1040 may penetrate the second outer layer part 1350 and the second coil board part 1200 in the vertical direction and may connect the second coil portions 1220 in the vertical direction. In this case, each sensing coil SC may be formed as a result of the second coil portions 1220 of the second outer layer part 1350 and the second coil board part 1200 stacked in the vertical direction being connected in the vertical direction by the second vertical connection part 1040.

As another example, when a plurality of second coil portions 1220 are stacked in the vertical direction in each coil board stack 1010, each second vertical connection part 1040 may penetrate the plurality of second coil board parts 1200 in the vertical direction and may connect the second coil portions 1220 in the vertical direction. In this case, each sensing coil SC may be formed as a result of the second coil portions 1220 of the plurality of second coil board parts 1200 stacked in the vertical direction being connected in the vertical direction by the second vertical connection part 1040.

The second vertical connection part 1040 may be disposed in a region of the second coil board part 1200 in which the first coil portion 1120 is not disposed, and may be connected to the second coil portion 1220 or the outer layer part 1300 or 1350 in a horizontal direction. Each second vertical connection part 1040 may include vias V, respectively, similarly to the first vertical connection part 1030.

Each via V may connect, in the vertical direction, the outer layer part 1300 or 1350 and the second coil portion 1220 arranged on the same straight line in the vertical direction. Each such via V may be disposed in a region of the second coil board part 1200 in which the first coil portion 1120 is not disposed, and may be connected to the second coil portion 1220 or the outer layer part 1300 or 1350 in the horizontal direction.

According to the present embodiment, at least one of a plurality of second coil portions 1220 arranged in a horizontal direction may be disposed at a position overlapping, in a vertical direction, a non-patterned region 1103 or 1105 of the first coil portion 1120. In this case, at least a portion of the corresponding second coil portion 1220 may be disposed at a position overlapping, in the vertical direction, the non-patterned region 1103 or 1105 of the first coil portion 1120.

More specifically, at least one of the plurality of second coil portions 1220 arranged in the horizontal direction may be disposed at a position overlapping, in the vertical direction, a second non-patterned region 1105. In this case, at least a portion of the corresponding second coil portion 1220 may be disposed at a position overlapping, in the vertical direction, the second non-patterned region 1105.

Further, a second vertical connection part 1040 connected to the second coil portion 1220 and vias V included therein may be disposed at a position overlapping, in the vertical direction, the second non-patterned region 1105.

Meanwhile, each heating coil WC may be disposed to be spaced apart by a predetermined distance in a first direction from another heating coil WC adjacent in the first direction, and may be disposed to be spaced apart by a predetermined distance in a second direction from another heating coil WC adjacent in the second direction. That is, a separation space may be formed between two heating coils WC adjacent in the first direction, and a separation space may also be formed between two heating coils WC adjacent in the second direction.

According to the present embodiment, at least one of the plurality of second coil portions 1220 may be disposed at a position overlapping, in the vertical direction, a separation space formed between two heating coils WC adjacent in the second direction. In this case, at least a portion of the corresponding second coil portion 1220 may be disposed at a position overlapping, in the vertical direction, the separation space.

Further, a second vertical connection part 1040 connected to the second coil portion 1220 and vias V included therein may be disposed at a position overlapping, in the vertical direction, the separation space.

Generally, formation of the second vertical connection part 1040 is performed in a state in which stacking of the first coil board part 1100 and the second coil board part 1200 for forming the coil board stack 1010 has been completed. That is, in a state in which both the first coil board part 1100 and the second coil board part 1200 are stacked, processing of hole parts Va for forming vias V of the second vertical connection part 1040 is performed.

However, if the second vertical connection part 1040 is disposed at a position overlapping, in a vertical direction, the coil pattern Cp of the first coil portion 1120, damage to the coil pattern Cp may occur due to a drilling operation for processing the hole parts Va. If, instead, the formation operation of the second vertical connection part 1040 is performed prior to stacking of the first coil board part 1100 and the second coil board part 1200, formation of the first vertical connection part 1030 and formation of the second vertical connection part 1040 may inevitably be performed separately. In this case, a problem arises in that a work load required for manufacturing the heating coil assembly 1000 is increased and a manufacturing cost is increased.

In consideration of these points, in the present embodiment, the second vertical connection part 1040 is disposed at a position overlapping, in the vertical direction, non-patterned regions 1103 and 1105 of the first coil portion 1120. According to this, since the second vertical connection part 1040 is disposed at a position that does not overlap, in the vertical direction, the coil pattern Cp of the first coil portion 1120, a drilling operation for forming the second vertical connection part 1040 does not affect the non-patterned regions 1103 and 1105 of the first coil portion 1120.

That is, as exemplified in the present embodiment, when the second vertical connection part 1040 is disposed as described above, even if a drilling operation for forming the second vertical connection part 1040 is performed in a state in which stacking of the first coil board part 1100 and the second coil board part 1200 for forming the coil board stack 1010 has been completed, a possibility that damage to the coil pattern Cp occurs due to the drilling operation may be extremely reduced.

Accordingly, the heating coil assembly 1000 according to the present embodiment may effectively suppress occurrence of damage to the coil pattern Cp caused by an operation for forming the vias V, while suppressing an increase in a work load required for manufacturing the heating coil assembly 1000 and an increase in a manufacturing cost.

[Structure of connection]

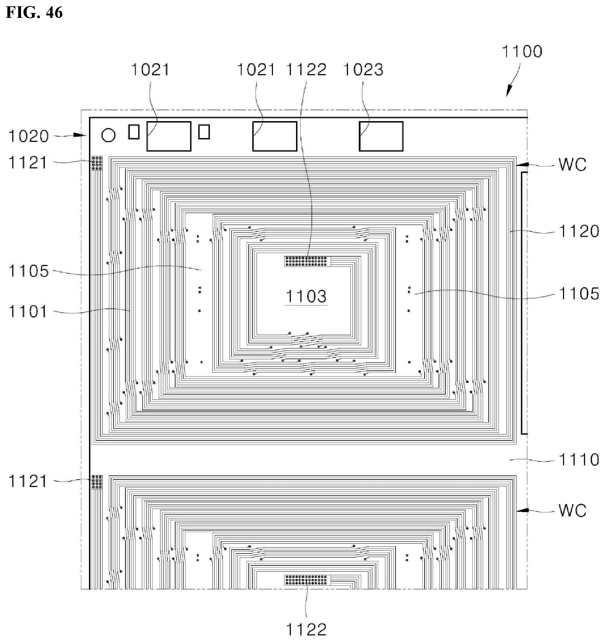

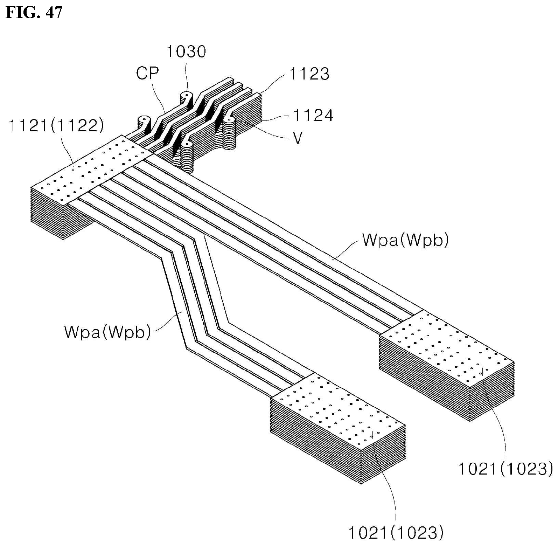

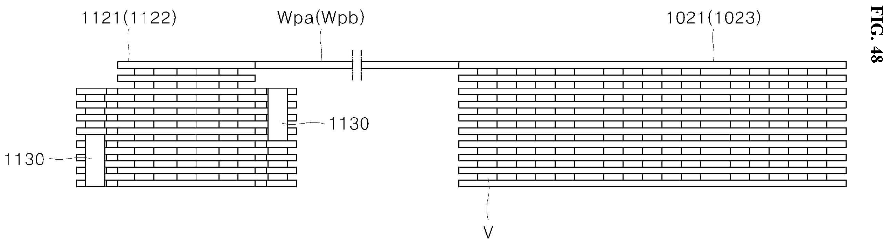

FIG. 46 is an enlarged view illustrating an enlarged portion of the first coil board part, FIG. 47 is a view illustrating a second terminal and a second connection separated from each other, and FIG. 48 is a cross-sectional view schematically illustrating a stacked structure of the second terminal and the second connection illustrated in FIG. 47.

Referring to FIGS. 7, 17, 20, and 44 to 48, the connection 1020 may be provided for connection between a power supply part supplying power and the heating coil WC. For example, the connection 1020 may be electrically connected to the heating coil WC and may also be electrically connected to a driving circuit 300 and a load circuit 350.

In a horizontal direction, the connection 1020 may be disposed outside a group of a plurality of heating coils WC. The connection 1020 may be provided to be connected to at least one of a first terminal 1121 and a second terminal 1122.

The connection 1020 may include a first connection 1021. The first connection 1021 is connected to the first terminal 1121. The first connection 1021 may be connected to the heating coil WC through the first terminal 1121.

Further, the connection 1020 may include a second connection 1023. The second connection 1023 is connected to the second terminal 1122. The second connection 1023 may be connected to the heating coil WC through the second terminal 1122.

The first terminal 1121 and the second terminal 1122 may be respectively provided in the first coil board part 1100 and the first outer layer part 1300. That is, the first terminal 1121 and the second terminal 1122 may be formed in the same layer as a layer in which the first coil portion 1120 is formed.

According to the present embodiment, in each of the coil modules 1001 and 1003, a plurality of heating coils WC may be disposed in a matrix form. That is, a plurality of heating coils WC may be arranged in a first direction, and a plurality of heating coils WC may also be arranged in a second direction.

For example, each connection 1020 may include a plurality of first connections 1021 disposed in the first direction. In addition, in each of the coil modules 1001 and 1003, a plurality of heating coils WC adjacent in the second direction may be connected to operate together simultaneously.

According to this, each first connection 1021 may be connected to one heating coil WC. Further, the second connection 1023 may be connected together with a plurality of heating coils WC adjacent in the second direction.

For example, when a plurality of heating coils WC are arranged in a 2-column by 4-row configuration in each of the coil modules 1001 and 1003, a pair of connections 1020 may be provided in each of the coil modules 1001 and 1003. The pair of connections 1020 may be disposed to be spaced apart from each other in the first direction with a group of a plurality of heating coils WC interposed therebetween. That is, one of the pair of connections 1020 may be disposed on a front side of the group of the plurality of heating coils WC, and the other of the pair of connections 1020 may be disposed on a rear side of the group of the plurality of heating coils WC.

In each of the coil modules 1001 and 1003, the plurality of heating coils WC may be divided into two halves each having a 2-column by 2-row configuration, and each connection 1020 may be connected to heating coils WC in the 2-column by 2-row configuration adjacent thereto. For example, one of the pair of connections 1020 disposed on the front side may be connected to four heating coils WC disposed on the front side on the coil modules 1001 and 1003, and the other of the pair of connections 1020 disposed on the rear side may be connected to four heating coils WC disposed on the rear side on the coil modules 1001 and 1003.

As described above, the first terminal 1121 may be connected to a horizontally outermost end of the heating coil WC, and the second terminal 1122 may be connected to an innermost end of the heating coil WC. For example, each first terminal 1121 may be disposed at a position biased toward a connection 1020 to which the first terminal 1121 is to be connected.

That is, with respect to the second direction, each first terminal 1121 may be disposed at a position closer to an end of the heating coil WC than to a center thereof, and may be disposed at a position biased toward the connection 1020 to which the first terminal 1121 is to be connected. For example, the first terminals 1121 provided in four heating coils WC adjacent to the connection 1020 disposed on the front side of the pair of connections 1020 may be disposed at positions biased toward the front side on the heating coils WC.

According to the present embodiment, each connection 1020 may include a pair of first connections 1021 arranged in the first direction. Each first connection 1021 may be connected to one first terminal 1121, thereby being connected to only one heating coil WC. Each of the first connections 1021 may electrically connect a heating coil WC, one by one, to a power supply part, for example, a driving circuit 300 and a load circuit 350.

The second connection 1023 may connect the heating coil WC to ground. The second connection 1023 may be connected to a pair of second terminals 1122 adjacent in the second direction. That is, the second connection 1023 may connect a pair of heating coils WC adjacent in the second direction to ground.

In addition, each connection 1020 may further include a third connection 1025. The third connection 1025 may connect a heating coil SC to the power supply part. The third connection 1025 may be provided in the second outer layer part 1350 and may also be provided in the second coil board part 1200.

For example, the connection 1020 may be respectively provided in the first coil board part 1100, the second coil board part 1200, and the outer layer parts 1300 and 1350 stacked in the vertical direction. For example, the first connections 1021 respectively provided in the first coil board part 1100, the second coil board part 1200, the first outer layer part 1300, and the second outer layer part 1350 may be stacked in the vertical direction, and the first connections 1021 stacked in the vertical direction in this manner may be electrically connected through vias V.

Further, the second connections 1023 respectively provided in the first coil board part 1100, the second coil board part 1200, the first outer layer part 1300, and the second outer layer part 1350 may be stacked in the vertical direction, and the second connections 1023 stacked in the vertical direction in this manner may be electrically connected through vias V.

As another example, the connection 1020 may be provided only in the second outer layer part 1350. That is, the connection 1020 may be disposed only at an upper end of the coil modules 1001 and 1003.

According to the present embodiment, each of the coil modules 1001 and 1003 includes a plurality of sensing coils SC, and the plurality of sensing coils SC may be disposed to be spaced apart from each other by a predetermined distance along the first direction. Further, the second outer layer part 1350 and the second coil board part 1200 may respectively include the first terminal 1121 and the second terminal 1122, similarly to the first coil board part 1100. That is, the first terminal 1121 and the second terminal 1122 may also be formed in the same layer as a layer in which the second coil portion 1220 is formed.

Further, at least one of the first terminal 1121 and the second terminal 1122 may include vias V. In the present embodiment, the first terminal 1121 and the second terminal 1122 are exemplified as each including a plurality of vias V, and the plurality of vias V are arranged in a horizontal direction in each of the first terminal 1121 and the second terminal 1122.

According to the present embodiment, the first terminals 1121 respectively provided in the first coil board part 1100, the second coil board part 1200, and the second outer layer part 1350 may be stacked in the vertical direction, and the first terminals 1121 stacked in the vertical direction in this manner may be electrically connected through vias V. Further, the second terminals 1122 respectively provided in the first coil board part 1100 and the second coil board part 1200 may be stacked in the vertical direction, and the second terminals 1122 stacked in the vertical direction in this manner may be electrically connected through vias V.

For example, each via V may penetrate the first coil board part 1100 and the second coil board part 1200 stacked in the vertical direction in the vertical direction. The vias V provided in the first terminal 1121 may connect, in a vertical direction, a plurality of first terminals 1121 arranged on the same straight line in the vertical direction. Further, the vias V provided in the second terminal 1122 may connect, in the vertical direction, a plurality of second terminals 1122 arranged on the same straight line in the vertical direction.

Further, at least one of the second coil board part 1200 and the second outer layer part 1350 may include a first wiring pattern Wpa and a second wiring pattern Wpb. For example, the first wiring pattern Wpa and the second wiring pattern Wpb may be respectively formed in the second coil board part 1200 and the second outer layer part 1350. As another example, the first wiring pattern Wpa and the second wiring pattern Wpb may be formed only in the second outer layer part 1350.

In the present embodiment, the first wiring pattern Wpa and the second wiring pattern Wpb are exemplified as being respectively formed in the second coil board part 1200 and the second outer layer part 1350. According to this, the first wiring pattern Wpa may be provided to electrically connect the first connection 1021 and the first terminal 1121 outside the first coil board part 1100 in the vertical direction. Further, the second wiring pattern Wpb may be provided to electrically connect the second connection 1023 and the second terminal 1122 outside the first coil board part 1100 in the vertical direction.

That is, the first wiring pattern Wpa may be electrically connected to the first terminal 1121 provided in at least one of the second coil board part 1200 and the second outer layer part 1350, and through this, may be electrically connected to the heating coil WC formed in the first coil board part 1100. Further, the second wiring pattern Wpb may be electrically connected to the second terminal 1122 provided in at least one of the second coil board part 1200 and the second outer layer part 1350, and through this, may be electrically connected to the heating coil WC formed in the first coil board part 1100.

According to the present embodiment, each sensing coil SC may be disposed at a position overlapping, in the vertical direction, the second non-patterned region 1105 or a separation space. Each such sensing coil SC may be disposed not to overlap, in the vertical direction, the first terminal 1121 and the second terminal 1122, and may also be disposed not to be positioned on the same straight line in the second direction as the first terminal 1121 and the second terminal 1122.

That is, in each of the coil modules 1001 and 1003, a pair of sensing coils SC may be disposed to be spaced apart from each other along the first direction with the second terminal 1122 interposed therebetween. For example, the second wiring pattern Wpb may extend from the second connection 1023 in the second direction, and may extend in the second direction through a path passing between the pair of sensing coils SC from the second connection 1023.

In addition, at least one of the second coil board part 1200 and the second outer layer part 1350 may further include a third wiring pattern Wpc. The third wiring pattern Wpc may be formed in each of the second coil board part 1200 and the second outer layer part 1350, or may be formed only in the second outer layer part 1350. The third wiring pattern Wpc is provided to electrically connect the heating coil SC and the third connection 1025.

As described above, the plurality of heating coils WC and sensing coils SC provided in the coil modules 1001 and 1003 may be connected to the connection 1020 through the wiring patterns Wpa, Wpb, and Wpc within the coil modules 1001 and 1003, and may be connected to the electrical component part 170 (see FIG. 4) through the connection 1020.

That is, wiring for connecting the heating coils WC and the sensing coils SC to the connection 1020 is formed in a patterned form in the coil modules 1001 and 1003 themselves, and connection between the heating coils WC and the sensing coils SC and the electrical component part 170 may be achieved only by connection between the connection 1020 and the electrical component part 170.

According to this, the heating coils WC and the sensing coils SC may be connected to the electrical component part 170 by only an easy and simple operation of connecting the connection 1020 and the electrical component part 170, and a connection structure between the heating coils WC and the sensing coils SC and the electrical component part 170 may be formed very simply.

Further, since a separate wiring operation for connecting the heating coil WC and the sensing coil SC to the electrical component part 170 is not required, a connection operation between the heating coil assembly 1000 and the electrical component part 170 may be easily and quickly performed, and a receiving space inside a cooktop 100 accommodating the heating coil assembly 1000 and the electrical component part 170 may not become complicated due to a large number of wirings.

[Structure of mask and dummy via]

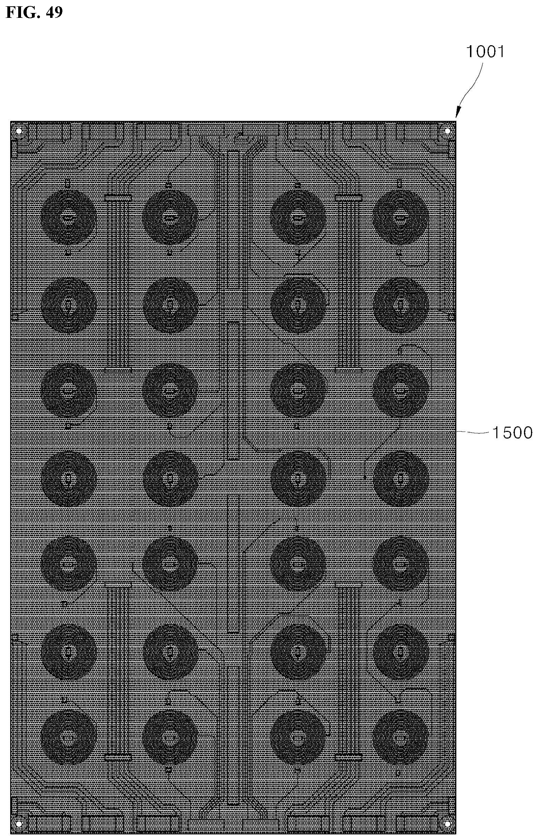

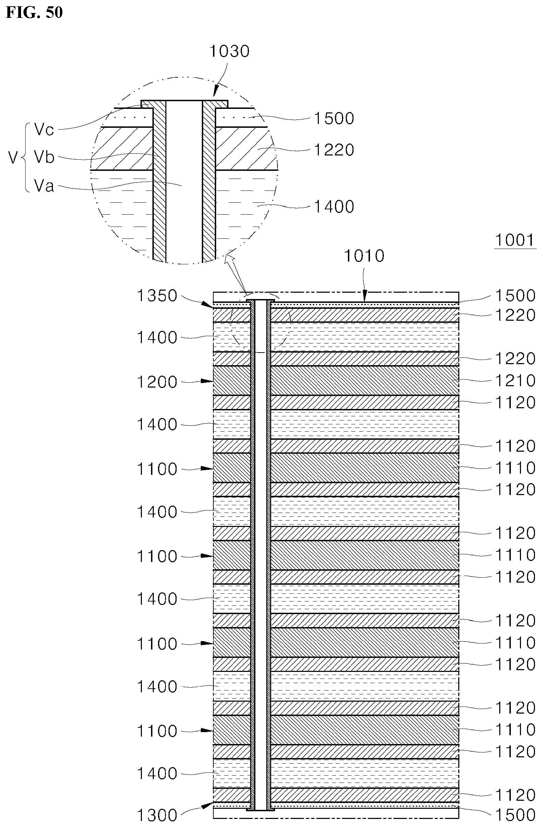

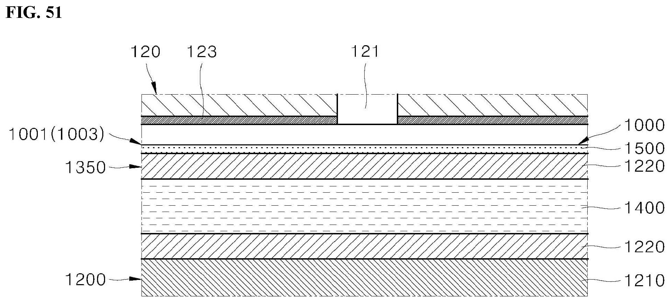

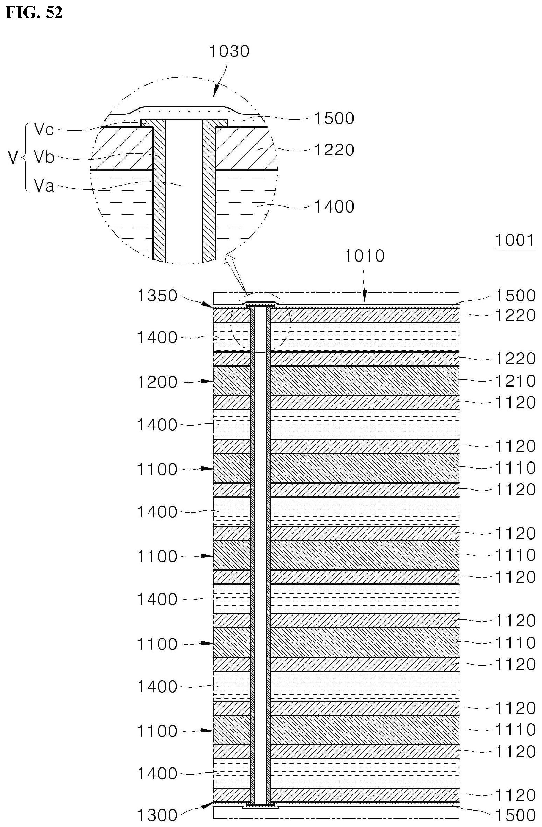

FIG. 49 is a view illustrating a state in which a mask covers the heating coil assembly, and FIG. 50 is a cross-sectional view schematically illustrating an example of a stacked structure of the heating coil assembly illustrated in FIG. 49. Further, FIG. 51 is a cross-sectional view schematically illustrating a state in which the heating coil assembly is covered with a top plate, and FIG. 52 is a cross-sectional view schematically illustrating another example of the stacked structure of the heating coil assembly illustrated in FIG. 49.

Referring to FIGS. 44 and 49 to 51, the heating coil assembly 1000 according to the present embodiment may further include a mask 1500. The mask 1500 is provided to cover uppermost and lowermost outer surfaces of the coil board stack 1010 in a vertical direction.

That is, the mask 1500 is provided to cover an upper surface and a lower surface of the coil modules 1001 and 1003. The mask 1500 may form surfaces of the coil modules 1001 and 1003, and may form a heat-resistant coating that protects various patterns disposed on the upper surface and the lower surface of the coil modules 1001 and 1003, for example, coil patterns Cp, wiring patterns Wpa and Lpb, and vias V.

For example, the mask 1500 may cover patterns or vias V disposed on outermost surfaces of the coil board stack 1010 and may form protrusions and recesses having shapes corresponding to the patterns or the vias V. That is, the upper surface and the lower surface of the coil modules 1001 and 1003 formed by the mask 1500 may include protrusions and recesses having a shape corresponding to shapes of the patterns or the vias V disposed on the outermost surfaces of the coil board stack 1010.

The mask 1500 as described above is provided to cover the upper surface and the lower surface of the coil modules 1001 and 1003 such that various patterns disposed on the upper surface and the lower surface of the coil modules 1001 and 1003 are not exposed to an outside of the coil modules 1001 and 1003, thereby preventing solder from being unnecessarily attached to circuit patterns formed on the coil modules 1001 and 1003 and protecting surfaces of the coil modules 1001 and 1003.

The mask 1500 may be formed by a solder resist printed on uppermost and lowermost outer surfaces of the coil board stack 1010 in a vertical direction. For example, the mask 1500 may be formed as a result of photo solder resist ink printed on the upper surface and the lower surface of the coil modules 1001 and 1003 being cured by ultraviolet light.

According to the present embodiment, a top plate 120 may be disposed outside the coil modules 1001 and 1003 in the vertical direction. That is, the coil modules 1001 and 1003 may be covered by the top plate 120 disposed above the coil modules 1001 and 1003. For example, the top plate 120 may be formed of a transparent or translucent material capable of transmitting light, such as glass or acrylic.

On one surface of the top plate 120 in the vertical direction, a cover part 123 covering the mask 1500 from outside in the vertical direction may be formed. For example, the cover part 123 may be formed on a lower surface of the top plate 120, and the cover part 123 may cover the mask 1500 from above. For example, the cover part 123 may be a printed layer or a coating layer formed on the lower surface of the top plate 120 facing the mask 1500.

According to the present embodiment, a light display region 121 is formed in the top plate 120, and the cover part 123 may be disposed in a region in which the light display region 121 is not disposed. For example, the cover part 123 may be formed in most regions of the top plate 120, and the light display region 121 may be formed only in a partial region for irradiating light emitted from the lighting module 180 to an upper portion of the top plate 120.

To this end, the light display region 121 may be formed to have higher transparency than the cover part 123. For example, the cover part 123 may be formed in an opaque state that hardly transmits light. For example, the cover part 123 may be formed in a low-luminance color having a grayscale luminance value of 0 to 3. For example, the cover part 123 may be formed in an achromatic color, more specifically, black.

The mask 1500 may be formed in a color similar to the cover part 123. That is, the mask 1500 may be formed in a color that is not easily distinguishable from a color of the cover part 123. For example, the mask 1500 may be formed in the same color as the cover part 123.

For example, the mask 1500 may be formed in a low-luminance color having a grayscale luminance value of 0 to 3. For example, the cover part 123 may be formed in a low-luminance color, and the mask 1500 may also be formed in the same or a similar low-luminance color.

In the present embodiment, the mask 1500 is exemplified as being formed in an achromatic color. According to this, the cover part 123 may be formed in an achromatic color, and the mask 1500 may also be formed in an achromatic color.

For example, the mask 1500 may be formed in black. According to this, the cover part 123 may be formed in black, and the mask 1500 may also be formed in black. As a result, surfaces of the coil modules 1001 and 1003 may be formed in black that is the same as or similar to a color of the cover part 123.

As the surfaces of the coil modules 1001 and 1003 are formed in a color that is the same as or similar to the color of the cover part 123, the heating coil assembly 1000 may not be easily visible from outside the cooktop 100. Further, as the surfaces of the coil modules 1001 and 1003 are formed in a dark color such as black, the heating coil assembly 1000 disposed in a dark internal space of the cooktop 100 may not be easily noticeable.

That is, by the mask 1500 formed in black that is the same as or similar to the color of the cover part 123, the heating coil assembly 1000 may be installed inside the cooktop 100 so as not to be easily visible from outside the cooktop 100, thereby effectively suppressing degradation of aesthetics of a cooking appliance due to the heating coil assembly 1000.

For example, formation of the mask 1500 may be performed prior to formation of vias V. That is, after the mask 1500 is first formed on outer side surface of the coil board stack 1010 in a vertical direction, formation of the vias V may be performed. In this case, at least a portion of the via V may be exposed to an outside of the mask 1500. For example, an end of the via V, for example, a land part Vc, may be exposed to an outside of the coil board stack 1010 covered with the mask 1500.

As another example, as illustrated in FIG. 52, formation of the via V may be performed prior to formation of the mask 1500. That is, after the via V is first formed, formation of the mask 1500 may be performed. In this case, the via V may be provided in a state covered by the mask 1500.

Meanwhile, referring to FIGS. 21 and 52, the coil module may further include a dummy via DV. The dummy via DV may be disposed in the non-patterned regions 1103 and 1105, and may be formed in a form including a hole penetrating the coil board stack 1010 in the vertical direction.

For example, the dummy via DV may be provided in a form similar to the via V (see FIG. 50). For example, the dummy via DV may be formed in a form including a hole part Va (see FIG. 50), an inner wall part Vb (see FIG. 50), and a land part Vc (see FIG. 50).

Further, the dummy via DV may be formed in a state electrically separated from various circuit patterns such as a coil pattern Cp forming the heating coil WC or the sensing coil SC and wiring patterns Wpa, Wpb, and Wpc. Such dummy vias DV do not serve a role for power supply or signal transmission, and may serve a role for heat dissipation of the coil module.

The dummy vias DV may be disposed in the non-patterned regions 1103 and 1105, and thus may be disposed so as not to contact or overlap, in the vertical direction, coil patterns Cp forming the heating coil WC or the sensing coil SC.

For example, a plurality of dummy vias DV may be respectively disposed in the first non-patterned region 1103 and the second non-patterned region 1105, and the dummy vias DV may be disposed so as not to contact or overlap, in the vertical direction, not only the coil patterns Cp but also various circuit patterns such as wiring patterns Wpa, Wpb, and Wpc.

The dummy vias DV provided in this manner may improve heat dissipation performance of the coil module while not interfering with power supply or signal transmission of various circuit patterns formed in the coil module.

For example, formation of the dummy vias DV may be performed after formation of the mask 1500. For example, formation of the vias V may be performed prior to formation of the mask 1500, and formation of the dummy vias DV may be performed after formation of the mask 1500. In this case, the vias V may be covered by the mask 1500, and the dummy vias DV may be exposed to an outside of the mask 1500. At this time, conductors forming an inner wall part and a land part of the dummy vias DV may be exposed to an outside of the mask 1500 through upper ends of the dummy vias DV.

In such a configuration, stability of the vias V connected to the heating coil WC and the like may be improved, and at the same time, the dummy vias DV may provide further improved heat dissipation performance.

As another example, for process convenience, formation of the vias V and formation of the dummy vias DV may both be performed after formation of the mask 1500. As still another example, formation of the mask 1500 may be performed after formation of both the vias V and the dummy vias DV.

[Method of manufacturing coil board stack]

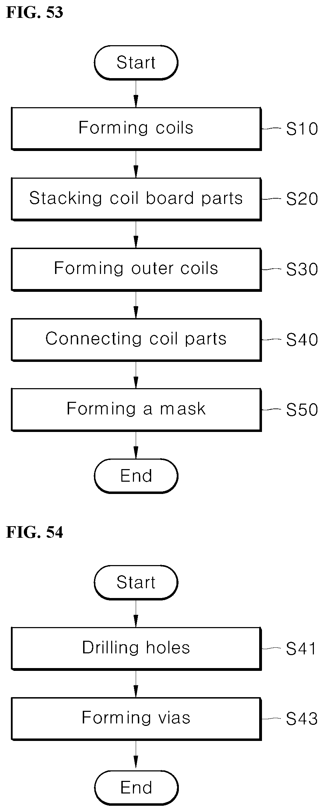

FIG. 53 is a flowchart schematically illustrating a manufacturing process of a coil board stack according to an embodiment of the present disclosure, and FIG. 54 is a flowchart schematically illustrating a progress of a connection step illustrated in FIG. 53.

As described above, the heating coil assembly 1000 may be formed as a result of the first coil board part 1100, the second coil board part 1200, and the like being stacked in a vertical direction. The heating coil assembly 1000 includes the heating coil WC and the sensing coil SC. The heating coil WC may be formed as a result of a plurality of first coil portions 1120 respectively provided in the first coil board part 1100 being connected in the vertical direction, and the sensing coil SC may be formed by at least one second coil portion 1220 provided in the second coil board part 1200.

For manufacturing the heating coil assembly 1000 as described above, as illustrated in FIGS. 50 and 53, a step of forming coil portions 1120 and 1220 in each of the coil board parts 1100 and 1200 may be first performed (coil forming step S10).

In the coil forming step S10, a plurality of first coil portions 1120 may be respectively formed in each first coil board part 1100, and a plurality of second coil portions 1220 may be respectively formed in each second coil board part 1200. Further, the first coil portions 1120 may be respectively formed on an upper surface and a lower surface of the first coil board part 1100, and the second coil portions 1220 may be respectively formed on an upper surface and a lower surface of the second coil board part 1200.

For example, the coil board parts 1100 and 1200 may be formed of a copper clad laminate including cores 1110 and 1210 and copper foils stacked on both sides of the cores 1110 and 1210 in the vertical direction. In this case, each coil pattern Cp forming the coil portions 1120 and 1220 may be formed as a result of a foil stacked on the cores 1110 and 1210 being patterned into a coil shape.

For example, formation of the coil pattern Cp may be performed through a process sequentially including dry film attachment, exposure, development, and etching.

For example, after a dry film is attached to a copper clad laminate, when ultraviolet light is irradiated onto the dry film, a portion of a photo resist of the dry film irradiated with the ultraviolet light is cured (exposure). A portion of the photo resist that is not cured is removed in a development process, and when the foil at a portion from which the photo resist is removed is removed by etching, the coil pattern Cp may be formed in the coil board parts 1100 and 1200.

When formation of the coil pattern Cp and the coil portions 1120 and 1220 including the coil pattern Cp is performed in each of the coil board parts 1100 and 1200 as described above, a coil board stack 1010 may be formed by stacking the plurality of coil board parts 1100 and 1200 in a vertical direction (stacking step S20).

In the stacking step S20, the coil board parts 1100 and 1200 and an adhesive material 1400 may be stacked in the vertical direction. At this time, stacking of the coil board parts 1100 and 1200 and the adhesive material 1400 may be performed such that the coil board parts 1100 and 1200 and the adhesive material 1400 are alternately disposed in the vertical direction.

For example, the adhesive material 1400 may include at least one prepreg film F. For example, the adhesive material 1400 may be formed in a form in which a plurality of prepreg films are stacked in the vertical direction. That is, the adhesive material 1400 may be formed by stacking a plurality of prepreg films in the vertical direction, and the adhesive material 1400 may be interposed between the coil board parts 1100 and 1200 stacked in the vertical direction.

When the coil board parts 1100 and 1200 and the adhesive material 1400 stacked in the vertical direction as described above are heated and pressed, the adhesive material 1400 interposed between the coil board parts 1100 and 1200 stacked in the vertical direction may be melted and then cured to bond the coil board parts 1100 and 1200 to each other. Accordingly, the plurality of coil board parts 1100 and 1200 and the adhesive material 1400 may be integrated, and as a result, one coil board stack 1010 having multilayer coil portions 1120 and 1220 may be formed.

In the coil board stack 1010 formed as described above, the coil portions 1120 and 1220 and insulating layers may be alternately disposed in the vertical direction. According to this, insulating layers may be formed by the cores 1110 and 1210 disposed between a pair of coil portions 1120 and 1220 in each of the coil board parts 1100 and 1200, and insulating layers may also be formed by the adhesive materials 1400 disposed between the coil board parts 1100 and 1200.

For example, a thickness of each of the coil portions 1120 and 1220 may be set to 0.10 mm to 0.11 mm, and a thickness of each prepreg film disposed between a pair of coil portions 1120 and 1220 arranged in the vertical direction may be set to 0.05 mm to 0.09 mm. Further, each adhesive material 1400 disposed between a pair of coil portions 1120 and 1220 arranged in the vertical direction may be formed by three prepreg films F stacked in the vertical direction.

For example, a thickness of each prepreg film F may be set to 0.06 mm to 0.08 mm, and each adhesive material 1400 may be formed by three prepreg films F.

As another example, a thickness of each prepreg film F may be set to 0.07 mm to 0.09 mm. Further, each adhesive material 1400 disposed between a pair of coil portions 1120 and 1220 arranged in the vertical direction may be formed by four prepreg films F stacked in the vertical direction.

Each adhesive material 1400 formed in the above-described manner may effectively fill spaces formed in each of the coil board parts 1100 and 1200 as a result of foil being removed by etching, and may bond the coil board parts 1100 and 1200 to each other.

In addition, in the stacking step S20, not only the plurality of coil board parts 1100 and 1200 but also a pair of outer layer parts 1300 and 1350 may be stacked together. That is, the plurality of coil board parts 1100 and 1200 and the pair of outer layer parts 1300 and 1350 may be stacked together such that the plurality of coil board parts 1100 and 1200 are disposed between the pair of outer layer parts 1300 and 1350. Accordingly, the pair of outer layer parts 1300 and 1350 may form an upper end and a lower end of the coil board stack 1010.

The outer layer parts 1300 and 1350 may be bonded to the coil board parts 1100 and 1200 by the adhesive material 1400 disposed between the outer layer parts 1300 and 1350 and the coil board parts 1100 and 1200. The adhesive material 1400 may form an insulating layer between the coil portions 1120 and 1220 and the outer layer parts 1300 and 1350, and may couple the coil board stack 1010 and the outer layer parts 1300 and 1350.

In a state in which the coil board stack 1010 is formed as described above, the outer layer parts 1300 and 1350 may be formed outside the coil board stack 1010 in the vertical direction (outer coil forming step S30).

In the outer coil forming step S30, an operation of forming the outer layer parts 1300 and 1350 by processing a foil into a coil shape may be performed.

Formation of the outer layer parts 1300 and 1350 may be performed through a process sequentially including dry film attachment, exposure, development, and etching, similarly to formation of the coil portions 1120 and 1220, and a detailed description thereof will be omitted.

For example, when the coil board stack 1010 is formed in a form in which the second coil portions 1220 are stacked above the plurality of first coil portions 1120, the outer layer parts 1300 and 1350 disposed above the second coil board part 1200 may be formed in the same form as the second coil portions 1220 to form the sensing coil SC together with the second coil portions 1220, and the outer layer parts 1300 and 1350 disposed below the first coil board part 1100 may be formed in the same form as the first coil portions 1120 to form the heating coil WC together with the first coil portions 1120.

After formation of the coil board stack 1010 as described above, the plurality of coil portions 1120 and 1220 stacked in the vertical direction may be connected in the vertical direction (connection step S40).

In the connection step S40, as illustrated in FIGS. 50 and 54, an operation of forming hole parts Va connected to the plurality of coil portions 1120 and 1220 stacked in the vertical direction may be first performed (hole drilling step S41). Each hole part Va may be formed in a form of a hole penetrating the coil board stack 1010 in the vertical direction, and formation of the hole part Va may be performed by drilling the coil board stack 1010 in the vertical direction to process a hole.

After formation of the hole parts Va is performed, vias V may be formed in the hole parts Va formed as described above, and the plurality of coil portions 1120 and 1220 may be connected in the vertical direction by the vias V (via forming step S43).

For example, a plurality of first coil portions 1120 may be connected in the vertical direction by a first vertical connection part 1030 formed by the vias V, thereby forming the heating coil WC. Further, a plurality of second coil portions 1220 may be connected in the vertical direction by a second vertical connection part 1040 formed by the vias V, thereby forming the sensing coil SC.

Each via V may be formed in a form including an inner wall part Vb and a land part Vc. For example, the inner wall part Vb may be formed as a result of plating a conductive metal, for example, copper foil, on an inner wall of each of the coil board parts 1100 and 1200 surrounding the hole part Va, and the land part Vc may be formed as a result of plating copper foil on an upper surface and a lower surface of the coil board parts 1100 and 1200 so as to be connected to the inner wall part Vb.

After formation of the heating coil WC and the sensing coil SC is performed as described above, a mask 1500 may be formed outside the coil board stack 1010 in a vertical direction (mask forming step S50).

In the mask forming step S50, the mask 1500 may be provided to cover an upper surface and a lower surface of the coil modules 1001 and 1003. The mask 1500 may form a heat-resistant coating that protects various circuit patterns disposed on the upper surface and the lower surface of the coil modules 1001 and 1003.

As another example, as illustrated in FIG. 52, formation of the mask 1500 may be performed after formation of the vias V is first performed. In this case, the vias V may be provided in a state covered by the mask 1500.

As still another example, formation of the vias V may be performed prior to formation of the mask 1500, and formation of the dummy vias DV (see FIG. 21) may be performed after formation of the mask 1500. In this case, the vias V may be covered by the mask 1500, and the dummy vias DV may be exposed to an outside of the mask 1500. At this time, conductors forming an inner wall part and a land part of the dummy vias DV may be exposed to an outside of the mask 1500 through upper ends of the dummy vias DV.

As another example, formation of the vias V and formation of the dummy vias DV may both be performed after formation of the mask 1500, or formation of the mask 1500 may be performed after formation of both the vias V and the dummy vias DV.

[Example of heating coil assembly]

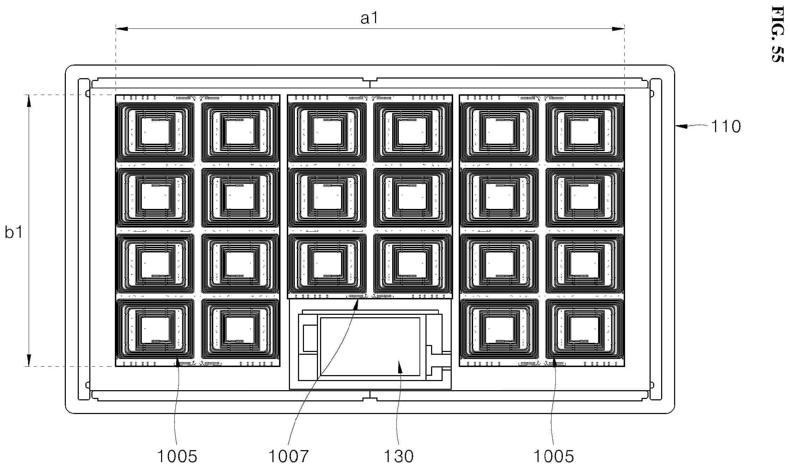

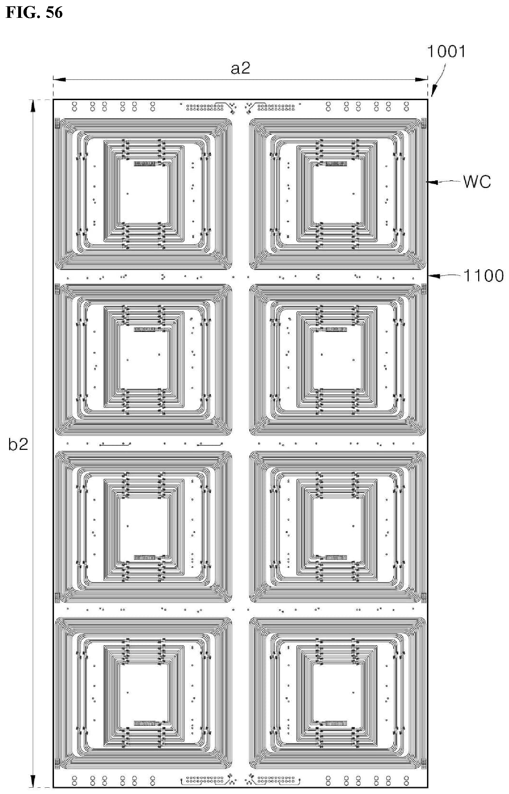

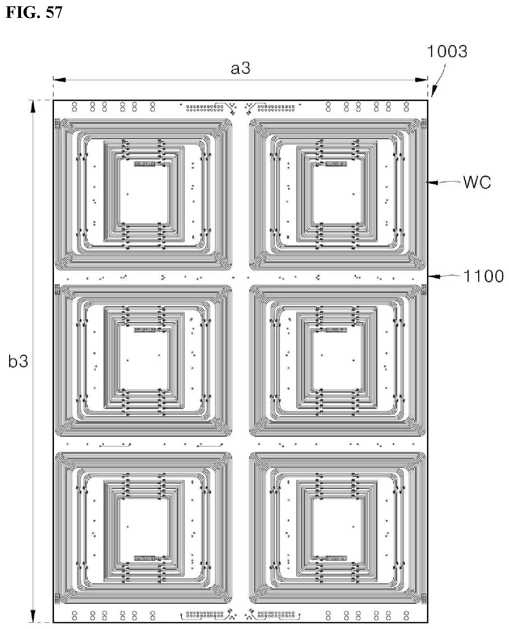

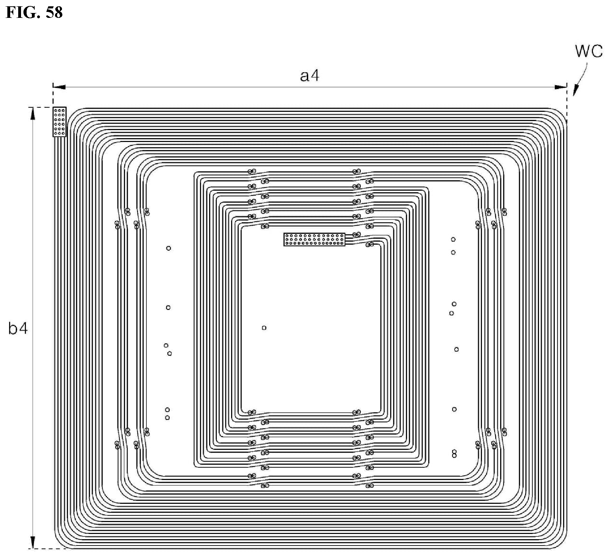

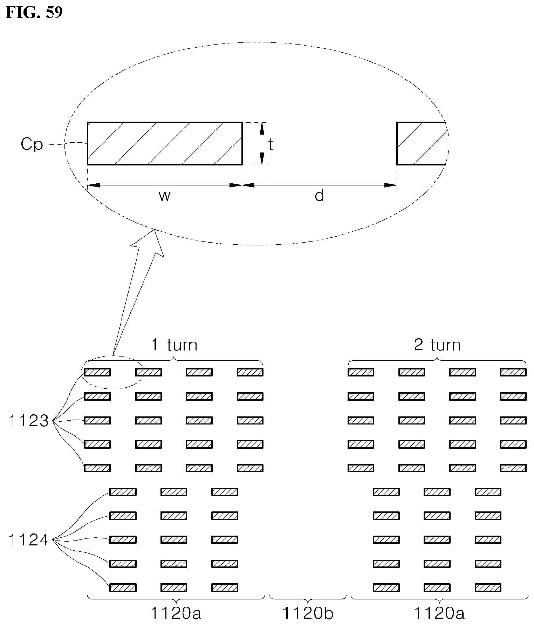

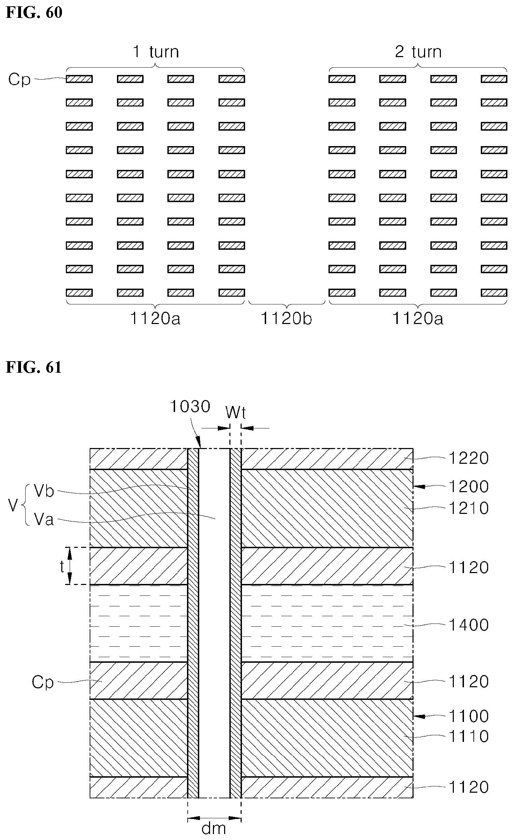

FIG. 55 is a view illustrating an example of a heating coil assembly according to an embodiment of the present disclosure, FIG. 56 is a view illustrating a first coil module shown in FIG. 55 in a separated state, and FIG. 57 is a view illustrating a second coil module shown in FIG. 55 in a separated state. Further, FIG. 58 is a view illustrating a heating coil shown in FIG. 55 in a separated state, and FIG. 59 is a cross-sectional view schematically illustrating an example of a per-turn disposement structure of a first coil portion. Further, FIG. 60 is a cross-sectional view schematically illustrating another example of the per-turn disposement structure of the first coil portion, and FIG. 61 is a cross-sectional view illustrating an enlarged stacked structure of the heating coil assembly.

Hereinafter, an example of a heating coil assembly will be described with reference to FIGS. 55 to 60.

Referring to FIGS. 55 to 57, the heating coil assembly 1000 according to the present embodiment may include a plurality of coil modules 1001 and 1003. In the present embodiment, a pair of first coil modules 1001 and one second coil module 1003 are illustrated as being arranged along a first direction.

Each of the first coil module 1001 and the second coil module 1003 may include a plurality of heating coils WC. For example, each first coil module 1001 may include eight heating coils WC arranged in a 2-column by 4-row configuration, and the second coil module 1003 may include six heating coils WC arranged in a 2-column by 3-row configuration. Accordingly, the heating coil assembly 1000 may include a total of twenty-two heating coils WC.

For example, the heating coil assembly 1000 may be formed in a polygonal shape having a length a1 in the first direction of 920 mm to 940 mm and a length b1 in a second direction of 525 mm to 545 mm. The first coil module 1001 forming the heating coil assembly 1000 may be formed in a rectangular shape having a length a2 in the first direction of 245 mm to 255 mm and a length b2 in the second direction of 400 mm to 410 mm. The second coil module 1003 may be formed in a rectangular shape having a length a3 in the first direction of 245 mm to 255 mm and a length b3 in the second direction of 300 mm to 310 mm.

Referring to FIG. 58, each heating coil WC provided in the coil modules 1001 and 1003 may be formed in a substantially rectangular spiral shape. An outer shape of each heating coil WC may have a substantially rectangular shape.

For example, the outer shape of the heating coil WC may be a rectangle having rounded corners. In a heating coil WC having such a shape, direction-changing sections of a coil pattern Cp may be formed in a curved shape. That is, straight sections of the coil pattern Cp extending in a left-right direction and straight sections extending in a front-rear direction may be smoothly connected to each other by curved portions.

Further, when corners of the heating coil WC are formed in a rounded shape, a change in cross-sectional area of the heating coil WC becomes more gradual than in a case where the corners are angular, and accordingly, resistance of the heating coil WC may be reduced. That is, the heating coil WC having rounded corners may generate less heat than a heating coil having angular corners.

As another example, the outer shape of the heating coil WC may be a rectangle having angular corners. In such a case, a length of a spiral formed by the heating coil WC may be increased, and accordingly, a pattern cross-sectional area per turn of the heating coil WC may be increased.

In the present embodiment, the outer shape of the heating coil WC is exemplified as a rectangle having a first-direction length different from a second-direction length. As another example, the outer shape of the heating coil WC may be a square. A heating coil WC formed in such a manner has an advantage in that production design of the heating coil WC may be facilitated.

An outer shape of each heating coil WC may be a rectangle having a length b4 of 60 mm to 120 mm and a width a4 of 80 mm to 130 mm. That is, the outer shape of each heating coil WC may be a rectangle having a first-direction length a4 of 80 mm to 130 mm and a second-direction length b4 of 60 mm to 120 mm.

For example, the outer shape of each heating coil WC may be a rectangle having a first-direction length of 95 mm to 125 mm and a second-direction length of 90 mm to 110 mm. Such a heating coil WC may be formed as a result of winding a coil pattern Cp nine or more turns around the first non-patterned region 1103. For example, the heating coil WC may be formed as a result of winding the coil pattern Cp nine to eleven turns around the first non-patterned region 1103.

In this case, as illustrated in FIGS. 50, 58, and 59, a width w of each coil pattern Cp may be 0.2 mm to 0.4 mm. Further, a spacing d between adjacent coil patterns Cp may be 0.2 mm to 0.4 mm.

In such coil modules 1001 and 1003, a plurality of first coil board parts 1100 may be stacked in a vertical direction such that the first coil portions 1120 are arranged along the vertical direction. In the present embodiment, the first coil portions 1120 are exemplified as being arranged in ten or more layers along the vertical direction. For example, the first coil portions 1120 may be stacked in ten to twelve layers along a vertical direction.

However, the present disclosure is not limited thereto, and the number of stacked layers of the first coil portions 1120 may be set to exceed twelve layers depending on design conditions such as a product thickness, a required power amount, a heat generation amount, and the like.

According to the present embodiment, ten to twelve first coil portions 1120 disposed on the same straight line along the vertical direction may be connected in the vertical direction to form one heating coil WC. For this purpose, a plurality of coil patterns Cp disposed on the same straight line along the vertical direction may be connected in the vertical direction.

More specifically, an outer shape of each heating coil WC may be a rectangle having a first-direction length of 100 mm to 125 mm and a second-direction length of 85 mm to 95 mm. Such a heating coil WC may be formed as a result of winding a coil pattern Cp nine or more turns around the first non-patterned region 1103.

For example, the coil pattern Cp may be wound nine to eleven turns around the first non-patterned region 1103, and the outer shape of the heating coil WC may be a rectangle having a first-direction length of 100 mm to 110 mm and a second-direction length of 88 mm to 100 mm. As another example, the outer shape of the heating coil WC may be a rectangle having a first-direction length of 115 mm to 125 mm and a second-direction length of 88 mm to 100 mm.

In this case, a width w of each coil pattern Cp may be 0.25 mm to 0.35 mm. Further, a spacing d between adjacent coil patterns Cp may be 0.25 mm to 0.35 mm. In such coil modules 1001 and 1003, a plurality of first coil board parts 1100 may be stacked in a vertical direction such that the first coil portions 1120 are arranged in ten layers along the vertical direction.

In this case, ten first coil portions 1120 disposed on the same straight line along the vertical direction may be connected in the vertical direction to form one heating coil WC. For this purpose, a plurality of coil patterns Cp disposed on the same straight line along the vertical direction may be connected in the vertical direction.

As described above, each heating coil WC may be formed as a result of winding a coil pattern Cp nine to eleven turns, more specifically eleven turns, around the first non-patterned region 1103. Further, each heating coil WC may include three to six coil patterns Cp disposed per layer. Here, the term "turn" refers to the number of times the coil pattern Cp is wound, and may also be expressed as a "rotation" or a "cycle." For example, "eleven turns" may alternatively be expressed as "eleven rotations" or "eleven cycles.

When each heating coil WC is cut in the vertical direction and a vertical cross-section of the heating coil WC is viewed, a plurality of coil patterns Cp included in the heating coil WC may be divided into a plurality of unit bodies along a radial direction of a spiral formed by the heating coil WC (hereinafter, referred to as a "radial direction").

In this case, each unit body may be defined with reference to a divided region 1120a. For example, when each first coil portion 1120 includes four coil patterns Cp, each divided region 1120a may include four coil patterns Cp arranged along a diametrical direction, and each unit body may include four columns of coil patterns Cp. Further, when each heating coil WC includes ten layers of coil patterns Cp, each unit body may include coil patterns Cp arranged in a 4-column by 10-row configuration.

A sum of vertical cross-sectional areas of the coil patterns Cp for each unit body, that is, a pattern cross-sectional area per turn of the heating coil WC, may satisfy the following relationships.

$$1 \leq S = I/D,$$

$$15 \leq D \leq 20,$$

$$15 \leq I \leq 20,$$

$$D = P * m * n,$$

where S denotes a pattern cross-sectional area per turn of the heating coil ($mm^2$), I denotes a current flowing through the heating coil at a maximum output, D denotes a current density of the current flowing through the heating coil at the maximum output ($A/mm^2$), P denotes a cross-sectional area of each coil pattern ($mm^2$), m denotes the number of coil portions stacked in each heating coil, and n denotes the number of coil patterns in each coil portion.

According to the present embodiment, the pattern cross-sectional area per turn S of the heating coil WC is set within a range such that the current density D of the current flowing through the heating coil WC at a maximum output of the cooktop 100 (hereinafter, referred to as a "current density") is within a range of 15 $A/mm^2$ to 20 $A/mm^2$.

For example, when a maximum output of the cooktop 100 including twenty-two heating coils WC is 3.6 kW, and a current I flowing through each heating coil WC is 15 A to 20 A, the pattern cross-sectional area per turn S of the heating coil WC may be set within a range such that the current density D is within a range of 15 $A/mm^2$ to 20 $A/mm^2$.

By satisfying such conditions for the pattern cross-sectional area per turn S of the heating coil WC, a frequency of the current flowing through each heating coil WC may be maintained at a low level. When a frequency of a current flowing through the heating coil WC can be maintained at a low level, a temperature rise of the heating coil WC can be effectively suppressed.

For example, when the pattern cross-sectional area per turn S of the heating coil WC is set within a range such that the current density D is within a range of 15 $A/mm^2$ to 20 $A/mm^2$ as described above, the frequency of the current flowing through the heating coil WC can be maintained at 90 kHz or less, and accordingly, even when the heating coil WC is continuously operated for ten minutes or more, a temperature of the heating coil WC can be maintained at 150°C or less.

According to results of a water boiling test, when a cooking appliance boils six liters of water within eleven minutes, the cooking appliance can be evaluated as having a relatively excellent condition in the water boiling test. That is, in order for the cooking appliance of the present embodiment to provide performance sufficient to receive an excellent grade in the water boiling test, the heating coil WC needs to be capable of being continuously operated at a maximum output for approximately nine to eleven minutes.

Further, in the present embodiment, a printed circuit board forming the heating coil assembly 1000 or the heating coil assembly 1000 as a whole is exemplified as being provided so as to be recognized for heat resistance at 150°C based on a North American Relative Thermal Index (RTI) standard.

Therefore, when the temperature of the heating coil WC can be maintained at 150°C or less even when the heating coil WC is continuously operated for ten minutes or more, both a stability standard of the printed circuit board and a performance condition of the water boiling test can be satisfied.

That is, the cooking appliance of the present embodiment can provide very excellent heating performance while effectively satisfying standards related to the heating coil assembly 1000 by maintaining the temperature of the heating coil WC at 150°C or less even when the heating coil WC is continuously operated for ten minutes or more.

According to the present embodiment, one coil line 1123 or 1124 may be formed by a group of a plurality of coil patterns Cp disposed along a diametrical direction, the one coil line 1123 or 1124 may be wound a plurality of times to form one first coil portion 1120, and the first coil portion 1120 may be connected in a vertical direction to form the heating coil WC.

Further, each coil line 1123 or 1124 forming the first coil portion 1120 forms a horizontal twisting structure within the first coil portion 1120, and a plurality of coil lines 1123 or 1124 stacked in the vertical direction form a vertical twisting structure, such that a plurality of coil patterns Cp forming the heating coil WC can form a braided twisting structure.

That is, the heating coil WC may be formed as a result of a plurality of coil patterns Cp forming horizontal twisting structures and vertical twisting structures and being connected in the vertical direction. Accordingly, a total area of a metal foil for each heating coil WC is not a value obtained by summing only an area of the metal foil forming one layer of the coil portion 1120 or 1220, but is a value obtained by summing areas of metal foils of a plurality of coil portions 1120 and 1220 connected in a vertical direction.

The current density D and the pattern cross-sectional area per turn S of the heating coil WC have an inversely proportional relationship with each other. Therefore, in order to reduce the current density D, the pattern cross-sectional area per turn S of the heating coil WC needs to be increased.

In consideration of this point, in the present embodiment, the heating coil WC is formed as a result of a plurality of coil lines 1123 and 1124 stacked in the vertical direction being connected in the vertical direction, and horizontal twisting structures and vertical twisting structures are formed in the heating coil WC, such that the pattern cross-sectional area per turn S of the heating coil WC can be increased.

The heating coil WC formed in this manner can provide an effect of increasing the pattern cross-sectional area per turn S of the heating coil WC while minimally suppressing an increase in a horizontal size of the heating coil WC. By means of such a heating coil WC, an objective of reducing the current density D flowing through the heating coil WC while reducing a size of the heating coil WC can be effectively achieved.

As the size of the heating coil WC can be reduced, the cooktop 100 of the present embodiment can include a larger number of heating coils WC than other cooktops having the same standard. That is, in the cooktop 100 of the present embodiment, smaller heating coils WC than those of the related art can be more densely disposed.

Further, as the current density D flowing through the heating coil WC can be reduced, a temperature rise of the heating coil WC can be more effectively suppressed. Accordingly, a maximum output can be maintained for a longer period of time than in other cooktops having the same standard.

That is, the cooking appliance according to the present embodiment can provide further improved heating efficiency by using heating coils WC that are small in size and densely disposed, and can also provide higher output for a longer period of time.

As an example in which the pattern cross-sectional area per turn S of the heating coil WC is set within a range such that a current density is in a range of 15 A/mm$^2$ to 20 A/mm$^2$, a thickness t of the coil pattern Cp may be 0.08 mm to 0.12 mm, a width w of the coil pattern Cp may be 0.25 mm to 0.35 mm, and a spacing d between a plurality of the coil patterns Cp may be set to 0.25 mm to 0.40 mm.

As another example in which the pattern cross-sectional area per turn S of the heating coil WC is set within a range such that the current density is in the range of 15 A/mm$^2$ to 20 A/mm$^2$, the thickness t of the coil pattern Cp may be 0.085 mm to 0.110 mm, the width w of the coil pattern Cp may be 0.28 mm to 0.32 mm, and the spacing d between the plurality of the coil patterns Cp may be set to 0.30 mm to 0.35 mm.

In the present embodiment, each coil pattern Cp is illustrated as being formed in a substantially rectangular shape. That is, the numerical values related to the coil pattern Cp are set on an assumption that the coil pattern Cp is formed in a rectangular shape.

More specifically, the thickness t of the coil pattern Cp may be 0.10 mm to 0.11 mm, the width w of the coil pattern Cp may be 0.28 mm to 0.32 mm, and the spacing d between the plurality of the coil patterns Cp may be set to 0.30 mm to 0.35 mm. In addition, an interlayer spacing between the coil patterns Cp may be set to 0.10 mm to 0.21 mm.

In this case, the heating coil assembly 1000 may include a total of 22 heating coils WC, and an outer shape of each heating coil WC may be a rectangle having a first-direction length of 100 mm to 125 mm and a second-direction length of 85 mm to 95 mm. Further, each heating coil WC may include coil patterns Cp of 10 layers or more, and may be formed as a result of each coil pattern Cp being wound nine times or more around the first non-patterned region 1103. As an example, each heating coil WC may include 10 layers of the coil patterns Cp, and each coil pattern Cp may be wound 9 times to 11 times around the first non-patterned region 1103.

In addition, each of the heating coils WC may include three or four coil patterns Cp per layer. As an example, when each heating coil WC includes coil patterns Cp of ten layers, four coil patterns Cp may be disposed in one of upper five layers and lower five layers of the heating coil WC, and three coil patterns Cp may be disposed in the other.

For example, four coil patterns Cp may be disposed in the upper five layers of the heating coil WC, and three coil patterns Cp may be disposed in the lower five layers of the heating coil WC. In this case, each heating coil WC may include a total of 35 coil patterns Cp.

In the heating coil WC having the above-described configuration, the coil patterns Cp of the upper five layers and the coil patterns Cp of the lower five layers may be disposed so as not to overlap each other in the vertical direction. That is, the coil patterns Cp of the upper layers and the coil patterns Cp of the lower layers may be disposed in a staggered manner.

In this case, electromagnetic generation positions of the coil patterns Cp in the upper layers and electromagnetic generation positions of the coil patterns Cp in the lower layers may be staggered along a horizontal direction, thereby suppressing occurrence of electromagnetic interference in the heating coil WC.

As another example, three coil patterns Cp may be disposed in the upper five layers of the heating coil WC, and four coil patterns Cp may be disposed in the lower five layers of the heating coil WC. In this case as well, each heating coil WC may include a total of 35 coil patterns Cp.

As still another example, as illustrated in FIG. 60, four coil patterns Cp may be disposed in each layer of the heating coil WC. In this case, each heating coil WC may include a total of 40 coil patterns Cp.

That is, when four coil patterns Cp may be disposed in each layer of the heating coil WC, the number of coil patterns Cp included in the heating coil WC may be increased as compared with a case in which the number of coil patterns Cp differs for each layer. As the number of coil patterns Cp may increase in this manner, a pattern cross-sectional area per turn of the heating coil WC may increase, and accordingly, a frequency of a current flowing through the heating coil WC may be maintained at a low level, thereby effectively suppressing a temperature increase of the heating coil WC.

The coil modules 1001 and 1003 as described above may be formed in a structure in which four to six coil board parts 1100 and 1200 and a pair of outer layer parts 1300 and 1350 are stacked in the vertical direction. A length of the coil modules 1001 and 1003 in the vertical direction, that is, a thickness thereof, may be set within a range of 3.2 mm to 3.8 mm.

As an example, the coil modules 1001 and 1003 may be formed in a structure in which one first outer layer part 1300, three first coil board parts 1100, one second coil board part 1200, and one second outer layer part 1350 are stacked in the vertical direction. That is, the coil modules 1001 and 1003 may be formed to include ten layers of coil portions 1120 and 1220. A thickness of the coil modules 1001 and 1003 may be set within a range of 3.2 mm to 3.4 mm.

As described above, each of the coil board parts 1100 and 1200 may include a core 1110 or 1210 and coil portions 1120 or 1220, and the plurality of coil board parts 1100 and 1200 may be coupled to each other by an adhesive material 1400.

In this case, a thickness of the adhesive material 1400 may be set to be greater than a thickness of the cores 1110 and 1210. Further, a thickness of the adhesive material 1400 may be set to be greater than a thickness of the coil portions 1120 and 1220. For example, the thickness of the adhesive material 1400 may be set to be at least twice the thickness of the coil portions 1120 and 1220.

Meanwhile, in FIGS. 59 and 60, a vertical cross-sectional shape of the coil pattern Cp is illustrated as a rectangular shape for convenience of description; however, an actual vertical cross-sectional shape of the coil pattern Cp may be a polygon having different lengths of a lower side and an upper side, for example, a trapezoidal shape. Further, in the actual vertical cross-section of the coil pattern Cp, side surfaces may be formed not as vertical straight lines but as inclined straight lines or curved shapes.

As an example, as illustrated in FIGS. 56 and 61, a thickness of each of the cores 1110 and 1210 may be 0.09 mm to 0.11 mm, a thickness of each of the coil portions 1120 and 1220 may be 0.10 mm to 0.11 mm, and a thickness of each adhesive material 1400 may be 0.28 mm to 0.36 mm.

Here, the thickness of the adhesive material 1400 refers to a thickness of the adhesive material 1400 before being interposed between the coil board parts 1100 and 1200, and after the adhesive material 1400 is interposed between the coil board parts 1100 and 1200 to couple the coil board parts 1100 and 1200, the thickness of the adhesive material 1400 may be reduced as compared with the thickness before interposition.

As an example, a thickness of each of the cores 1110 and 1210 may be 0.10 mm to 0.11 mm, and a thickness of the adhesive material 1400 interposed between the coil board parts 1100 and 1200 may be 0.18 mm to 0.21 mm. In this case, an interlayer spacing of the coil patterns Cp may be 0.10 mm to 0.21 mm.

As described above, a thickness of the coil modules 1001 and 1003 including ten layers of coil portions 1120 and 1220 may be set to be 3.2 mm to 3.4 mm. As another example, a thickness of the coil modules 1001 and 1003 formed in a structure in which one first outer layer part 1300, four first coil board parts 1100, one second coil board part 1200, and one second outer layer part 1350 are stacked in the vertical direction, that is, coil modules including twelve layers of coil portions 1120 and 1220, may be set within a range of 3.6 mm to 3.8 mm.

In the coil modules 1001 and 1003 formed as described above, a diameter dm of each via V connecting the coil portions 1120 and 1220 in the vertical direction may be set to be 0.40 mm or greater. In such vias V, a horizontal thickness wt of an inner wall part Vb may be set to be smaller than a thickness t of the coil pattern Cp. That is, the inner wall part Vb of each via V may be formed to have a thickness smaller than the thickness t of the coil pattern Cp.

As an example, each first vertical connection part 1030 may include a plurality of vias V arranged along a circumferential direction of a spiral formed by the heating coil WC. Further, a sum of the horizontal thicknesses wt of the inner wall parts Vb of the vias V included in one first vertical connection part 1030 may be set to be greater than one half of the thickness t of one coil pattern Cp. For example, when two vias V are provided in each first vertical connection part 1030, a horizontal thickness of the inner wall part Vb of each via V may be set to be greater than one quarter of the thickness t of one coil pattern Cp.

Accordingly, a current path having a sufficient width for current flow may be formed within each first vertical connection part 1030. By forming a current path having a sufficient width for current flow in the first vertical connection part 1030 as described above, a flow of current in the heating coil WC may be stably maintained, and a loss of current flowing through the heating coil WC may be effectively reduced.

According to the present embodiment, as illustrated in FIGS. 29 and 61, the vias V are disposed in a separation region 1120b. In each via V disposed as described above, a diameter of a land part Vc may be set within a range of 0.75 mm to 0.85 mm. This is a result of a design that takes into consideration that a length of the separation region 1120b in the diametrical direction is set within a range of 1.05 mm to 1.15 mm. For example, a diameter of the land part Vc may be set to be shorter than the length of the separation region 1120b in the diametrical direction, while being long enough to be stably connected to the coil pattern Cp.

In each vertical connection part 1030, a plurality of vias V may be arranged along a circumferential direction. That is, in each vertical connection part 1030, the plurality of vias V may be arranged in a line along the circumferential direction rather than being arranged along the diametrical direction.

[Structure of coil pattern]

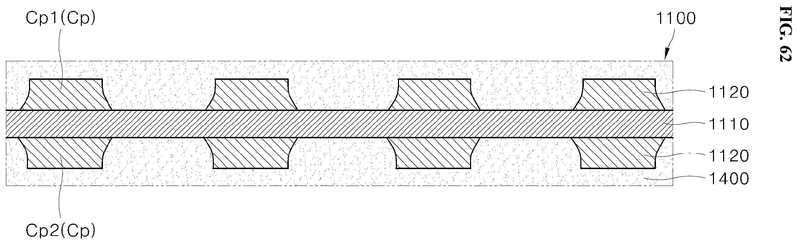

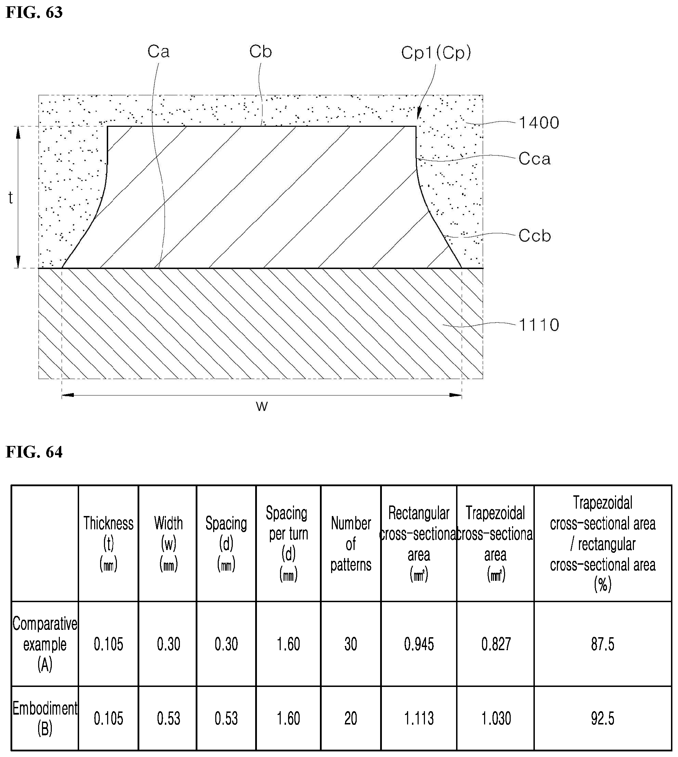

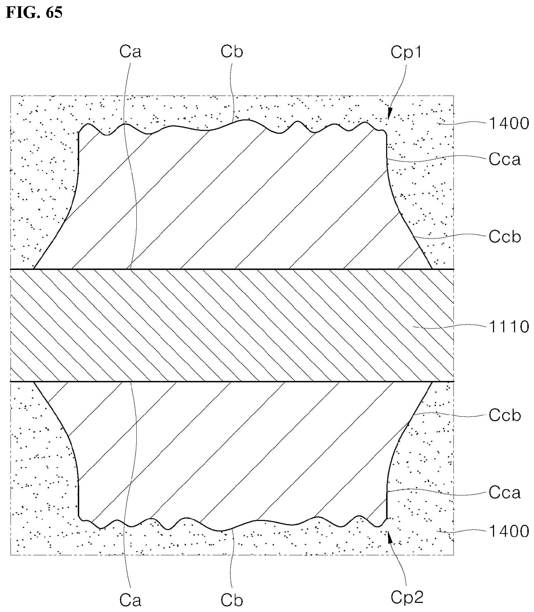

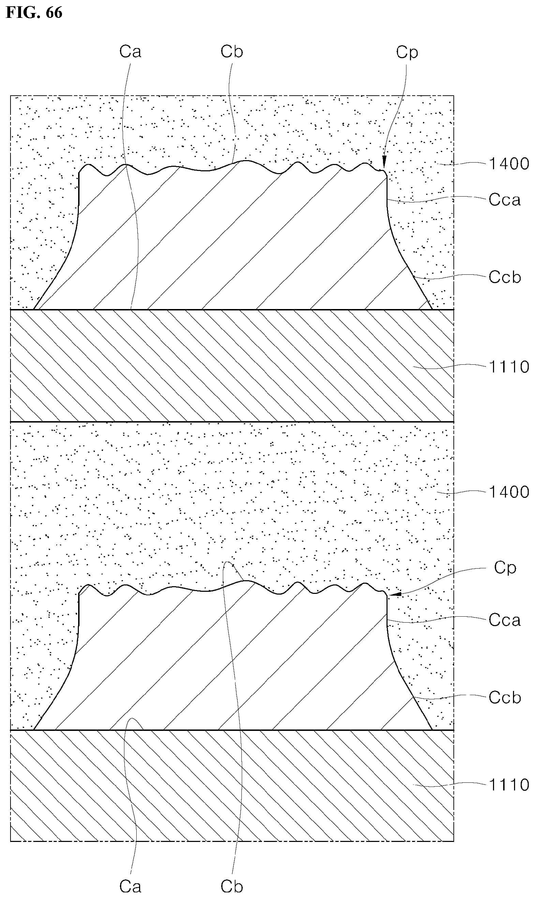

FIG. 62 is a cross-sectional view illustrating a vertical cross-sectional shape of a pattern coil, FIG. 63 is an enlarged view enlarging the pattern coil shown in FIG. 62, and FIG. 64 is a table comparing a pattern coil according to an embodiment of the present disclosure with a comparative example. FIG. 65 is an enlarged cross-sectional view enlarging a vertical cross-sectional shape of a pattern coil formed by etching, and FIG. 66 is a cross-sectional view illustrating another example of a pattern coil formed by etching.

As illustrated in FIGS. 50 and 62 to 64, the heating coil WC may be formed by a plurality of first coil portions 1120 stacked in a vertical direction, and each first coil portion 1120 may include a plurality of coil patterns Cp arranged along a diametrical direction of the heating coil WC.

For example, each coil pattern Cp may be formed in a shape patterned in a coil form on a core 1110 of the first coil board part 1100.

As described above, the coil pattern Cp may be formed through a process sequentially including dry film attachment, exposure, development, and etching. That is, the coil pattern Cp may be formed as a result in which a portion of a foil provided on the core 1110 that is not cured by exposure is etched and removed from the coil board parts 1100 and 1200.

A vertical cross-section of each coil pattern Cp may be formed in a polygonal shape including a lower side Ca closest to the core 1110 and an upper side Cb spaced apart from the core 1110 by a thickness of the coil pattern Cp. In the coil pattern Cp, a length of the upper side Cb may be set to be smaller than a length of the lower side Ca.

In general, in a process of forming the coil pattern Cp as described above, a greater amount of foil is removed in a region adjacent to the upper side Cb than in a region adjacent to the lower side Ca. That is, as a result of an etching process for forming the coil pattern Cp, a large amount of foil loss occurs in the region adjacent to the upper side Cb.

For example, during a process of removing a portion of the foil to form the coil pattern Cp, a greater amount of foil is removed around the upper side Cb than around the lower side Ca, such that the length of the upper side Cb becomes shorter than a designed value and becomes smaller than the length of the lower side Ca.

For example, the vertical cross-section of the coil pattern Cp may be formed in a polygonal shape in which the length of the upper side Cb is 70% to 80% of the length of the lower side Ca. In the present embodiment, the vertical cross-section of the coil pattern Cp is exemplified as being formed in a polygonal shape close to a trapezoidal shape in which the lower side Ca and the upper side Cb are parallel to each other.

For example, the vertical cross-section of each coil pattern Cp may be formed in a polygonal shape including a pair of side surfaces Cca and Ccb connecting the lower side Ca and the upper side Cb in the vertical direction. Each of the side surfaces Cca and Ccb may include a first side surface Cca connected to the upper side Cb, and a second side surface Ccb connecting the first side surface Cca and the lower side Ca. That is, the second side surface Ccb is disposed above the lower side Ca, and the first side surface Cca is disposed above the second side surface Ccb.

For example, the first side surface Cca may be formed in a vertical straight-line shape. For example, the first side surface Cca may be formed as a vertical line. The second side surface Ccb may be formed as an inclined surface connecting a lower end of the first side surface Cca and the lower side Ca.

The second side surface Ccb may be formed as an inclined surface that is inclined toward an outer side in a horizontal direction of the coil pattern Cp as the second side surface Ccb approaches the lower side Ca in the vertical direction, that is, toward a lower side. For example, the second side surface Ccb may be formed in a curved shape connecting the lower end of the first side surface Cca and the lower side Ca. In this case, the second side surface Ccb may be formed in a concave curved shape toward an inner side in the horizontal direction and toward a lower side of the coil pattern Cp.

For example, a vertical cross-section of the coil pattern Cp may satisfy the following relationship:

$$1.47 \leq W1/t \leq 1.57$$

(where W1 denotes a length of the lower side of the coil pattern, and t denotes a thickness of the coil pattern).

According to the present embodiment, a length W1 of the lower side Ca of the coil pattern Cp is set within a range of 1.47 times to 1.57 times a thickness of the coil pattern Cp. By setting the length W1 of the lower side Ca of the coil pattern Cp to satisfy the above condition, even when the length of the upper side Cb becomes shorter than the lower side Ca by 20% or more during a process of forming the coil pattern Cp, the coil pattern Cp may be formed such that a cross-sectional area of each coil pattern Cp is 90% or more of a designed value.

For example, a width W of the coil pattern Cp may be set within a range of 0.3 mm to 0.6 mm. More specifically, the width W of the coil pattern Cp may be set within a range of 0.5 mm to 0.6 mm.

Referring to FIGS. 62 to 55, under a condition in which each unit body of a heating coil WC having a first-direction length of 104 mm and a second-direction length of 96 mm includes ten layers of first coil portions 1120 and a thickness of each coil pattern Cp is 0.105 mm, when a width of each coil pattern Cp and a spacing between the coil patterns Cp are each 0.30 mm, a pattern cross-sectional area per turn S of the heating coil WC may be approximately 0.945 mm$^2$ (comparative example). That is, according to a designed value of the comparative example, the pattern cross-sectional area per turn S of the heating coil WC may be approximately 0.945 mm$^2$.

In this case, each unit body of the heating coil WC may include coil patterns Cp disposed in a three-column by ten-row configuration. That is, the number of coil patterns Cp per turn of the heating coil WC becomes approximately thirty.

In the comparative example designed as described above, an actual heating coil WC may be formed in a trapezoidal shape, and a pattern cross-sectional area per turn S of the heating coil WC formed in the trapezoidal shape may be approximately 0.827 mm$^2$. That is, the pattern cross-sectional area per turn S of the actual heating coil WC formed in the trapezoidal shape is only about 87.5% of the designed value.

In contrast, under the same conditions as those of the heating coil WC of the comparative example, that is, under a condition in which each unit body of a heating coil WC having a first-direction length of 104 mm and a second-direction length of 96 mm includes ten layers of first coil portions 1120 and a thickness of each coil pattern Cp is 0.105 mm, when a width of each coil pattern Cp and a spacing between the coil patterns Cp are each 0.53 mm, each unit body of the heating coil WC may include coil patterns Cp disposed in a two-column by ten-row configuration. That is, the number of coil patterns Cp per turn of the heating coil WC becomes approximately twenty.

In this embodiment, a pattern cross-sectional area per turn S of the heating coil WC may be approximately 1.113 mm$^2$. That is, according to a designed value of the embodiment, the pattern cross-sectional area per turn S of the heating coil WC may be approximately 1.113 mm$^2$.

In the embodiment designed as described above, an actual heating coil WC may be formed in a trapezoidal shape, and a pattern cross-sectional area per turn S of the heating coil WC formed in the trapezoidal shape may be approximately 1.030 mm$^2$. That is, the pattern cross-sectional area per turn S of the actual heating coil WC formed in the trapezoidal shape reaches about 92.5% of the designed value.

Accordingly, according to the present embodiment, although the number of coil patterns Cp per turn of the heating coil WC is reduced compared to the comparative example, the pattern cross-sectional area per turn S of the heating coil WC is increased compared to the comparative example.

Moreover, the pattern cross-sectional area per turn S of the heating coil WC according to the designed value of the present embodiment, that is, the rectangular heating coil WC of the present embodiment, is greater than that of the heating coil WC according to the designed value of the comparative example, that is, the rectangular heating coil WC of the comparative example. In addition, the pattern cross-sectional area per turn S of the actual heating coil WC of the present embodiment, that is, the trapezoidal heating coil WC of the present embodiment, is greater than the pattern cross-sectional area per turn S of the rectangular heating coil WC of the comparative example.

That is, the heating coil WC of the present embodiment is formed to satisfy a condition in which a length W1 of the lower side Ca of the coil pattern Cp is set within a range of 1.47 times to 1.57 times a thickness of the coil pattern Cp, such that even when a length of the upper side Cb becomes shorter than the lower side Ca by 20% or more during a process of forming the coil pattern Cp, the heating coil WC may be formed to have a sufficient pattern cross-sectional area per turn S required to effectively suppress a temperature rise of the heating coil WC.

The coil pattern Cp formed as described above may be connected to a via V, as illustrated in FIGS. 29 and 61 to 63. For example, a diameter dm of a via V connected to the coil pattern Cp may be set to be greater than a length of a lower side Ca of the coil pattern Cp. When the diameter dm of the via V is set to be greater than the length of the lower side Ca of the coil pattern Cp, a connection between the via V and the coil pattern Cp may be achieved with high reliability.

For example, even when a positional deviation of the coil pattern Cp occurs in each layer during a manufacturing process of the heating coil assembly, if the diameter dm of the via V is greater than a width of the coil pattern Cp, a likelihood that the connection between the via V and the coil pattern Cp is properly achieved may be increased.

Moreover, considering that a length of the lower side Ca is likely to be greater than a length of an upper side Cb in the coil pattern Cp, when the diameter dm of the via V is set to be greater than the length of the lower side Ca, the connection between the via V and the coil pattern Cp may be achieved with high reliability even when a positional deviation of the coil pattern Cp occurs in each layer during the manufacturing process of the heating coil assembly.

As another example, a diameter of a dummy via DV (see FIG. 21), which is provided so as not to be connected to the coil pattern Cp, may also be set to be greater than the length of the lower side Ca of the coil pattern Cp, similarly to the via V.

As still another example, an inner diameter of the via V may be set to be smaller than the length of the lower side Ca. More preferably, the inner diameter of the via V may be set to be smaller than the length of the upper side Cb. In this case, while a horizontal length of a region occupied by the hole portion Va inside the via V is reduced, a horizontal length of a region occupied by the inner wall part Vb may be increased.

When the inner diameter of the via V is set to be smaller than the length of the lower side Ca or the length of the upper side Cb as described above, the connection between the via V and the coil pattern Cp may be achieved with high reliability. In addition, a contact area between the via V and the coil pattern Cp may be increased, thereby reducing resistance at a connection portion between the via V and the coil pattern Cp.

Meanwhile, the coil pattern Cp may include a first coil pattern CP1 and a second coil pattern CP2. The first coil pattern CP1 may be formed in a polygonal shape in which a lower side Ca is disposed at a lower side and an upper side Cb is disposed at an upper side. The second coil pattern CP2 may be formed in a polygonal shape in which a lower side Ca is disposed at an upper side and an upper side Cb is disposed at a lower side.

For example, the first coil pattern CP1 and the second coil pattern CP2 may be provided to be line-symmetric with respect to a horizontal straight line. For example, the first coil pattern CP1 and the second coil pattern CP2 may each be formed in a trapezoidal shape and may be formed to be line-symmetric with respect to the core 1110.

In this case, the first coil pattern CP1 and the second coil pattern CP2 may be provided not to form complete line symmetry, but to include partially line-symmetric regions. That is, due to positions of vias V or pattern shape characteristics, some regions of the first coil pattern CP1 or the second coil pattern CP2 may not be symmetric, and the first coil pattern CP1 and the second coil pattern CP2 may be provided in a form in which remaining regions, excluding the non-symmetric regions, are line-symmetric.

When the coil pattern Cp is formed in a patterned shape on the core 1110 of the first coil board part 1100, the first coil pattern CP1 may be disposed on an upper side of the core 1110, and the second coil pattern CP2 may be disposed on a lower side of the core 1110.

According to the present embodiment, the first coil pattern CP1 and the second coil pattern CP2 stacked in a vertical direction may be connected in the vertical direction to form the heating coil WC. In this case, the coil modules 1001 and 1003 may include a region in which the first coil pattern CP1 and the second coil pattern CP2 are alternately disposed in the vertical direction.

For example, a plurality of first coil board parts 1100 may be stacked in a vertical direction, first coil patterns CP1 and second coil patterns CP2 may be respectively deposited on both sides of each first coil board part 1100 in the vertical direction, and accordingly, the first coil patterns CP1 and the second coil patterns CP2 may be disposed alternately in the vertical direction.

When the coil pattern Cp is formed in a patterned shape on the core 1110 of the first coil board part 1100, the lower side Ca may be in contact with the core 1110, and the upper side Cb may be spaced apart from the core 1110 by a thickness of the coil pattern Cp in a vertical direction.

Meanwhile, as described above, the coil pattern Cp may be formed by etching, and in this case, at least a portion of the coil pattern Cp may form a rough surface. In the previously illustrated drawings, the coil pattern Cp has been illustrated as being formed only with smooth surfaces; however, a coil pattern Cp formed by a method such as etching may actually be formed to have a rough surface.

For example, in the coil pattern Cp of the present embodiment, as illustrated in FIG. 65, one of the lower side Ca and the upper side Cb may form a flat surface, and the other of the lower side Ca and the upper side Cb may form a rough surface.

For example, the lower side Ca may form a flat surface, and the upper side Cb may form a rough surface. As a result of an etching process for forming the coil pattern Cp, the upper side Cb may form a rough surface, and the lower side Ca, which is in contact with the core 1110, may form a flat surface.

When the coil pattern Cp is formed in a patterned shape on both sides in a vertical direction of the core 1110 of the first coil board part 1100, in the first coil pattern CP1 disposed on an upper side of the core 1110, an upper surface of the first coil pattern CP1 may form a rough surface, and in the second coil pattern CP2 disposed on a lower side of the core 1110, a lower surface of the second coil pattern CP2 may form a rough surface.

As another example, as illustrated in FIG. 66, the coil pattern Cp may be formed only on a cross-section of the first coil board part 1100, or the coil pattern Cp may be printed on an upper surface of each insulating layer. When the coil pattern Cp is printed on the upper surface of each insulating layer, the insulating layers and the coil patterns Cp printed thereon may be sequentially stacked from a lowermost layer.

In this case, in all of the coil patterns Cp, the upper side Cb may be disposed above the lower side Ca. Accordingly, in all of the coil patterns Cp, the upper side Cb may face one direction, for example, upward. In other words, in all of the coil patterns Cp illustrated in FIG. 66, the flat lower side Ca may be disposed to face downward, and the rough upper side Cb may be disposed to face upward.

The embodiments are described above with reference to a number of illustrative embodiments thereof. However, the embodiments are provided as examples, and numerous other modifications and equivalent embodiments can be drawn by one having ordinary skill in the art from the embodiments. Thus, the technical scope of protection of the subject matter of the disclosure is to be defined according to the following claims.

For example, in the present specification, embodiments in which the heating coil assembly is applied to a cooking appliance are described. However, in other embodiments, the heating coil assembly may be applied to other home appliances requiring induction heating.

For example, the heating coil assembly may be mounted in a washing machine and used to heat a tub, a drum, or a washing container inside the washing machine, or to heat washing water.

As another example, the heating coil assembly may be mounted in a water purifier and used to heat a hot-water pipe or a water tank.

As still another example, the heating coil assembly may be mounted in a clothes dryer or a clothes care appliance and used to heat air for drying clothes.

As yet another example, the heating coil assembly may be mounted in an electric kettle or a rice cooker and used to heat liquid or food inside the appliance.

**[Description of Reference Numerals]**

10: Oven part
11: Door
13: Main control panel
100: Cooktop
105: Controller
110: Case
111: Bottom
113: Side wall
115: Support protrusion
120: Top plate
130: Cooktop control panel
150: Supporter
160: Ferrite core

171: Main PCB
172: Switching mode power supply
173: Inverter PCB
174: Resonant PCB
175: Noise filter
176: Fan
180: Lighting module
1000: Heating coil assembly
1001: First coil module
1003: Second coil module
1010: Coil board stack
1020: Connection
1021: First connection
1023: Second connection
1025: Third connection
1030: First vertical connection part
1040: Second vertical connection part
1100: First coil board part
1101: Patterned region
1103: First non-patterned region
1105: Second non-patterned region
1110: Core
1120: First coil portion
1120a: Divided region
1120b: Separation region
1121: First terminal
1122: Second terminal
1123: First coil line
1124: Second coil line
1200: Second coil board part
1210: Core
1220: Second coil portion
1300: First outer layer part
1350: Second outer layer part
1400: Adhesive material

**Claims**

1. A home appliance comprising:

   at least one coil module including a heating coil configured to inductively heat a heating target, wherein the heating coil is formed by a plurality of coil patterns stacked in a vertical direction, wherein a vertical cross-section of each of the coil patterns is formed in a shape including a lower side and an upper side spaced apart from each other in the vertical direction by a thickness of the coil pattern, and wherein a length of the upper side is less than a length of the lower side.

2. The home appliance according to claim 1, wherein the vertical cross-section of the coil pattern is formed in a shape in which the length of the upper side is 70% to 80% of the length of the lower side.

3. The home appliance according to claim 1, wherein the vertical cross-section of the coil pattern is formed in a trapezoidal shape in which the lower side and the upper side are parallel to each other.

4. The home appliance according to claim 1,

   wherein the vertical cross-section of the coil pattern is formed in a shape including a pair of side surfaces connecting the lower side and the upper side in a vertical direction, wherein each of the side surfaces respectively includes a first side surface connected to the upper side and a second side surface connecting the first side surface and the lower side, and wherein the second side surface forms an inclined surface that becomes farther from a horizontal center of the lower side as the second side surface becomes closer to the lower side.

5. The home appliance according to claim 4,

   wherein the first side surface is formed in a linear shape in the vertical direction, and wherein the second side surface is formed as an inclined surface connecting a lower end of the first side surface and the lower side.

6. The home appliance according to claim 1, wherein the coil pattern is formed in the coil module as a result in which a portion of a foil stacked on a core and not cured by exposure is etched and removed from the coil module.

7. The home appliance according to claim 1,

   wherein the vertical cross-section of the coil pattern satisfies the following relationship:

   $$0.47 \leq W1/t \leq 0.57,$$

   where W1 denotes a length of the lower side of the coil pattern, and t denotes a thickness of the coil pattern.

8. The home appliance according to claim 1,

   wherein an outer shape of the heating coil in a horizontal direction is a rectangle in which a length in a first direction is 98 mm to 100 mm and a length in a second direction orthogonal to the first direction is 118 mm to 120 mm, wherein the coil module includes a plurality of the coil patterns disposed along a diametrical direction of a spiral formed by the heating coil, and wherein a width of each of the coil patterns is 0.3 mm to 0.6 mm.

9. The home appliance according to claim 8,

   wherein the coil module includes a pair of the coil patterns disposed along the diametrical direction of the spiral formed by the heating coil, wherein a thickness of each of the coil patterns is 0.10 mm to 0.11 mm, and wherein a width of each of the coil patterns is 0.5 mm to 0.6 mm.

10. The home appliance according to claim 1,

    wherein one of the lower side and the upper side forms a flat surface, and wherein the other of the lower side and the upper side forms a rough surface.

11. The home appliance according to claim 1,

    wherein the coil module is formed by a plurality of coil board parts stacked in a vertical direction, and wherein each of the coil board parts includes at least one coil patterns patterned on a core.

12. The home appliance according to claim 11,

    wherein the lower side is in contact with the core, and wherein the upper side is spaced apart from the core in the vertical direction by a thickness of the coil pattern.

13. The home appliance according to claim 11, wherein the coil pattern is deposited on an upper surface and a lower surface of the core, respectively.

14. The home appliance according to claim 1,

    wherein the coil pattern is deposited on the insulating layer such that the lower side is in contact with the insulating layer, wherein the lower side forms a flat surface, and wherein the upper side forms a rough surface.

15. The home appliance according to claim 1,

    wherein the coil pattern includes a first coil pattern in which the lower side is disposed at a lower portion and the upper side is disposed at an upper portion, and a second coil pattern in which the lower side is disposed at the upper portion and the upper side is disposed at the lower portion, and wherein the coil module includes a region in which the first coil pattern and the second coil pattern are disposed alternately in the vertical direction.

**16.** The home appliance according to claim 1,

wherein the coil pattern includes a first coil pattern disposed on the insulating layer and a second coil pattern disposed under the insulating layer, and
wherein the first coil pattern and the second coil pattern are provided to be line-symmetric with respect to a horizontal straight line.

**17.** The home appliance according to claim 1,

wherein the coil module further includes a via connected to the coil pattern, and
wherein a diameter of the via is greater than a length of the lower side.

**18.** The home appliance according to claim 1,

wherein the coil module further includes a via connected to the coil pattern or a dummy via not connected to the coil pattern, and
wherein a diameter of the via or the dummy via is greater than a length of the lower side.

**19.** The home appliance according to claim 1,

wherein the coil module further includes a via connected to the coil pattern, and
wherein an inner diameter of the via is less than a length of the lower side.

**FIG. 1**

**FIG. 2**

**FIG. 3**

**FIG. 4**

**FIG. 5**

**FIG. 6**

**FIG. 7**

**FIG. 8**

**FIG. 9**

P

| | | | |
|---|---|---|---|
| 1100 | 1100 | 1100 | 1100 |
| 1100 | 1100 | 1100 | 1100 |
| 1100 | 1100 | 1100 | 1100 |

FIG. 10

**FIG. 11**

EP 4 770 272 A1

FIG. 12

60

FIG. 13

**FIG. 14**

**FIG. 15**

**FIG. 16**

**FIG. 17**

**FIG. 18**

**FIG. 19**

**FIG. 20**

**FIG. 21**

(a)

(b)

**FIG. 22**

**FIG. 23**

**FIG. 24**

**FIG. 25**

**FIG. 26**

**FIG. 27**

FIG. 28

EP 4 770 272 A1

**FIG. 29**

**FIG. 30**

**FIG. 31**

**FIG. 32**

**FIG. 33**

**FIG. 34**

**FIG. 35**

**FIG. 36**

**FIG. 37**

**FIG. 38**

**FIG. 39**

**FIG. 40**

**FIG. 41**

EP 4 770 272 A1

**FIG. 42**

**FIG. 43**

**FIG. 44**

**FIG. 45**

EP 4 770 272 A1

FIG. 46

91

**FIG. 47**

**FIG. 48**

**FIG. 49**

**FIG. 50**

**FIG. 51**

120    123              121                    1000
1001(1003)                                     1500
1350                                           1220
                                               1400
                                               1220
1200                                           1210

**FIG. 52**

**FIG. 53**

```
        ( Start )
            |
   +------------------+
   |  Forming coils   |--- S10
   +------------------+
            |
   +------------------+
   | Stacking coil    |--- S20
   | board parts      |
   +------------------+
            |
   +------------------+
   | Forming outer    |--- S30
   | coils            |
   +------------------+
            |
   +------------------+
   | Connecting coil  |--- S40
   | parts            |
   +------------------+
            |
   +------------------+
   | Forming a mask   |--- S50
   +------------------+
            |
        (  End  )
```

**FIG. 54**

```
        ( Start )
            |
   +------------------+
   | Drilling holes   |--- S41
   +------------------+
            |
   +------------------+
   | Forming vias     |--- S43
   +------------------+
            |
        (  End  )
```

**FIG. 55**

**FIG. 56**

**FIG. 57**

**FIG. 58**

**FIG. 59**

**FIG. 60**

**FIG. 61**

**FIG. 62**

**FIG. 63**

**FIG. 64**

| | Thickness (t) (mm) | Width (w) (mm) | Spacing (d) (mm) | Spacing per turn (d) (mm) | Number of patterns | Rectangular cross-sectional area (mm²) | Trapezoidal cross-sectional area (mm²) | Trapezoidal cross-sectional area / rectangular cross-sectional area (%) |
|---|---|---|---|---|---|---|---|---|
| Comparative example (A) | 0.105 | 0.30 | 0.30 | 1.60 | 30 | 0.945 | 0.827 | 87.5 |
| Embodiment (B) | 0.105 | 0.53 | 0.53 | 1.60 | 20 | 1.113 | 1.030 | 92.5 |

**FIG. 65**

**FIG. 66**

# EP 4 770 272 A1

## INTERNATIONAL SEARCH REPORT

| International application No. |
|---|
| **PCT/KR2024/014078** |

### A. CLASSIFICATION OF SUBJECT MATTER

**H05B 6/12**(2006.01)i; **F24C 7/08**(2006.01)i; **F24C 15/10**(2006.01)i; **F24C 15/34**(2006.01)i; **H05B 6/06**(2006.01)i; **F24C 3/12**(2006.01)i

According to International Patent Classification (IPC) or to both national classification and IPC

### B. FIELDS SEARCHED

Minimum documentation searched (classification system followed by classification symbols)

H05B 6/12(2006.01)

Documentation searched other than minimum documentation to the extent that such documents are included in the fields searched

Korean utility models and applications for utility models: IPC as above
Japanese utility models and applications for utility models: IPC as above

Electronic data base consulted during the international search (name of data base and, where practicable, search terms used)

eKOMPASS (KIPO internal) & keywords: cooker, induction, heat, coil, layer, pattern, vertical, cross-sectional, view, thickness, length, width, rectangular, slope, groove, via, hole, dummy

### C. DOCUMENTS CONSIDERED TO BE RELEVANT

| Category* | Citation of document, with indication, where appropriate, of the relevant passages | Relevant to claim No. |
|---|---|---|
| Y | JP 2016-085818 A (NGK SPARK PLUG CO., LTD.) 19 May 2016 (2016-05-19)<br>See paragraphs [0016]-[0034]; and figures 1-8. | 1-19 |
| Y | KR 10-2020-0108273 A (I. R. C. A. -S.P.A.-INDUSTRIA RESISTENZE CORAZZATE E AFFINI) 17 September 2020 (2020-09-17)<br>See paragraphs [0042]-[0059]; and figures 3-3b. | 1-19 |
| Y | JP 05-074559 A (SHARP CORP.) 26 March 1993 (1993-03-26)<br>See paragraph [0024]; and figures 1-2. | 13 |
| A | JP 07-014669 A (GOLD STAR CO., LTD.) 17 January 1995 (1995-01-17)<br>See paragraphs [0010]-[0017]; and figures 1-8. | 1-19 |
| A | US 2022-0287159 A1 (I.R.C.A. S.P.A. INDUSTRIA RESISTENZE CORAZZATE E AFFINI) 08 September 2022 (2022-09-08)<br>See paragraphs [0064]-[0211]; and figures 1-6. | 1-19 |

☐ Further documents are listed in the continuation of Box C.          ☑ See patent family annex.

| * | Special categories of cited documents: | "T" | later document published after the international filing date or priority date and not in conflict with the application but cited to understand the principle or theory underlying the invention |
|---|---|---|---|
| "A" | document defining the general state of the art which is not considered to be of particular relevance | | |
| "D" | document cited by the applicant in the international application | "X" | document of particular relevance; the claimed invention cannot be considered novel or cannot be considered to involve an inventive step when the document is taken alone |
| "E" | earlier application or patent but published on or after the international filing date | | |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| **26 December 2024** | **26 December 2024** |

| Name and mailing address of the ISA/KR | Authorized officer |
|---|---|
| **Korean Intellectual Property Office**<br>**Government Complex-Daejeon Building 4, 189 Cheongsa-ro, Seo-gu, Daejeon 35208** | |
| Facsimile No. **+82-42-481-8578** | Telephone No. |

Form PCT/ISA/210 (second sheet) (July 2022)

**INTERNATIONAL SEARCH REPORT**
Information on patent family members

International application No.

**PCT/KR2024/014078**

| Patent document cited in search report | | | Publication date (day/month/year) | Patent family member(s) | | | Publication date (day/month/year) |
|---|---|---|---|---|---|---|---|
| JP | 2016-085818 | A | 19 May 2016 | None | | | |
| KR | 10-2020-0108273 | A | 17 September 2020 | CN | 111656863 | A | 11 September 2020 |
| | | | | CN | 111656863 | B | 14 October 2022 |
| | | | | EP | 3707961 | A1 | 16 September 2020 |
| | | | | EP | 3707961 | B1 | 05 January 2022 |
| | | | | KR | 10-2690907 | B1 | 31 July 2024 |
| | | | | US | 11743978 | B2 | 29 August 2023 |
| | | | | US | 2020-0367326 | A1 | 19 November 2020 |
| | | | | WO | 2019-092653 | A1 | 16 May 2019 |
| JP | 05-074559 | A | 26 March 1993 | None | | | |
| JP | 07-014669 | A | 17 January 1995 | KR | 10-0143226 | B1 | 01 July 1998 |
| | | | | KR | 10-1993-0003869 | A | 22 March 1993 |
| | | | | US | 5369249 | A | 29 November 1994 |
| US | 2022-0287159 | A1 | 08 September 2022 | CN | 114466608 | A | 10 May 2022 |
| | | | | CN | 114466608 | B | 05 July 2024 |
| | | | | EP | 4008161 | A1 | 08 June 2022 |
| | | | | IT | 201900013785 | A1 | 02 February 2021 |
| | | | | WO | 2021-024130 | A1 | 11 February 2021 |

Form PCT/ISA/210 (patent family annex) (July 2022)